(19) Europäisches Patentamt
European Patent Office
Office européen des brevets

(11) EP 3 998 297 A1

(12) EUROPEAN PATENT APPLICATION
published in accordance with Art. 153(4) EPC

(43) Date of publication:
**18.05.2022 Bulletin 2022/20**

(21) Application number: **20850138.7**

(22) Date of filing: **06.08.2020**

(51) International Patent Classification (IPC):
***C08G 59/20** (2006.01)* ***C08G 59/40** (2006.01)*
***C08F 214/18** (2006.01)* ***C08F 218/04** (2006.01)*
***C08L 27/12** (2006.01)* ***C08L 31/02** (2006.01)*
***C08L 63/00** (2006.01)* ***B32B 15/08** (2006.01)*
***B32B 15/082** (2006.01)* ***H05K 1/03** (2006.01)*

(52) Cooperative Patent Classification (CPC):
**B32B 15/08; B32B 15/082; C08F 214/18; C08F 218/04; C08G 59/20; C08G 59/40; C08L 27/12; C08L 31/02; C08L 63/00; H05K 1/03**

(86) International application number:
**PCT/JP2020/030199**

(87) International publication number:
**WO 2021/025117 (11.02.2021 Gazette 2021/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.08.2019 JP 2019144663**
**30.10.2019 JP 2019197865**

(71) Applicant: **Daikin Industries, Ltd.**
**Osaka-shi, Osaka 530-8323 (JP)**

(72) Inventors:
- **ISHIKAWA, Takuji**
**Osaka-Shi, Osaka 530-8323 (JP)**
- **OZAKI, Hidenori**
**Osaka-Shi, Osaka 530-8323 (JP)**
- **IMOTO, Katsuhiko**
**Osaka-Shi, Osaka 530-8323 (JP)**

(74) Representative: **Hoffmann Eitle**
**Patent- und Rechtsanwälte PartmbB**
**Arabellastraße 30**
**81925 München (DE)**

# (54) FLUORINE-CONTAINING POLYMER FOR METAL-CLAD LAMINATED SHEET, COMPOSITION FOR METAL-CLAD LAMINATED SHEET, CURABLE COMPOSITION, METAL-CLAD LAMINATED SHEET AND PRINTED SUBSTRATE

(57) The disclosure provides a fluorine-containing polymer for a metal-clad laminated sheet excellent in compatibility with epoxy resins. Provided is a fluorine-containing polymer for a metal-clad laminated sheet, containing: a polymerized unit based on a fluorine-containing vinyl monomer; and a polymerized unit based on a vinyl ester monomer other than the fluorine-containing vinyl monomer, the fluorine-containing polymer comprising not more than 1 mol% in total of a polymerized unit based on a monomer containing a hydroxy group and a polymerized unit based on a monomer containing a carboxy group, of all polymerized units.



Processed by Luminess, 75001 PARIS (FR)

## Description

TECHNICAL FIELD

The disclosure relates to fluorine-containing polymers for metal-clad laminated sheets, compositions for metal-clad laminated sheets, curable compositions, metal-clad laminated sheets, and printed substrates.

BACKGROUND ART

In recent years, electrical devices, electronic devices, and communication devices have been remarkably developed. Currently, these devices tend to use higher frequency bands. Various printed substrates are usually used for these devices. Therefore, such a printed substrate is also required to have various properties such as excellent electrical characteristics compatible with a high frequency band and excellent heat resistance to withstand soldering work. In the case where the printed substrate is a two-layer laminate including a substrate and a copper foil layer, conventionally, the substrate includes polyimides, and epoxy resins or acrylic resins are used in an adhesive layer. Such a substrate is, however, insufficient in insulation properties, adhesiveness, and heat resistance, and studies have been made on this issue.

Patent Literature 1, for example, aims to provide a metal-clad laminate which includes a base material and a metal foil firmly bonded to the base material and exhibits excellent electrical characteristics, and discloses a metal-clad laminate including a metal foil and a first resin layer provided on the metal foil in which the first resin layer is formed of an epoxy resin and a fluorine-containing polymer having a curable functional group, and a flexible printed circuit board including a patterned circuit formed by etching the metal foil of the metal-clad laminate.

Patent Literature 2 discloses an active ester compound having a specific structure, and a thermosetting resin composition containing an active ester compound component including at least one type of the active ester compound and an epoxy resin component including at least one epoxy resin.

CITATION LIST

- Patent Literature

Patent Literature 1: JP 2012-106491 A
Patent Literature 2: JP 2006-307091 A

SUMMARY OF INVENTION

- Technical Problem

The disclosure aims to provide a fluorine-containing polymer for a metal-clad laminated sheet excellent in compatibility with epoxy resins.

- Solution to Problem

The disclosure provides a fluorine-containing polymer for a metal-clad laminated sheet, containing: a polymerized unit based on a fluorine-containing vinyl monomer; and a polymerized unit based on a vinyl ester monomer other than the fluorine-containing vinyl monomer, the fluorine-containing polymer containing not more than 1 mol% in total of a polymerized unit based on a monomer containing a hydroxy group and a polymerized unit based on a monomer containing a carboxy group, of all polymerized units (hereafter, also referred to as a "first fluorine-containing polymer of the disclosure").

The disclosure also provides a composition for a metal-clad laminated sheet, containing the first fluorine-containing polymer of the disclosure and a solvent (hereafter, also referred to as a "first composition for a metal-clad laminated sheet of the disclosure").

The disclosure also provides a curable composition containing: a fluorine-containing polymer; and an epoxy resin, the fluorine-containing polymer containing a polymerized unit based on a fluorine-containing vinyl monomer and a polymerized unit based on a vinyl ester other than the polymerized unit based on a fluorine-containing vinyl monomer, and containing not more than 1 mol% in total of a polymerized unit based on a monomer containing a hydroxy group and a polymerized unit based on a monomer containing a carboxy group, of all polymerized units (hereafter, also referred

to as a "first curable composition of the disclosure").

The first curable composition of the disclosure preferably further contains a solvent.

In the first curable composition of the disclosure, preferably, the epoxy resin is contained in an amount of 1 to 1000 parts by mass relative to 100 parts by mass of the fluorine-containing polymer.

The first curable composition of the disclosure preferably further contains a curing accelerator.

The polymerized unit based on a vinyl ester monomer is preferably contained in an amount of 10 mol% or more of all polymerized units of the fluorine-containing polymer.

The vinyl ester monomer is preferably a monomer represented by the following formula:

$$CH_2{=}CH\text{-}O\text{-}C({=}O)\text{-}R^A$$

wherein $R^A$ is a C1-C4 alkyl group or a phenyl group optionally containing a substituent.

The vinyl ester monomer preferably includes at least one selected from the group consisting of vinyl benzoate, vinyl para-t-butylbenzoate, vinyl acetate, and vinyl pivalate.

The polymerized unit based on a fluorine-containing vinyl monomer is preferably contained in an amount of 10 mol% or more of all polymerized units of the fluorine-containing polymer.

The fluorine-containing vinyl monomer preferably includes at least one selected from the group consisting of tetrafluoroethylene, chlorotrifluoroethylene, vinyl fluoride, hexafluoropropylene, and perfluoro(alkyl vinyl ethers).

The first fluorine-containing polymer of the disclosure preferably further contains a polymerized unit based on a monomer different from the fluorine-containing vinyl monomer or the vinyl ester monomer.

In the first fluorine-containing polymer of the disclosure, the monomer different from the fluorine-containing vinyl monomer or the vinyl ester monomer preferably includes a monomer represented by the following formula (2):

[Chem. 1]

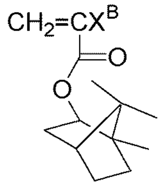

(2)

wherein $X^B$ is H or $CH_3$.

The first fluorine-containing polymer of the disclosure preferably has a number average molecular weight of 1000 to 30000.

The disclosure also provides a metal-clad laminated sheet including: a metal foil; and a resin layer provided on the metal foil, the resin layer being formed of the curable composition (hereafter, also referred to as a "first metal-clad laminated sheet of the disclosure").

The disclosure also provides a printed substrate including a patterned circuit formed by etching the metal foil of the metal-clad laminated sheet (hereafter, also referred to as a "first printed substrate of the disclosure").

The disclosure also provides a fluorine-containing polymer containing: a polymerized unit based on tetrafluoroethylene; and a polymerized unit based on a vinyl ester monomer, the fluorine-containing polymer containing a chain of a tetrafluoroethylene unit-a vinyl ester unit-a tetrafluoroethylene unit in an amount of 45 mol% or more and containing not more than 1 mol% in total of a polymerized unit based on a monomer containing a hydroxy group and a polymerized unit based on a monomer containing a carboxy group, of all polymerized units (hereafter, also referred to as a "second fluorine-containing polymer of the disclosure").

The second fluorine-containing polymer of the disclosure preferably has a number average molecular weight of 15000 or less.

In the second fluorine-containing polymer of the disclosure, the polymerized unit based on a vinyl ester monomer is preferably contained in an amount of 10 mol% or more of all polymerized units of the fluorine-containing polymer.

In the second fluorine-containing polymer of the disclosure, the vinyl ester monomer is preferably a monomer represented by the following formula:

$$CH_2{=}CH\text{-}O\text{-}C({=}O)\text{-}R^A$$

wherein $R^A$ is a C1-C4 alkyl group or a phenyl group optionally containing a substituent.

In the second fluorine-containing polymer of the disclosure, the vinyl ester monomer preferably includes at least one selected from the group consisting of vinyl benzoate, vinyl para-t-butylbenzoate, vinyl acetate, and vinyl pivalate.

In the second fluorine-containing polymer of the disclosure, the polymerized unit based on tetrafluoroethylene is preferably contained in an amount of 10 mol% or more of all polymerized units of the fluorine-containing polymer.
The second fluorine-containing polymer of the disclosure preferably further contains a polymerized unit based on a monomer different from the tetrafluoroethylene or the vinyl ester monomer.
In the second fluorine-containing polymer of the disclosure, the monomer different from the tetrafluoroethylene or the vinyl ester monomer preferably includes a monomer represented by the following formula (2) :

[Chem. 2]

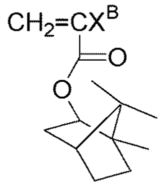

(2)

wherein $X^B$ is H or $CH_3$.
The disclosure also provides a composition for a metal-clad laminated sheet, containing: the second fluorine-containing polymer of the disclosure; and a solvent (hereafter, also referred to as a "second composition for a metal-clad laminated sheet of the disclosure").
The disclosure also provides a curable composition containing: the second fluorine-containing polymer of the disclosure; and an epoxy resin (hereafter, also referred to as a "second curable composition of the disclosure").
The second curable composition of the disclosure preferably further contains a solvent.
In the second curable composition of the disclosure, the epoxy resin is preferably contained in an amount of 1 to 1000 parts by mass relative to 100 parts by mass of the fluorine-containing polymer.
The second curable composition of the disclosure preferably further contains a curing accelerator.
The disclosure also provides a metal-clad laminated sheet including; a metal foil; and a resin layer provided on the metal foil, the resin layer being formed of the curable composition (hereafter, also referred to as a "second metal-clad laminated sheet of the disclosure").
The disclosure also provides a printed substrate including a patterned circuit formed by etching the metal foil of the metal-clad laminated sheet (hereafter, also referred to as a "second printed substrate of the disclosure").
The disclosure also provides a fluorine-containing polymer containing: a polymerized unit based on a fluorine-containing vinyl monomer; and a polymerized unit based on a vinyl ester monomer, the polymerized unit based on a fluorine-containing vinyl monomer and the polymerized unit based on a vinyl ester monomer being contained in a total amount of 70 to 100 mol% of all polymerized units, the fluorine-containing vinyl monomer including at least one selected from the group consisting of tetrafluoroethylene, hexafluoropropylene, and chlorotrifluoroethylene, wherein, in the case of the fluorine-containing vinyl monomer including tetrafluoroethylene, an integral value of $CF_2H$ at a $-CF_2H$ end is not more than 2% of an integral value of entire $CF_2$ in 19F-NMR, in the case of the fluorine-containing vinyl monomer including hexafluoropropylene, an integral value of CFH at a $-CF_2CFHCF_3$ end is not more than 2% of an integral value of entire CF in 19F-NMR, and in the case of the fluorine-containing vinyl monomer including chlorotrifluoroethylene, a total of an integral value of $CF_2H$ at a $-CF_2H$ end and an integral value of CFClH at a - CFClH end is not more than 2% of a total of an integral value of entire $CF_2$ and an integral value of entire CFCl in 19F-NMR (hereafter, also referred to as a "third fluorine-containing polymer of the disclosure").
The third fluorine-containing polymer of the disclosure preferably has a number average molecular weight of 1000 to 600000.
In the third fluorine-containing polymer of the disclosure, the polymerized unit based on a vinyl ester monomer is preferably contained in an amount of 10 mol% or more of all polymerized units of the fluorine-containing polymer.
In the third fluorine-containing polymer of the disclosure, the vinyl ester monomer is preferably a monomer represented by the following formula:

$$CH_2=CH-O-C(=O)-R^A$$

wherein $R^A$ is a C1-C4 alkyl group or a phenyl group optionally containing a substituent.
In the third fluorine-containing polymer of the disclosure, the vinyl ester monomer preferably includes at least one selected from the group consisting of vinyl benzoate, vinyl para-t-butylbenzoate, vinyl acetate, and vinyl pivalate.
In the third fluorine-containing polymer of the disclosure, the polymerized unit based on a fluorine-containing

vinyl monomer is preferably contained in an amount of 10 mol% or more of all polymerized units of the fluorine-containing polymer.

The third fluorine-containing polymer of the disclosure preferably further contains a polymerized unit based on a monomer different from the fluorine-containing vinyl monomer or the vinyl ester monomer.

In the third fluorine-containing polymer of the disclosure, the monomer different from the fluorine-containing vinyl monomer or the vinyl ester monomer preferably includes a monomer represented by the following formula (2):

[Chem. 3]

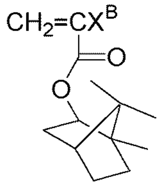

(2)

wherein $X^B$ is H or $CH_3$.

The disclosure also provides a composition for a metal-clad laminated sheet containing: the third fluorine-containing polymer of the disclosure; and a solvent (hereafter, also referred to as a "third composition for a metal-clad laminated sheet of the disclosure").

The disclosure also provides a curable composition containing: the third fluorine-containing polymer of the disclosure; and an epoxy resin (hereafter, also referred to as a "third curable composition of the disclosure").

The third curable composition of the disclosure preferably further contains a solvent.

In the third curable composition of the disclosure, the epoxy resin is preferably contained in an amount of 1 to 1000 parts by mass relative to 100 parts by mass of the fluorine-containing polymer.

The third curable composition of the disclosure preferably further contains a curing accelerator.

The disclosure also provides a metal-clad laminated sheet including: a metal foil; and a resin layer provided on the metal foil, the resin layer being formed of the curable composition (hereafter, also referred to as a "third metal-clad laminated sheet of the disclosure").

The disclosure also provides a printed substrate including a patterned circuit formed by etching the metal foil of the metal-clad laminated sheet (hereafter, also referred to as a "third printed substrate of the disclosure").

The disclosure also provides an epoxy resin containing: at least one of a polymerized unit based on tetrafluoroethylene or a polymerized unit based on hexafluoropropylene; and a polymerized unit based on allyl glycidyl ether, the polymerized unit based on tetrafluoroethylene, the polymerized unit based on hexafluoropropylene, and the polymerized unit based on allyl glycidyl ether being contained in a total amount of 98 to 100 mol% of all polymerized units (hereafter, also referred to as an "epoxy resin of the disclosure").

The epoxy resin of the disclosure is preferably liquid at 25°C. The epoxy resin of the disclosure preferably has a number average molecular weight of 500 to 10000.

Preferably, regarding the epoxy resin of the disclosure, in the case where the polymerized unit based on tetrafluoroethylene is contained, an integral value of $CF_2H$ at a $-CF_2H$ is not more than 4% of an integral value of entire $CF_2$ in 19F-NMR, and in the case where the polymerized unit based on hexafluoropropylene is contained, an integral value of CFH at a $-CF_2CFHCF_3$ end is not more than 4% of an integral value of entire CF in 19F-NMR.

In the epoxy resin of the disclosure, the polymerized unit based on allyl glycidyl ether is preferably contained in an amount of 10 mol% or more of all polymerized units of the epoxy resin.

In the epoxy resin of the disclosure, the polymerized unit based on tetrafluoroethylene and the polymerized unit based on hexafluoropropylene are preferably contained in a total amount of 10 mol% or more of all polymerized units of the epoxy resin.

The disclosure also provides a curable composition containing: the epoxy resin of the disclosure; and a fluorine-containing polymer.

The fourth curable composition of the disclosure preferably further contains a solvent (hereafter, also referred to as a "fourth curable composition of the disclosure").

In the fourth curable composition of the disclosure, the epoxy resin is preferably contained in an amount of 1 to 1000 parts by mass relative to 100 parts by mass of the fluorine-containing polymer.

The fourth curable composition of the disclosure preferably further contains a curing accelerator.

The disclosure also provides a metal-clad laminated sheet including: a metal foil; and a resin layer provided on the metal foil, the resin layer being formed of the curable composition (hereafter, also referred to as a "fourth metal-clad laminated sheet of the disclosure").

The disclosure also provides a printed substrate including a patterned circuit formed by etching the metal foil

of the metal-clad laminated sheet (hereafter, also referred to as a "fourth printed substrate of the disclosure").

- Advantageous Effects of Invention

The fluorine-containing polymer for a metal-clad laminated sheet of the disclosure, the second fluorine-containing polymer of the disclosure, and the third fluorine-containing polymer of the disclosure are excellent in compatibility with epoxy resins. The epoxy resin of the disclosure is excellent in compatibility with fluorine-containing polymers.

DESCRIPTION OF EMBODIMENTS

The metal-clad laminated sheet of Patent Literature 1 includes a first resin layer formed of an epoxy resin and a fluorine-containing polymer having a curable functional group to achieve firm bonding of a metal foil to a base material, which allows the metal-clad laminated sheet to exhibit excellent electrical characteristics. Still, there is room for improvement in terms of compatibility of the fluorine-containing polymer with the epoxy resin.

Patent Literature 2 discloses, as an active ester compound, a compound having a group (active ester group) obtained by esterifying a phenolic hydroxy group with an aromatic or fatty acid but does not disclose any other hydroxy group-containing resins. In order to achieve further improvement of properties including a low dielectric constant and a low dielectric loss tangent, there is still room for improvement.

The fluorine-containing polymer for a metal-clad laminated sheet of the disclosure (first fluorine-containing polymer of the disclosure) contains a polymerized unit based on a fluorine-containing vinyl monomer and a polymerized unit based on a vinyl ester monomer other than the fluorine-containing vinyl monomer, and contains not more than 1 mol% in total of a polymerized unit based on a monomer containing a -OH group and a polymerized unit based on a monomer containing a -COOH group. This structure allows the fluorine-containing polymer to exhibit excellent compatibility with epoxy resins. The fluorine-containing polymer exhibits a function as an active ester to provide a resin layer of a metal-clad laminated sheet with a low dielectric constant and a low dielectric loss tangent. In addition, the resin layer of the metal-clad laminated sheet can be firmly bonded to a metal foil. The inventors of the disclosure made intensive studies to find out that the fluorine-containing polymer has the above properties and is particularly suitable for metal-clad laminated sheets (for resin layers of metal-clad laminated sheets).

The disclosure provides the use of the fluorine-containing polymer in metal-clad laminated sheets (resin layers of metal-clad laminated sheets).

The first fluorine-containing polymer of the disclosure contains a polymerized unit based on a fluorine-containing vinyl monomer (hereafter, referred to as a "fluorine-containing vinyl monomer unit").

The fluorine-containing vinyl monomer preferably includes at least one selected from the group consisting of tetrafluoroethylene (TFE), chlorotrifluoroethylene (CTFE), vinyl fluoride, hexafluoropropylene (HFP), and perfluoro(alkyl vinyl ethers), more preferably at least one selected from the group consisting of TFE, CTFE, vinyl fluoride, HFP, and perfluoro(alkyl vinyl ethers). More preferred is at least one selected from the group consisting of TFE, CTFE, and HFP because they have a low dielectric constant and a low dielectric loss tangent, are excellent in dispersibility, moisture resistance, heat resistance, flame retardancy, adhesiveness, chemical resistance, and the like, have a low dielectric constant and a low dielectric loss tangent, and are excellent in weather resistance and moisture proofness. Still more preferred is at least one selected from the group consisting of TFE and HFP because they are free from chlorine. Particularly preferred is TFE because it is excellent in copolymerizability.

Examples of the perfluoro(alkyl vinyl ethers) include, but are not limited to, perfluoro(methyl vinyl ether) (PMVE), perfluoro(ethyl vinyl ether) (PEVE), perfluoro(propyl vinyl ether) (PPVE), and perfluoro(butyl vinyl ether).

The fluorine-containing vinyl monomer unit excellently has a low dielectric constant and a low dielectric loss tangent and therefore is contained in an amount of preferably 10 mol% or more, more preferably 20 mol% or more, still more preferably 30 mol% or more, even more preferably 40 mol% or more, particularly preferably 50 mol% or more, while preferably 80 mol% or less, more preferably 70 mol% or less, still more preferably 60 mol% or less, of all polymerized units constituting the fluorine-containing polymer.

The first fluorine-containing polymer of the disclosure contains a polymerized unit based on a vinyl ester monomer other than the fluorine-containing vinyl monomer (hereafter, referred to as a "vinyl ester monomer unit"). Containing the vinyl ester monomer unit, the first fluorine-containing polymer of the disclosure can generate an active ester to react with an epoxy resin.

Examples of the vinyl ester monomer include vinyl acetate, vinyl propionate, vinyl butyrate, vinyl isobutyrate, vinyl pivalate, vinyl caproate, vinyl versatate, vinyl laurate, vinyl stearate, vinyl cyclohexyl carboxylate, vinyl benzoate, and vinyl para-t-butylbenzoate.

The vinyl ester monomer is preferably a monomer represented by the following formula (A):

$$CH_2=CH-O-C(=O)-R^A \qquad (A)$$

(wherein $R^A$ is a C1-C4 alkyl group or a phenyl group optionally including a substituent) because the active ester generated is highly reactive.

The alkyl group for $R^A$ is a C1-C4 alkyl group. The carbon number is preferably 1 to 2, more preferably 1.

Examples of the substituent optionally included in the phenyl group for $R^A$ include a C1-C4 alkyl group, an alkoxyl group, and a dialkyl amino group. More preferred is a t-butyl group.

For achieving a highly reactive active ester, the vinyl ester monomer preferably includes at least one selected from the group consisting of vinyl benzoate, vinyl para-t-butylbenzoate, vinyl acetate, and vinyl pivalate, more preferably at least one selected from the group consisting of vinyl benzoate, vinyl para-t-butylbenzoate, and vinyl acetate.

The vinyl ester monomer unit is preferably contained in an amount of 20 mol% or more of all polymerized units of the fluorine-containing polymer for achieving excellent compatibility and high reactivity with epoxy resins. The vinyl ester monomer unit is contained in an amount of more preferably 30 mol% or more, still more preferably 40 mol% or more, of all polymerized units. For achieving excellent heat resistance, the amount is preferably 80 mol% or less, more preferably 70 mol% or less, still more preferably 60 mol% or less.

According to a preferred embodiment, the first fluorine-containing polymer of the disclosure contains 10 to 100 mol% of a polymerized unit based on a monomer represented by the formula (A) and 0 to 90 mol% of a polymerized unit based on a vinyl ester monomer different from the monomer represented by the formula (A), relative to 100 mol% in total of the vinyl ester monomer units. The polymerized unit based on a monomer represented by the formula (A) is contained in an amount of more preferably 20 to 90 mol%, still more preferably 30 to 80 mol%, even more preferably 35 to 75 mol%, particularly preferably 40 to 70 mol%, relative to 100 mol% in total of the vinyl ester monomer units. The polymerized unit based on a vinyl ester monomer different from the monomer represented by the formula (A) is contained in an amount of more preferably 10 to 80 mol%, still more preferably 20 to 70 mol%, even more preferably 25 to 65 mol%, particularly preferably 30 to 60 mol%, relative to 100 mol% in total of the vinyl ester monomer units.

In order to use the first fluorine-containing polymer of the disclosure in metal-clad laminated sheets, the first fluorine-containing polymer of the disclosure is desired to have excellent heat resistance. Accordingly, the vinyl ester monomer different from the monomer represented by the formula (A) is preferably a vinyl ester monomer that can increase the glass transition temperature by crosslinking. Examples thereof include vinyl cinnamate, vinyl β-styryl acrylate, vinyl β-furyl acrylate, and vinyl p-azidocinnamate.

The vinyl ester monomer may contain no hydroxy or carboxy group.

The first fluorine-containing polymer of the disclosure may further contain a polymerized unit based on a monomer different from the fluorine-containing vinyl monomer or the vinyl ester monomer (hereafter, referred to as a "different monomer") (hereafter, this polymerized unit is referred to as a "different monomer unit").

Examples of the different monomer include alkyl vinyl ethers containing no hydroxy group, non-fluorinated olefins containing no halogen atom or no hydroxy group, amino group-containing monomers containing no NH group, hydrolyzable silyl group-containing monomers containing no OH group, epoxy group-containing monomers, oxetane group-containing monomers, heterocycle-containing monomers, and (meth)acrylic acid ester monomers.

The (meth)acrylic acid ester is preferably an aromatic ester or an alicyclic ester of (meth)acrylic acid because it can increase the polymer glass transition temperature. The (meth)acrylic acid ester is particularly preferably a monomer (2) represented by the following formula (2):

[Chem. 4]

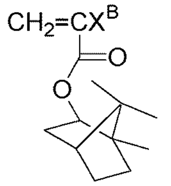

(2)

(wherein $X^B$ is H or $CH_3$), or phenyl (meth) acrylate. An aromatic ester of (meth)acrylic acid is preferred as it can serve as an active ester, and phenyl (meth)acrylate is preferred.

In the disclosure, the term "(meth)acrylic acid" means methacrylic acid or acrylic acid.

Examples of the alkyl vinyl ethers containing no hydroxy group include methyl vinyl ether, ethyl vinyl ether, n-propyl vinyl ether, n-butyl vinyl ether, octadecyl vinyl ether, 2-ethylhexyl vinyl ether, cyclohexyl vinyl ether, isopropyl vinyl ether, and isobutyl vinyl ether. In particular, at least one selected from the group consisting of ethyl vinyl ether and cyclohexyl vinyl ether is preferred.

Examples of the non-fluorinated olefins containing no halogen atom or no hydroxy group include ethylene, propylene, n-butene, and isobutene.

Examples of the amino group-containing monomers include: amino vinyl ethers represented by $CH_2$=CH-O-$(CH_2)_x$-$NH_2$ (x = 0 to 10); amines represented by $CH_2$=CH-O-CO$(CH_2)_x$-$NH_2$ (x = 1 to 10); and other monomers including amino methyl styrene, vinyl amine, acrylamide, vinyl acetamide, and vinyl formamide.

Examples of the hydrolyzable silyl group-containing monomers include: (meth)acrylic acid esters such as $CH_2=CHCO_2(CH_2)_3Si(OCH_3)_3$, $CH_2=CHCO_2(CH_2)_3Si(OC_2H_5)_3$, $CH_2=C(CH_3)CO_2(CH_2)_3Si(OCH_3)_3$, $CH_2=C(CH_3)CO_2(CH_2)_3Si(OC_2H_5)_3$, $CH_2=CHCO_2(CH_2)_3SiCH_3(OC_2H_5)_2$, $CH_2=C(CH_3)CO_2(CH_2)_3SiC_2H_5(OCH_3)_2$, $CH_2=C(CH_3)CO_2(CH_2)_3Si(CH_3)_2(OC_2H_5)$, $CH_2=C(CH_3)CO_2(CH_2)_3Si(CH_3)_2OH$, $CH_2=CH(CH_2)_3Si(OCOCH_3)_3$, $CH_2=C(CH_3)CO_2(CH_2)_3SiC_2H_5(OCOCH_3)_2$, $CH_2=C(CH_3)CO_2(CH_2)_3SiCH_3(N(CH_3)COCH_3)_2$, $CH_2=CHCO_2(CH_2)_3SiCH_3[ON(CH_3)C_2H_5]_2$, and $CH_2=C(CH_3)CO_2(CH_2)_3SiC_6H_5[ON(CH_3)C_2H_5]_2$; vinyl silanes such as $CH_2=CHSi\ [ON=C(CH_3)(C_2H_5)]_3$, $CH_2=CHSi\ (OCH_3)_3$, $CH_2=CHSi\ (OC_2H_5)_3$, $CH_2=CHSiCH_3(OCH_3)_2$, $CH_2=CHSi(OCOCH_3)_3$, $CH_2=CHSi(CH_3)_2(OC_2H_5)$, $CH_2=CHSi(CH_3)_2SiCH_3(OCH_3)_2$, $CH_2=CHSiC_2H_5(OCOCH_3)_2$, $CH_2=CHSiCH_3[ON(CH_3)C_2H_5]_2$, vinyl trichlorosilane, and partial hydrolysates of these; and vinyl ethers such as trimethoxysilyl ethyl vinyl ether, triethoxysilyl ethyl vinyl ether, trimethoxysilyl butyl vinyl ether, methyl dimethoxysilyl ethyl vinyl ether, trimethoxysilyl propyl vinyl ether, and triethoxysilyl propyl vinyl ether.

The fluorine-containing polymer contains not more than 1 mol% in total of a polymerized unit based on a monomer containing a hydroxy group (-OH group) and a polymerized unit based on a monomer containing a carboxy group (-COOH group), of all polymerized units. The total amount of the polymerized unit based on a monomer containing a hydroxy group (-OH group) and the polymerized unit based on a monomer containing a carboxy group (-COOH group) is preferably 0.5 mol% or less, more preferably 0.3 mol% or less, still more preferably 0.1 mol% or less, particularly preferably 0.0 mol%. When the total amount of the polymerized unit based on a monomer containing a hydroxy group (-OH group) and the polymerized unit based on a monomer containing a carboxy group (-COOH group) is within the above range, the dielectric constant and the dielectric loss tangent can be set lower.

Examples of the monomer containing a hydroxy group (-OH group) include hydroxyalkyl vinyl ethers, hydroxyalkyl allyl ethers, hydroxycarboxylic acid vinyl esters, hydroxycarboxylic acid allyl esters, and hydroxyalkyl (meth)acrylates.

Examples of the hydroxyalkyl vinyl ethers include 2-hydroxyethyl vinyl ether, 3-hydroxypropyl vinyl ether, 2-hydroxypropyl vinyl ether, 2-hydroxy-2-methylpropyl vinyl ether, 4-hydroxybutyl vinyl ether, 4-hydroxy-2-methylbutyl vinyl ether, 5-hydroxypentyl vinyl ether, and 6-hydroxyhexyl vinyl ether.

Examples of the hydroxyalkyl allyl ethers include 2-hydroxyethyl allyl ether, 4-hydroxybutyl allyl ether, and glycerol monoallyl ether.

Examples of the hydroxycarboxylic acid vinyl esters include vinyl hydroxyacetate, vinyl hydroxypropanate, vinyl hydroxybutanoate, vinyl hydroxyhexanate, and vinyl 4-hydroxycyclohexyl acetate.

Examples of the hydroxycarboxylic acid allyl esters include allyl hydroxyacetate, allyl hydroxypropanate, allyl hydroxybutanoate, allyl hydroxyhexanoate, and allyl 4-hydroxycyclohexyl acetate.

Examples of the hydroxyalkyl (meth)acrylates include 2-hydroxyethyl acrylate and 2-hydroxyethyl methacrylate.

Examples of the monomer containing a carboxy group include monomers represented by the formula (B):

$$R^{1a}R^{2a}C=CR^{3a}-(CH_2)_n-COOH \qquad (B)$$

wherein $R^{1a}$, $R^{2a}$, and $R^{3a}$ are the same as or different from one another and each represent a hydrogen atom or a C1-C10 linear or branched alkyl group, and n is an integer of 0 or larger. Examples thereof include acrylic acid, methacrylic acid, vinyl acetic acid, crotonic acid, pentenoic acid, hexenic acid, heptenoic acid, octenoic acid, nonenoic acid, decenoic acid, undecylenic acid, dodecenoic acid, tridecenoic acid, tetradecenoic acid, pentadecenoic acid, hexadecenoic acid, heptadecenoic acid, octadecenoic acid, nonadecenoic acid, eicosenoic acid, and 22-tricosenoic acid.

Examples of the monomer containing a carboxy group also include cinnamic acid, 3-allyloxypropionic acid, itaconic acid, itaconic acid monoesters, maleic acid, maleic acid monoesters, maleic acid anhydride, fumaric acid, fumaric acid monoesters, vinyl phthalate, vinyl pyromellitate, citraconic acid, mesaconic acid, and aconitic acid.

The different monomer preferably includes an epoxy group-containing monomer or an oxetane group-containing monomer in order to improve the curability. Examples of the epoxy group-containing monomer include allyl glycidyl ether, 4-hydroxybutyl acrylate glycidyl ether, and 3,4-epoxycyclohexyl methyl methacrylate. Examples of the oxetane group-containing monomer include (3-ethyloxetan-3-yl)methyl acrylate. The amount of the epoxy group- or oxetane group-containing monomer is preferably 0.1 mol% or more, more preferably 0.5 mol% or more, still more preferably 1 mol% or more, of all polymerized units. The amount is preferably 15 mol% or less, more preferably 10 mol% or less, particularly preferably 5 mol% or less.

The different monomer that contains no hydroxy or carboxy group is preferably a heterocycle-containing monomer containing no hydroxy or carboxy group in order to improve the adherence. Examples of the heterocycle-containing monomer include: monomers containing a cyclic ether group such as furan, tetrahydrofurfuryl acrylate, and (2-methyl-2-ethyl-1,3-dioxolan-4-yl)methyl acrylate; monomers containing a lactone group such as 5-oxo-4-oxatricyclo[4.2.1.03.7]nonan-2-yl=acrylate; monomers containing an acid anhydride group such as itaconic anhydride, citraconic anhydride, and 5-norbornene-2,3-dicarboxylic acid anhydride; and monomers containing a pyrrolidone group such as N-vinyl-2-pyrrolidone. The amount of the heterocycle-containing monomer is preferably 0.1 mol% or more, more preferably 0.5 mol% or more, still more preferably 1 mol% or more, of all polymerized units. In terms of heat resistance, the amount is preferably 20 mol% or less, more preferably 10 mol% or less, particularly preferably 5 mol% or less.

The different monomer preferably includes the monomer (2) in terms of heat resistance, a low dielectric constant, and a low dielectric loss tangent. In the formula (2), $X^B$ is H or $CH_3$, preferably H. In order to further improve heat resistance, the polymerized unit based on the monomer (2) is contained in an amount of preferably 10 mol% or more of all polymerized units. The amount is more preferably 15 mol% or more, still more preferably 20 mol% or more. In order to achieve an excellently low dielectric constant and an excellently low dielectric loss tangent, the monomer (2) unit is contained in an amount of preferably 90 mol% or less of all polymerized units. The amount is more preferably 80 mol% or less, still more preferably 70 mol% or less, even more preferably 60 mol% or less, particularly preferably 50 mol% or less.

The first fluorine-containing polymer of the disclosure has a molar ratio, fluorine-containing vinyl monomer unit/vinyl ester monomer unit, of preferably (10 to 90)/(10 to 90), more preferably (20 to 80)/(20 to 80), still more preferably (30 to 70)/(30 to 70).

In the fluorine-containing polymer, the fluorine-containing vinyl monomer unit and the vinyl ester monomer unit are contained in a total amount of preferably 70 mol% or more, more preferably 80 mol% or more, still more preferably 90 mol% or more, even more preferably 95 mol% or more, particularly preferably 97 mol% or more, of all polymerized units. The total amount may be 100 mol% of all polymerized units.

The different monomer unit is contained in an amount of preferably 30 mol% or less, more preferably 20 mol% or less, still more preferably 10 mol% or less, even more preferably 5 mol% or less, particularly preferably 3 mol% or less, of all polymerized units of the fluorine-containing polymer. The amount is preferably 0 mol% or more, more preferably 0.1 mol% or more, still more preferably 0.5 mol% or more, of all polymerized units of the fluorine-containing polymer.

According to a particularly preferred embodiment, the first fluorine-containing polymer of the disclosure contains 10 to 90 mol% of a TFE, HFP, or CTFE unit, 10 to 80 mol% of a unit based on the monomer represented by the formula (A), 0 to 80 mol% of a unit based on the vinyl ester monomer different from the monomer represented by the formula (A), and 0 to 10 mol% of the different monomer unit.

According to a more preferred embodiment, the first fluorine-containing polymer of the disclosure contains 20 to 80 mol% of the TFE, HFP, or CTFE unit, 10 to 70 mol% of the unit based on the monomer represented by the formula (A), 0 to 60 mol% of the unit based on the vinyl ester monomer different from the monomer represented by the formula (A), and 0 to 10 mol% of the different monomer unit. According to a still more preferred embodiment, the first fluorine-containing polymer of the disclosure contains 30 to 70 mol% of the TFE, HFP, or CTFE unit, 20 to 60 mol% of the unit based on the monomer represented by the formula (A), 0 to 40 mol% of the unit based on the vinyl ester monomer different from the monomer represented by the formula (A), and 0 to 10 mol% of the different monomer unit. According to a particularly preferred embodiment, the first fluorine-containing polymer of the disclosure contains 35 to 65 mol% of the TFE, HFP, or CTFE unit, 25 to 55 mol% of the unit based on the monomer represented by the formula (A), 0 to 35 mol% of the unit based on the vinyl ester monomer different from the monomer represented by the formula (A), and 0 to 5 mol% of the different monomer unit.

According to a preferred embodiment, the first fluorine-containing polymer of the disclosure contains 10 to 90 mol% of the TFE, HFP, or CTFE unit, 10 to 80 mol% of the unit based on the monomer represented by the formula (A), and 1 to 60 mol% of a unit based on the monomer (2) represented by the formula (2).

According to a more preferred embodiment, the first fluorine-containing polymer of the disclosure contains 20 to 80 mol% of the TFE, HFP, or CTFE unit, 10 to 70 mol% of the unit based on the monomer represented by the formula (A), and 5 to 50 mol% of the unit based on the monomer (2) represented by the formula (2). According to a still more preferred embodiment, the first fluorine-containing polymer of the disclosure contains 30 to 70 mol% of the TFE, HFP, or CTFE unit, 20 to 60 mol% of the unit based on the monomer represented by the formula (A), and 10 to 40 mol% of the unit based on the monomer (2) represented by the formula (2). According to a particularly preferred embodiment, the first fluorine-containing polymer of the disclosure contains 35 to 65 mol% of the TFE, HFP, or CTFE unit, 25 to 55 mol% of the unit based on the monomer represented by the formula (A), and 10 to 30 mol% of the unit based on the monomer (2) represented by the formula (2) .

The first fluorine-containing polymer of the disclosure is preferably a compound including a group obtained by esterifying a highly acidic OH group, specifically an OH group having a pKa of 25 or less (a value measured in a dimethyl sulfoxide solvent), with an aromatic or fatty acid (hereafter, this group is also referred to as an "active ester group (A)) (hereafter, this compound is also referred to as an "active ester compound (A)"). The fluorine-containing polymer of the disclosure being the active ester compound (A) is more efficiently reactive with epoxy resins.

For example, a fluorine-containing alcohol is known as a highly acidic alcohol, having a pKA of 25 or less (a value measured in a dimethyl sulfoxide solvent; the same applies hereafter). For example, it is known that $(CH_3)_3COH$

which is a fluorine-free alcohol has a pKa of 32.2, while $CF_3CH_2OH$ has a pKa of 23.5 and $(CF_3)_2CHOH$ has a pKa of 17.9.

In contrast, a phenolic hydroxy group has a pKa similar to that of a fluorine-containing alcohol. It is known that naphthol has a pKa of 17.2 and 2,6-di-t-butylphenol has a pKa of 16.8.

The first fluorine-containing polymer of the disclosure preferably contains a polymerized unit based on a monomer including the active ester group (A).

The fluorine-containing polymer of the disclosure contains the polymerized unit based on a monomer including the active ester group (A) in an amount of preferably 10 to 70 mol%, more preferably 20 to 60 mol%, still more preferably 25 to 55 mol%, of all polymerized units.

In order to achieve a low dielectric constant and a low dielectric loss tangent, the first fluorine-containing polymer of the disclosure has a fluorine content of preferably 20% by mass or more. The fluorine content is more preferably 25% by mass or more, still more preferably 30% by mass or more, particularly preferably 35% by mass or more.

The fluorine content of the fluorine-containing polymer can be determined by elemental analysis using an automatic sample combustion device.

The first fluorine-containing polymer of the disclosure has a vinyl ester monomer unit equivalent of preferably 90 to 5000 g/eg. The vinyl ester monomer unit equivalent is more preferably 90 to 1000 g/eg, still more preferably 90 to 500 g/eg.

The vinyl ester monomer unit equivalent can be calculated from the composition of the polymer.

The first fluorine-containing polymer of the disclosure has a number average molecular weight of preferably 1000 to 50000. When the number average molecular weight is within the above range, the fluorine-containing polymer has higher reactivity as an active ester to efficiently react with epoxy resins, leading to firm bonding of a resin layer of a metal-clad laminated sheet to a metal foil. The number average molecular weight of the fluorine-containing polymer is more preferably 1000 to 30000, more preferably 1000 to 20000, still more preferably 1000 to 15000.

In order to increase the gel fraction, the number average molecular weight is preferably 10000 or less, more preferably 7000 or less, still more preferably 5000 or less, particularly preferably 3000 or less.

The number average molecular weight of the fluorine-containing polymer can be determined by gel permeation chromatography (GPC).

The first fluorine-containing polymer of the disclosure has a glass transition temperature of preferably 30°C or higher, more preferably 40°C or higher, still more preferably 50°C or higher, even more preferably 60°C or higher, furthermore preferably 65°C or higher, still furthermore preferably 70°C or higher, particularly preferably 100°C or higher. A higher glass transition temperature is preferred. Still, in terms of processability, the glass transition temperature is preferably 200°C or lower.

The glass transition temperature is a value determined in accordance with ASTM E1356-98 from heat absorption in the second run by the midpoint method, using a differential scanning calorimeter under the following conditions.

Measurement conditions
Rate of temperature rise: 20°C/min
Amount of sample: 10 mg
Heat cycle: -50°C to 150°C, heating-cooling-heating

The first fluorine-containing polymer of the disclosure includes a chain of a fluorine-containing vinyl monomer unit (T')-a vinyl ester monomer unit (V')-a fluorine-containing vinyl monomer unit (T') (T'V'T' chain) in an amount of 45 mol% or more. The T'V'T' chain contained in an amount of 45 mol% or more contributes to a larger gel fraction. In order to achieve a further increase in the gel fraction, the T'V'T' chain is contained in an amount of preferably 50 mol% or more, more preferably 55 mol% or more, still more preferably 60 mol% or more, even more preferably 65 mol% or more, furthermore preferably 70 mol% or more, particularly preferably 75 mol% or more.

The amount of the T'V'T' chain can be calculated from the peak area obtained in NMR analysis. For example, in the case where the fluorine-containing vinyl monomer is TFE and the vinyl ester monomer is vinyl benzoate, the T'V'T' chain gives a peak at around 6.1 ppm. Similarly, a T'V'V'T' chain gives a peak at around 5.9 ppm and a T'V'V'V'T' chain gives a peak at around 5.6 ppm. Based on the resulting peak areas, the proportion of the T'V'T' chain can be calculated using the following equation. The unit used here is mol%.

$$\text{(Proportion of T'V'T' chain)} = \text{((Peak area of T'V'T' chain)/((peak area of T'V'T' chain) + (peak area of T'V'V'T' chain) + (peak area of T'V'V'V'T' chain)))} \times 100$$

The proportion of the T'V'V'T' chain and the proportion of the T'V'V'V'T' chain are similarly calculated.

The fluorine-containing vinyl monomer unit is preferably a polymerized unit based on TFE (TFE unit). The vinyl ester monomer unit is preferably a polymerized unit based on vinyl benzoate.

The first fluorine-containing polymer of the disclosure can be produced by preparing the fluorine-containing polymer having the above composition.

The first fluorine-containing polymer of the disclosure can be produced by solution polymerization, emulsion polymerization, suspension polymerization, or bulk polymerization, preferably by solution polymerization.

The first fluorine-containing polymer of the disclosure is preferably produced by polymerizing monomers capable of providing the above units by solution polymerization in which additives such as an organic solvent, a polymerization initiator, or a chain transfer agent are used. The polymerization temperature is normally 0°C to 150°C, preferably 5°C to 95°C. The polymerization pressure is normally 0.1 to 10 MPaG (1 to 100 kgf/$cm^2$G).

Examples of the organic solvent include: esters such as methyl acetate, ethyl acetate, propyl acetate, n-butyl acetate, and tert-butyl acetate; ketones such as acetone, methyl ethyl ketone, and cyclohexanone; aliphatic hydrocarbons such as hexane, cyclohexane, octane, nonane, decane, undecane, dodecane, and mineral spirits; aromatic hydrocarbons such as benzene, toluene, xylene, naphthalene, and solvent naphtha; alcohols such as methanol, ethanol, tert-butanol, iso-propanol, and ethylene glycol monoalkyl ether; cyclic ethers such as tetrahydrofuran, tetrahydropyran, and dioxane; dimethyl sulfoxide; and mixtures of these.

Examples of the polymerization initiator include: persulfates such as ammonium persulfate and potassium persulfate (optionally in combination with a reducing agent such as sodium bisulfite, sodium metabisulfite, cobalt naphthenate, or dimethylaniline); redox initiators containing an oxidant (e.g., ammonium peroxide, potassium peroxide), a reducing agent (e.g., sodium sulfite), and a transition metal salt (e.g., iron sulfate); diacylperoxides such as acetyl peroxide and benzoyl peroxide; dialkoxycarbonyl peroxides such as isopropoxycarbonyl peroxide and tert-butoxycarbonyl peroxide; ketone peroxides such as methyl ethyl ketone peroxide and cyclohexanone peroxide; hydroperoxides such as hydrogen peroxide, tert-butyl hydroperoxide, and cumene hydroperoxide; dialkyl peroxides such as di-tert-butyl peroxide and dicumyl peroxide; alkyl peroxy esters such as tert-butyl peroxyacetate and tert-butyl peroxypivalate; and azo compounds such as 2,2'-azobisisobutyronitrile, 2,2'-azobis(2,4-dimethylvaleronitrile), 2,2'-azobis(2-methylvaleronitrile), 2,2'-azobis(2-cyclopropyl propionitrile), dimethyl 2,2'-azobis(isobutyrate), 2,2'-azobis[2-(hydroxymethyl)propionitrile], and 4,4'-azobis(4-cyanopentenoic acid).

The chain transfer agent may be, for example, an alcohol, preferably a C1-C10 alcohol, more preferably a C1-C10 monohydric alcohol. Specific examples of usable alcohols include methanol, ethanol, propanol, isopropanol, n-butanol, t-butanol, 2-methylpropanol, cyclohexanol, methyl cyclohexanol, cyclopentanol, methyl cyclopentanol, and dimethyl cyclopentanol. Among these, preferred are methanol, isopropanol, t-butanol, cyclohexanol, methyl cyclohexanol, cyclopentanol, and methyl cyclopentanol, and particularly preferred are methanol and isopropanol.

The fluorine-containing polymer containing 45 mol% or more of the T'V'T' chain can be produced by polymerization in which the proportion of the fluorine-containing vinyl monomer is increased, the amount of the vinyl ester monomer fed to the reactor per unit time is reduced, or a mixture of the monomers and a solvent is introduced into the reactor.

The first composition for a metal-clad laminated sheet of the disclosure contains the first fluorine-containing polymer of the disclosure and a solvent.

Containing the fluorine-containing polymer having the above structure, the first composition for a metal-clad laminated sheet of the disclosure is excellent in compatibility with epoxy resins. The use of the first composition for a metal-clad laminated sheet of the disclosure in a resin layer of a metal-clad laminated sheet allows the resin layer to have a low dielectric constant and a low dielectric loss tangent. The disclosure provides the use of the composition for a metal-clad laminated sheet in metal-clad laminated sheets (resin layers of metal-clad laminated sheets).

The first composition for a metal-clad laminated sheet of the disclosure contains a solvent. The solvent is preferably an organic solvent. Examples of the organic solvent include, but are not limited to: esters such as ethyl acetate, butyl acetate, isopropyl acetate, isobutyl acetate, cellosolve acetate, and propylene glycol methyl ether acetate; ketones such as acetone, methyl ethyl ketone, methyl isobutyl ketone, and cyclohexanone; cyclic ethers such as tetrahydrofuran and dioxane; amides such as N,N-dimethylformamide and N,N-dimethylacetamide; aromatic hydrocarbons such as toluene and xylene; alcohols such as propylene glycol methyl ether; carbon hydrides such as hexane and heptane; and solvent mixtures containing these.

The first composition for a metal-clad laminated sheet of the disclosure may further contain a curing accelerator. Examples of the curing accelerator include phosphor compounds, tertiary amines, imidazole compounds, pyridine compounds, organic acid metal salts, Lewis acid, and amine complex salts. The curing accelerator is preferably a basic catalyst. Specifically, preferred is at least one selected from the group consisting of alkali metal hydroxides, pyridines, and imidazole compounds. More preferred is at least one selected from the group consisting of tertiary amines, imidazole compounds, pyridine compounds, and amine complex salts, still more preferred is at least one selected from the group consisting of imidazole compounds and pyridine compounds, and particularly preferred is 4-dimethylaminopyridine or 2-ethyl-4-methylimidazole.

Each of these may be used alone or in combination of two or more.

The first composition for a metal-clad laminated sheet of the disclosure contains the fluorine-containing polymer in an amount of preferably 10% by mass or more, more preferably 25% by mass or more, still more preferably 40% by mass or more, relative to 100% by mass of the solid content. The amount may be 100% by mass or less, or 80% by mass or less.

The first composition for a metal-clad laminated sheet of the disclosure may be free from epoxy resins.

The first curable composition of the disclosure contains a fluorine-containing polymer and an epoxy resin. The fluorine-containing polymer contains a polymerized unit based on a fluorine-containing vinyl monomer and a polymerized unit based on a vinyl ester other than the polymerized unit based on a fluorine-containing vinyl monomer, and contains not more than 1 mol% in total of a polymerized unit based on a monomer containing a -OH group and a polymerized unit based on a monomer containing a - COOH group, of all polymerized units.

Conventional fluorine-containing polymers having been proposed to be used in resin layers of metal-clad laminated sheets unfortunately do not have sufficient compatibility with epoxy resins.

The first curable composition of the disclosure containing the fluorine-containing polymer is excellent in compatibility with epoxy resins, and therefore has a low dielectric constant and a low dielectric loss tangent. Moreover, the first curable composition of the disclosure has excellent properties including dispersibility, moisture resistance, heat resistance, flame retardancy, and adhesiveness.

The first curable composition of the disclosure containing the fluorine-containing polymer can form resin layers having a low dielectric constant and a low dielectric loss tangent, and therefore is particularly suitable for forming resin layers of metal-clad laminated sheets.

The first curable composition of the disclosure is preferably a curable composition for a metal-clad laminated sheet. The disclosure provides the use of the curable composition in metal-clad laminated sheets (resin layers of metal-clad laminated sheets).

In the first curable composition of the disclosure, the fluorine-containing polymer is the same as the fluorine-containing polymer for a metal-clad laminated sheet of the disclosure and that in the composition for a metal-clad laminated sheet of the disclosure. Accordingly, all the preferred embodiments of the fluorine-containing polymer having been described for the fluorine-containing polymer for a metal-clad laminated sheet and the composition for a metal-clad laminated sheet of the disclosure are employable.

Examples of the epoxy resin include a phenol novolac-type epoxy resin, a cresol novolac-type epoxy resin, a naphthol novolac-type epoxy resin, a bisphenol novolac-type epoxy resin, a biphenol novolac-type epoxy resin, a bisphenol-type epoxy resin, a biphenyl-type epoxy resin, a triphenol methane-type epoxy resin, a tetraphenol ethane-type epoxy resin, a dicyclopentadiene-phenol addition reaction-type epoxy resin, a phenolaralkyl-type epoxy resin, and a naphtholaralkyl-type epoxy resin.

More specific examples include: EPIKOTE 828 (available from Shell chemicals Co., Ltd.) which is an epibis type compound based on bisphenol A or the like; EPICLON 800, EPICLON 4050, and EPICLON 1121N (all available from DIC Corporation) which are alkyl-modified type compounds; glycidyl ester compounds such as Shodyne (available from Showa Denko K.K.) and Araldite CY-183 (available from Ciba-Geigy); EPIKOTE 154 (available from Shell chemicals Co., Ltd.), and DEN 431 and DEN 438 (both available from The Dow Chemical Company) which are novolac-type compounds; ECN 1280 and ECN1235 (both available from Ciba-Geigy) which are cresol novolac-type compounds; and EPU-6 and EPU-10 (both available from Jyuryu Kagaku Co., Ltd.) which are urethane-modified type compounds.

The epoxy resin has a weight average molecular weight of preferably 100 to 1000000. When the weight average molecular weight of the epoxy resin is within this range, the resulting resin layer can be firmly bonded to a metal foil. The weight average molecular weight of the epoxy resin is more preferably 1000 to 100000.

The weight average molecular weight of the epoxy resin can be determined, for example, by gel permeation chromatography (GPC).

The epoxy resin has an epoxy equivalent of preferably 50 to 5000 g/eg. The epoxy equivalent is more preferably 50 to 1000 g/eg, still more preferably 50 to 500 g/eg.

The epoxy equivalent can be determined in conformity with JIS 7236.

In the first curable composition of the disclosure, a ratio (value obtained by multiplying the mass and the vinyl ester monomer unit equivalent of the fluorine-containing polymer)/(value obtained by multiplying the mass and the epoxy equivalent of the epoxy resin) is preferably 0.4 to 2.0. The ratio is more preferably 0.5 to 1.5, still more preferably 0.7 to 1.3, even more preferably 0.8 to 1.2, particularly preferably 0.9 to 1.1. When the ratio is within the above range, the fluorine-containing polymer and the epoxy resin can be efficiently cured.

The first curable composition of the disclosure contains the epoxy resin in an amount of preferably 1 part by mass or more, more preferably 50 parts by mass or more, still more preferably 80 parts by mass or more, relative to 100 parts by mass of the fluorine-containing polymer, in terms of the dielectric constant, dielectric loss tangent, dispersibility, moisture resistance, heat resistance, flame retardancy, and adhesiveness. The amount of the epoxy resin is preferably 1000 parts by mass or less, more preferably 500 parts by mass or less, still more preferably 300 parts by

mass or less, particularly preferably 200 parts by mass or less, relative to 100 parts by mass of the fluorine-containing polymer.

The first curable composition of the disclosure may contain, in addition to the epoxy resin, additives such as a flame retardant, an inorganic filler, a silane coupling agent, a mold release agent, a pigment, and an emulsifier.

The first curable composition of the disclosure preferably further contains a curing accelerator. Examples of the curing accelerator include phosphor compounds, tertiary amines, imidazole compounds, pyridine compounds, organic acid metal salts, Lewis acid, and amine complex salts. The curing accelerator is preferably a basic catalyst. Specifically, preferred is at least one selected from the group consisting of alkali metal hydroxides, pyridines, and imidazole compounds. More preferred is at least one selected from the group consisting of tertiary amines, imidazole compounds, pyridine compounds, and amine complex salts, still more preferred is at least one selected from the group consisting of imidazole compounds and pyridine compounds, and particularly preferred is 4-dimethylaminopyridine or 2-ethyl-4-methylimidazole.

Each of these may be used alone or in combination of two or more.

The first curable composition of the disclosure may contain various additives in accordance with demanded properties. Examples of the additives include pigment dispersants, defoamers, leveling agents, UV absorbents, light stabilizers, thickeners, adhesion improvers, and matting agents.

In the case where the first curable composition of the disclosure contains the various additives mentioned above, the curable composition of the disclosure contains the fluorine-containing polymer and the epoxy resin in a total amount of preferably 5% by mass or more, more preferably 50% by mass or more, still more preferably 70% by mass or more, even more preferably 80% by mass or more, relative to 100% by mass of the solid content.

The first curable composition of the disclosure preferably contains an organic solvent. Examples of the organic solvent include: esters such as ethyl acetate, butyl acetate, isopropyl acetate, isobutyl acetate, cellosolve acetate, and propylene glycol methyl ether acetate; ketones such as acetone, methyl ethyl ketone, methyl isobutyl ketone, and cyclohexanone; cyclic ethers such as tetrahydrofuran and dioxane; amides such as N,N-dimethylformamide and N,N-dimethylacetamide; aromatic hydrocarbons such as toluene and xylene; alcohols such as propylene glycol methyl ether; carbon hydrides such as hexane and heptane; and solvent mixtures containing these.

The curable composition of the disclosure has a solid content concentration of 10 to 80% by mass in total of the fluorine-containing polymer and the epoxy resin. When the solid content concentration is within this range, the curable composition has an appropriate viscosity to be applied to form a uniform coating.

The first curable composition of the disclosure may be prepared by any method. An exemplary method includes mixing a solution or dispersion of a fluorine-containing polymer with a solution or dispersion of an epoxy resin.

The first curable composition of the disclosure can be used not only in a resin layer of a metal-clad laminated sheet but also as a resin for a powder coating composition or a resin for an optical application.

The first metal-clad laminated sheet of the disclosure is a metal-clad laminated sheet including: a metal foil; and a resin layer provided on the metal foil, the resin layer being formed of the curable composition of the disclosure. The resin layer can be formed by curing the first curable composition of the disclosure.

The first metal-clad laminated sheet of the disclosure is a metal-clad laminated sheet including: a metal foil; and a resin layer provided on the metal foil. The resin layer contains a fluorine-containing polymer and an epoxy resin. The fluorine-containing polymer contains a polymerized unit based on a fluorine-containing vinyl monomer and a polymerized unit based on a vinyl ester other than the polymerized unit based on a fluorine-containing vinyl monomer, and contains not more than 1 mol% in total of a polymerized unit based on a monomer containing a -OH group and a polymerized unit based on a monomer containing a -COOH group, of all polymerized units.

The first metal-clad laminated sheet of the disclosure includes a metal foil and a resin layer. The resin layer has excellent insulation properties to serve as a substrate of the metal-clad laminated sheet.

Examples of the metal foil include metal foil consisting of copper, aluminum, iron, nickel, chromium, molybdenum, tungsten, zinc, or alloys of these. Preferred is copper foil. In order to improve the adhesive strength, chemical or mechanical surface treatment may be performed by siding, nickel plating, copper-zinc alloy plating, or use of an aluminum alcoholate, aluminum chelate, silane coupling agent, or the like.

The resin layer contains the epoxy resin in an amount of preferably 1 part by mass or more, more preferably 10 parts by mass or more, still more preferably 50 parts by mass or more, particularly preferably 80 parts by mass or more, relative to 100 parts by mass of the fluorine-containing polymer. The amount of the epoxy resin is preferably 1000 parts by mass or less, more preferably 500 parts by mass or less, still more preferably 300 parts by mass or less, particularly preferably 200 parts by mass or less, relative to 100 parts by mass of the fluorine-containing polymer. Too much fluorine-containing polymer may lower the adhesiveness, while too much epoxy resin may lower the insulation properties, moisture resistance, heat resistance, or flame retardancy.

The resin layer is formed of the first curable composition of the disclosure, and the fluorine-containing polymer and the epoxy resin are crosslinked therein. Accordingly, the above ratio is a ratio of the amount of a resin portion derived from the epoxy resin relative to 100 parts by mass of a resin portion derived from the fluorine-containing polymer.

The first metal-clad laminated sheet of the disclosure may include different layer(s) in addition to the metal foil and the resin layer. One metal foil and one resin layer each may be used alone, or two or more different metal foils and two or more different resin layers each may be used in combination.

The first metal-clad laminated sheet of the disclosure may further include a second resin layer on the resin layer (hereafter, referred to as a "first resin layer"). Specifically, the first metal-clad laminated sheet of the disclosure may include a metal foil, a first resin layer, and a second resin layer in the stated order. The first resin layer may serve not only as a substrate but also as an adhesive layer bonding the metal foil and the second resin layer.

In the first metal-clad laminated sheet of the disclosure, the first resin layer may be also provided on a face (opposite face) of the metal foil different from the face where the first resin layer is already provided. Specifically, the first metal-clad laminated sheet of the disclosure may include a first resin layer, a metal foil, and a first resin layer in the stated order or include a first resin layer, a metal foil, a first resin layer, and a second resin layer in the stated order.

The second resin layer may be formed of a resin conventionally used in printed substrates. The second resin layer is preferably formed of at least one resin selected from the group consisting of polyethylene terephthalate and polyimide. In terms of heat resistance, preferred is polyimide.

The first resin layer used may be a film having a thickness of 1 to 150 μm. In the case where the metal foil and a second adhesive layer are bonded via the first resin layer, the first resin layer may have a dry thickness of 1 to 100 μm.

The second resin layer used may be a resin film having a thickness of 1 to 150 μm.

The first metal-clad laminated sheet of the disclosure can be obtained by a production method including bonding a metal foil and a film containing an epoxy resin and the first fluorine-containing polymer for a metal-clad laminated sheet of the disclosure to provide a metal-clad laminated sheet.

Suitably, the bonding is performed by laminating a metal foil and a film containing an epoxy resin and the fluorine-containing polymer on each other and then thermocompression bonding the resulting laminate at 50°C to 300°C with a hot press machine.

The production method may further include molding a composition containing an epoxy resin and the fluorine-containing polymer to provide a film containing an epoxy resin and the fluorine-containing polymer.

Examples of the molding method include, but are not limited to, melt extrusion molding, solvent casting, and spraying. The composition containing an epoxy resin and the fluorine-containing polymer may contain additives such as an organic solvent or a curing agent, or other additives such as a curing accelerator, a pigment dispersant, a defoamer, a leveling agent, a UV absorbent, a light stabilizer, a thickener, an adhesion modifier, or a matting agent, as described later.

The first metal-clad laminated sheet of the disclosure can be also obtained by a production method including applying a composition containing an epoxy resin and the fluorine-containing polymer to a metal foil to form a first resin layer.

The production method may further include, after the step of forming a first resin layer, bonding a resin film that is to serve as a second resin layer to the first resin layer to provide a metal-clad laminated sheet including a metal foil and first and second resin layers. Examples of the resin film include a film formed of a resin suitable for forming a second resin layer.

The resin film is suitably bonded by thermocompression bonding at 50°C to 300°C with a hot press machine.

In the production method, the composition for forming a first resin layer is applied to a metal foil, for example, by brush coating, dip coating, spray coating, comma coating, knife coating, die coating, lip coating, roll coater coating, curtain coating, or the like. After application of the composition, the composition is dried in a hot air drying oven at 25°C to 200°C for one minute to one week to be cured.

The first metal-clad laminated sheet of the disclosure can also be produced by a production method including: applying the first curable composition of the disclosure to a resin film that is to serve as a second resin layer to form a first resin layer; and bonding a metal foil to the first resin layer side of the resulting laminate including the first resin layer and the second resin layer to provide a metal-clad laminated sheet including a metal foil and first and second resin layers. The resin film used may be, for example, a film formed of a resin suitable for forming a second resin layer.

The composition for forming a first resin layer is applied to a resin film, for example, by brush coating, dip coating, spray coating, comma coating, knife coating, die coating, lip coating, roll coater coating, curtain coating, or the like. After application of the composition, the composition is dried in a hot air drying oven at 25°C to 200°C for one minute to one week to be cured.

In the production method, a metal foil is bonded to the first resin layer side of the laminate including the first resin layer and the second resin layer by arranging the laminate including the first resin layer and the second resin layer on the metal foil in a manner that the first resin layer is in contact with the metal foil, followed by thermocompression bonding at 50°C to 300°C with a hot press machine.

The disclosure also provides a printed substrate including a patterned circuit formed by etching the metal foil of the first metal-clad laminated sheet of the disclosure. The printed substrate of the disclosure may be a flexible substrate or a rigid substrate. Preferred is a flexible substrate.

The first printed substrate of the disclosure may include a coverlay film on the metal-clad laminated sheet, and

the coverlay film may be bonded to the metal-clad laminated sheet via the resin layer.

The etching may be performed by any conventionally known method. The patterned circuit is not limited. The printed substrate may have any patterned circuit.

The application of the first printed substrate of the disclosure is not limited. For example, since including a resin layer having a low dielectric constant and a low dielectric loss tangent, the printed substrate of the disclosure can be used for applications using higher frequency bands such as 4G (37.5 Mbps) or 5G (several Gbps to 20 Gbps).

The second fluorine-containing polymer of the disclosure contains: a polymerized unit based on TFE and a polymerized unit based on a vinyl ester monomer. The second fluorine-containing polymer contains a chain of a TFE unit-a vinyl ester monomer unit-a TFE unit in an amount of 45 mol% or more and contains not more than 1 mol% in total of a polymerized unit based on a monomer containing a hydroxy group and a polymerized unit based on a monomer containing a carboxy group, of all polymerized units. The second fluorine-containing polymer of the disclosure having the above structure is excellent in compatibility with epoxy resins and further can increase the gel fraction after acetone immersion.

The second fluorine-containing polymer of the disclosure contains a chain of a TFE unit (T)-a vinyl ester monomer unit (V)-a TFE unit (T) (TVT chain) in an amount of 45 mol% or more. Containing the TVT chain in an amount of 45 mol% or more, the second fluorine-containing polymer is excellent in reactivity with epoxy resins. In order to achieve higher reactivity with epoxy resins, the second fluorine-containing polymer of the disclosure contains the TVT chain in an amount of preferably 50 mol% or more, more preferably 55 mol% or more, still more preferably 60 mol% or more, even more preferably 65 mol% or more, furthermore preferably 70 mol% or more, particularly preferably 75 mol% or more.

The amount of the TVT chain can be calculated from the peak area obtained in NMR analysis. For example, in the case where the vinyl ester monomer is vinyl benzoate, the TVT chain gives a peak at around 6.1 ppm. Similarly, a TVVT chain gives a peak at around 5.9 ppm and a TVVVT chain gives a peak at around 5.6 ppm. Based on the resulting peak areas, the proportion of each chain is calculated. In the case of using a different monomer, the peak positions are similarly obtained, and the proportion of the chain can be calculated.

The fluorine-containing polymer containing a TVT chain in an amount of 45 mol% or more can be produced by increasing the proportion of TFE or reducing the amount of the vinyl ester monomer fed to the reactor per unit time.

The second fluorine-containing polymer of the disclosure contains a polymerized unit based on TFE (hereafter, also referred to as a "TFE unit"). The TFE unit excellently has a low dielectric constant and a low dielectric loss tangent and therefore is contained in an amount of preferably 10 mol% or more, more preferably 20 mol% or more, still more preferably 30 mol% or more, even more preferably 40 mol% or more, particularly preferably 50 mol% or more, while preferably 80 mol% or less, more preferably 70 mol% or less, still more preferably 60 mol% or less, of all polymerized units constituting the fluorine-containing polymer.

The second fluorine-containing polymer of the disclosure contains a polymerized unit based on a vinyl ester monomer other than the fluorine-containing vinyl monomer (hereafter, referred to as a "vinyl ester monomer unit"). Containing the vinyl ester monomer unit, the second fluorine-containing polymer of the disclosure can generate an active ester to react with an epoxy resin.

The vinyl ester monomer is the same as that of the first fluorine-containing polymer of the disclosure. In particular, preferred is a monomer represented by the formula (A). Particularly, the vinyl ester monomer preferably includes at least one selected from the group consisting of vinyl benzoate, vinyl para-t-butylbenzoate, vinyl acetate, and vinyl pivalate, more preferably at least one selected from the group consisting of vinyl benzoate, vinyl para-t-butylbenzoate, and vinyl acetate.

The vinyl ester monomer unit is preferably contained in an amount of preferably 10 mol% or more, more preferably 20 mol% or more of all polymerized units of the second fluorine-containing polymer of the disclosure for achieving excellent compatibility and high reactivity with epoxy resins. The vinyl ester monomer unit is contained in an amount of still more preferably 30 mol% or more, even more preferably 40 mol% or more, of all polymerized units. For achieving excellent heat resistance, the amount is preferably 80 mol% or less, more preferably 70 mol% or less, still more preferably 60 mol% or less.

According to a preferred embodiment, the second fluorine-containing polymer of the disclosure contains 10 to 100 mol% of a polymerized unit based on a monomer represented by the formula (A) and 0 to 90 mol% of a polymerized unit based on a vinyl ester monomer different from the monomer represented by the formula (A), relative to 100 mol% in total of the vinyl ester monomer units. The polymerized unit based on a monomer represented by the formula (A) is contained in an amount of more preferably 20 to 90 mol%, still more preferably 30 to 80 mol%, even more preferably 35 to 75 mol%, particularly preferably 40 to 70 mol%, relative to 100 mol% in total of the vinyl ester monomer units. The polymerized unit based on a vinyl ester monomer different from the monomer represented by the formula (A) is contained in an amount of more preferably 10 to 80 mol%, still more preferably 20 to 70 mol%, even more preferably 25 to 65 mol%, particularly preferably 30 to 60 mol%, relative to 100 mol% in total of the vinyl ester monomer units.

In order to use the second fluorine-containing polymer of the disclosure in metal-clad laminated sheets, the second fluorine-containing polymer of the disclosure is desired to have excellent heat resistance. Accordingly, the vinyl

ester monomer different from the monomer represented by the formula (A) is preferably a vinyl ester monomer that can increase the glass transition temperature by crosslinking. Examples thereof include vinyl cinnamate, vinyl β-styryl acrylate, vinyl β-furyl acrylate, and vinyl p-azidocinnamate.

The vinyl ester monomer may contain no hydroxy or carboxy group.

The second fluorine-containing polymer of the disclosure may further contain a polymerized unit based on a monomer different from TFE or the vinyl ester monomer (hereafter, referred to as a "different monomer") (hereafter, this polymerized unit is referred to as a "different monomer unit").

The different monomer is the same as that of the first fluorine-containing polymer of the disclosure, and examples thereof include alkyl vinyl ethers containing no hydroxy group, non-fluorinated olefins containing no halogen atom or no hydroxy group, amino group-containing monomers containing no NH group, hydrolyzable silyl group-containing monomers containing no OH group, epoxy group-containing monomers, oxetane group-containing monomers, heterocycle-containing monomers, and (meth)acrylic acid ester monomers. For these monomers, all the monomers exemplified for the first fluorine-containing polymer of the disclosure are employable.

The (meth)acrylic acid ester is preferably an aromatic ester or an alicyclic ester of (meth)acrylic acid because it can increase the polymer glass transition temperature. The (meth)acrylic acid ester is particularly preferably a monomer (2) represented by the following formula (2):

[Chem. 5]

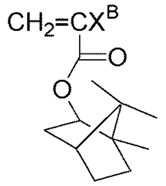

(2)

(wherein $X^B$ is H or $CH_3$), or phenyl (meth) acrylate. An aromatic ester of (meth)acrylic acid is preferred as it can serve as an active ester, and phenyl (meth)acrylate is preferred.

In the disclosure, the term "(meth)acrylic acid" means methacrylic acid or acrylic acid.

The different monomer preferably includes an epoxy group-containing monomer or an oxetane group-containing monomer in terms of curability. Examples of the epoxy group-containing monomer include allyl glycidyl ether, 4-hydroxybutyl acrylate glycidyl ether, and 3,4-epoxycyclohexyl methyl methacrylate. Examples of the oxetane group-containing monomer include (3-ethyloxetan-3-yl)methyl acrylate. The amount of the epoxy group- or oxetane group-containing monomer is preferably 0.1 mol% or more, more preferably 0.5 mol% or more, still more preferably 1 mol% or more, of all polymerized units. The amount is preferably 15 mol% or less, more preferably 10 mol% or less, particularly preferably 5 mol% or less.

The different monomer that contains no hydroxy or carboxy group is preferably a heterocycle-containing monomer containing no hydroxy or carboxy group in order to improve the adherence. Examples of the heterocycle-containing monomer include: monomers containing a cyclic ether group such as furan, tetrahydrofurfuryl acrylate, and (2-methyl-2-ethyl-1,3-dioxolan-4-yl)methyl acrylate; monomers containing a lactone group such as 5-oxo-4-oxatricyclo[4.2.1.03.7]nonan-2-yl=acrylate; monomers containing an acid anhydride group such as itaconic anhydride, citraconic anhydride, and 5-norbornene-2,3-dicarboxylic acid anhydride; and monomers containing a pyrrolidone group such as N-vinyl-2-pyrrolidone. The amount of the heterocycle-containing monomer is preferably 0.1 mol% or more, more preferably 0.5 mol% or more, still more preferably 1 mol% or more, of all polymerized units. In terms of heat resistance, the amount is preferably 20 mol% or less, more preferably 10 mol% or less, particularly preferably 5 mol% or less.

The different monomer preferably includes the monomer (2) in terms of heat resistance. In the formula (2), $X^B$ is H or $CH_3$, preferably H. In order to further improve heat resistance, the polymerized unit based on the monomer (2) is contained in an amount of preferably 10 mol% or more of all polymerized units. The amount is more preferably 15 mol% or more, still more preferably 20 mol% or more. The monomer (2) unit is contained in an amount of preferably 90 mol% or less of all polymerized units. The amount is more preferably 80 mol% or less, still more preferably 70 mol% or less, even more preferably 60 mol% or less, particularly preferably 50 mol% or less.

The second fluorine-containing polymer of the disclosure contains not more than 1 mol% in total of a polymerized unit based on a monomer containing a hydroxy group (-OH group) and a polymerized unit based on a monomer containing a carboxy group (-COOH group), of all polymerized units. The total amount of the polymerized unit based on a monomer containing a hydroxy group (-OH group) and the polymerized unit based on a monomer containing a carboxy group (-COOH group) is preferably 0.5 mol% or less, more preferably 0.3 mol% or less, still more preferably 0.1 mol% or less, particularly preferably 0.0 mol%. When the total amount of the polymerized unit based on a monomer containing a hydroxy group (-OH group) and the polymerized unit based on a monomer containing a carboxy group (-COOH group)

is within the above range, the dielectric constant and the dielectric loss tangent can be set lower.

The monomer containing a hydroxy group (-OH group) and the monomer containing a carboxy group are the same as those of the first fluorine-containing polymer of the disclosure.

The second fluorine-containing polymer of the disclosure has a molar ratio, TFE unit/vinyl ester monomer unit, of preferably (10 to 90)/(10 to 90), more preferably (20 to 80)/(20 to 80), still more preferably (30 to 70)/(30 to 70).

In the fluorine-containing polymer, the TFE unit and the vinyl ester monomer unit are contained in a total amount of preferably 70 mol% or more, more preferably 80 mol% or more, still more preferably 90 mol% or more, even more preferably 95 mol% or more, particularly preferably 97 mol% or more, of all polymerized units. The total amount may be 100 mol% of all polymerized units.

The different monomer unit is contained in an amount of preferably 30 mol% or less, more preferably 20 mol% or less, still more preferably 10 mol% or less, even more preferably 5 mol% or less, particularly preferably 3 mol% or less, of all polymerized units of the fluorine-containing polymer. The amount is preferably 0 mol% or more, more preferably 0.1 mol% or more, still more preferably 0.5 mol% or more, of all polymerized units of the fluorine-containing polymer.

According to a particularly preferred embodiment, the second fluorine-containing polymer of the disclosure contains 10 to 90 mol% of the TFE unit, 10 to 80 mol% of a unit of the monomer represented by the formula (A), 0 to 80 mol% of a unit of the vinyl ester monomer different from the monomer represented by the formula (A), and 0 to 10 mol% of the different monomer unit.

According to a more preferred embodiment, the second fluorine-containing polymer of the disclosure contains 20 to 80 mol% of the TFE unit, 10 to 70 mol% of the unit of the monomer represented by the formula (A), 0 to 60 mol% of the unit of the vinyl ester monomer different from the monomer represented by the formula (A), and 0 to 10 mol% of the different monomer unit. According to a still more preferred embodiment, the second fluorine-containing polymer of the disclosure contains 30 to 70 mol% of the TFE unit, 20 to 60 mol% of the unit of the monomer represented by the formula (A), 0 to 40 mol% of the unit of the vinyl ester monomer different from the monomer represented by the formula (A), and 0 to 10 mol% of the different monomer unit. According to a particularly preferred embodiment, the second fluorine-containing polymer of the disclosure contains 35 to 65 mol% of the TFE unit, 25 to 55 mol% of the unit of the monomer represented by the formula (A), 0 to 35 mol% of the unit of the vinyl ester monomer different from the monomer represented by the formula (A), and 0 to 5 mol% of the different monomer unit.

According to a preferred embodiment, the second fluorine-containing polymer of the disclosure contains 10 to 90 mol% of the TFE unit, 10 to 80 mol% of the unit of the monomer represented by the formula (A), and 1 to 60 mol% of a unit of the monomer (2) represented by the formula (2).

According to a more preferred embodiment, the second fluorine-containing polymer of the disclosure contains 20 to 80 mol% of the TFE unit, 10 to 70 mol% of the unit of the monomer represented by the formula (A), and 3 to 50 mol% of the unit of the monomer (2) represented by the formula (2). According to a still more preferred embodiment, the second fluorine-containing polymer of the disclosure contains 30 to 70 mol% of the TFE unit, 20 to 60 mol% of the unit of the monomer represented by the formula (A), and 5 to 40 mol% of the unit of the monomer (2) represented by the formula (2). According to a particularly preferred embodiment, the second fluorine-containing polymer of the disclosure contains 35 to 65 mol% of the TFE unit, 25 to 55 mol% of the unit of the monomer represented by the formula (A), and 10 to 30 mol% of the unit of the monomer (2) represented by the formula (2).

The second fluorine-containing polymer of the disclosure is preferably a compound including a group obtained by esterifying a highly acidic OH group, specifically an OH group having a pKa of 25 or less (a value measured in a dimethyl sulfoxide solvent), with an aromatic or fatty acid (hereafter, this group is also referred to as an "active ester group (A)) (hereafter, this compound is also referred to as an "active ester compound (A)"). The second fluorine-containing polymer of the disclosure being the active ester compound (A) is more efficiently reactive with epoxy resins.

The second fluorine-containing polymer of the disclosure preferably contains a polymerized unit based on a monomer including the active ester group (A).

The second fluorine-containing polymer of the disclosure contains the polymerized unit based on a monomer including the active ester group (A) in an amount of preferably 10 to 70 mol%, more preferably 20 to 60 mol%, still more preferably 25 to 55 mol%, of all polymerized units.

In order to achieve a low dielectric constant and a low dielectric loss tangent, the second fluorine-containing polymer of the disclosure has a fluorine content of preferably 20% by mass or more. The fluorine content is more preferably 25% by mass or more, still more preferably 30% by mass or more, particularly preferably 35% by mass or more. The fluorine content of the fluorine-containing polymer can be determined by elemental analysis using an automatic sample combustion device.

The second fluorine-containing polymer of the disclosure has a vinyl ester monomer unit equivalent of preferably 90 to 5000 g/eg. The vinyl ester monomer unit equivalent is more preferably 90 to 1000 g/eg, still more preferably 90 to 700 g/eg. The vinyl ester monomer unit equivalent can be calculated from the composition of the polymer.

The second fluorine-containing polymer of the disclosure has a number average molecular weight of preferably 1000 to 50000. When the number average molecular weight is within the above range, the fluorine-containing polymer

has higher reactivity as an active ester to efficiently react with epoxy resins, leading to firm bonding of a resin layer of a metal-clad laminated sheet to a metal foil. The number average molecular weight of the fluorine-containing polymer is more preferably 1000 to 30000, more preferably 1000 to 20000, more preferably 1000 to 15000.

The number average molecular weight is more preferably 1000 to 10000, more preferably 1000 to 7000, still more preferably 1000 to 5000, particularly preferably 1000 to 3000.

The number average molecular weight of the fluorine-containing polymer can be determined by gel permeation chromatography (GPC).

The second fluorine-containing polymer of the disclosure has a glass transition temperature of preferably 0°C or higher, more preferably 40°C or higher, still more preferably 50°C or higher, even more preferably 60°C or higher, furthermore preferably 65°C or higher, still furthermore preferably 70°C or higher, particularly preferably 100°C or higher. A higher glass transition temperature is preferred. Still, in terms of processability, the glass transition temperature is preferably 200°C or lower.

The second fluorine-containing polymer of the disclosure can be produced by the method having been described for the first fluorine-containing polymer of the disclosure.

The second composition for a metal-clad laminated sheet of the disclosure contains the second fluorine-containing polymer of the disclosure and a solvent. Containing the fluorine-containing polymer having the above structure, the second composition for a metal-clad laminated sheet of the disclosure is excellent in compatibility with epoxy resins. The use of the second composition for a metal-clad laminated sheet of the disclosure in a resin layer of a metal-clad laminated sheet allows the resin layer to have a low dielectric constant and a low dielectric loss tangent. The disclosure provides the use of the composition for a metal-clad laminated sheet in metal-clad laminated sheets (resin layers of metal-clad laminated sheets).

The second composition for a metal-clad laminated sheet of the disclosure contains a solvent. The solvent is the same as that of the first composition for a metal-clad laminated sheet of the disclosure.

The second composition for a metal-clad laminated sheet of the disclosure may further contain a curing accelerator. The curing accelerator is the same as that of the first composition for a metal-clad laminated sheet of the disclosure. Each of these may be used alone or in combination of two or more.

The second composition for a metal-clad laminated sheet of the disclosure contains the fluorine-containing polymer in an amount of preferably 10% by mass or more, more preferably 25% by mass or more, still more preferably 40% by mass or more, relative to 100% by mass of the solid content. The amount may be 100% by mass or less, or 80% by mass or less.

The second composition for a metal-clad laminated sheet of the disclosure may be free from epoxy resins.

The second curable composition of the disclosure contains the second fluorine-containing polymer of the disclosure and an epoxy resin. Conventional fluorine-containing polymers having been proposed to be used in resin layers of metal-clad laminated sheets unfortunately do not have sufficient compatibility with epoxy resins.

The second curable composition of the disclosure containing the second fluorine-containing polymer of the disclosure is excellent in compatibility with epoxy resins, and therefore has a low dielectric constant and a low dielectric loss tangent. Moreover, the second curable composition of the disclosure has excellent properties including dispersibility, moisture resistance, heat resistance, flame retardancy, and adhesiveness.

The second curable composition of the disclosure containing the second fluorine-containing polymer of the disclosure can form resin layers having a low dielectric constant and a low dielectric loss tangent, and therefore is particularly suitable for forming resin layers of metal-clad laminated sheets.

The second curable composition of the disclosure is preferably a curable composition for a metal-clad laminated sheet. The disclosure provides the use of the curable composition in metal-clad laminated sheets (resin layers of metal-clad laminated sheets).

In the second curable composition of the disclosure, the epoxy resin is the same as that of the first curable composition of the disclosure, and all the embodiments having been described for the first curable composition are employable.

In the second curable composition of the disclosure, a ratio (value obtained by multiplying the mass and the vinyl ester monomer unit equivalent of the fluorine-containing polymer)/(value obtained by multiplying the mass and the epoxy equivalent of the epoxy resin) is preferably 0.4 to 2.0. The ratio is more preferably 0.5 to 1.5, still more preferably 0.7 to 1.3, even more preferably 0.8 to 1.2, particularly preferably 0.9 to 1.1. When the ratio is within the above range, the fluorine-containing polymer and the epoxy resin can be efficiently cured.

The second curable composition of the disclosure contains the epoxy resin in an amount of preferably 1 part by mass or more, more preferably 50 parts by mass or more, still more preferably 80 parts by mass or more, relative to 100 parts by mass of the fluorine-containing polymer, in terms of the dielectric constant, dielectric loss tangent, dispersibility, moisture resistance, heat resistance, flame retardancy, and adhesiveness. The amount of the epoxy resin is preferably 1000 parts by mass or less, more preferably 500 parts by mass or less, still more preferably 300 parts by mass or less, particularly preferably 200 parts by mass or less, relative to 100 parts by mass of the fluorine-containing

polymer.

The second curable composition of the disclosure may contain, in addition to the epoxy resin, additives such as a flame retardant, an inorganic filler, a silane coupling agent, a mold release agent, a pigment, and an emulsifier.

The second curable composition of the disclosure preferably further contains a curing accelerator. The curing accelerator is the same as that of the first curable composition of the disclosure. One curing accelerator may be used alone, or two or more curing accelerators may be used in combination.

The second curable composition of the disclosure may contain various additives in accordance with demanded properties. Examples of the additives include pigment dispersants, defoamers, leveling agents, UV absorbents, light stabilizers, thickeners, adhesion improvers, and matting agents.

In the case where the second curable composition of the disclosure contains the various additives mentioned above, the second curable composition of the disclosure contains the second fluorine-containing polymer of the disclosure and the epoxy resin in a total amount of preferably 5% by mass or more, more preferably 50% by mass or more, still more preferably 70% by mass or more, even more preferably 80% by mass or more, relative to 100% by mass of the solid content.

The second curable composition of the disclosure preferably contains an organic solvent. The organic solvent is the same as that of the first curable composition of the disclosure. The second curable composition of the disclosure has a solid content concentration of 10 to 80% by mass in total of the second fluorine-containing polymer of the disclosure and the epoxy resin. When the solid content concentration is within this range, the curable composition has an appropriate viscosity to be applied to form a uniform coating.

The second curable composition of the disclosure may be prepared by any method. An exemplary method includes mixing a solution or dispersion of a fluorine-containing polymer with a solution or dispersion of an epoxy resin.

The second curable composition of the disclosure can be used not only in a resin layer of a metal-clad laminated sheet but also as a resin for a powder coating composition or a resin for an optical application.

The second metal-clad laminated sheet of the disclosure is a metal-clad laminated sheet including: a metal foil; and a resin layer provided on the metal foil, the resin layer being formed of the second curable composition of the disclosure. The resin layer can be formed by curing the second curable composition of the disclosure.

The second metal-clad laminated sheet of the disclosure is a metal-clad laminated sheet including: a metal foil; and a resin layer provided on the metal foil. The resin layer contains a fluorine-containing polymer and an epoxy resin. The fluorine-containing polymer contains a polymerized unit based on TFE and a polymerized unit based on a vinyl ester monomer. The fluorine-containing polymer contains a chain of a TFE unit-a vinyl ester monomer unit-a TFE unit in an amount of 45 mol% or more and contains not more than 1 mol% in total of a polymerized unit based on a monomer containing a hydroxy group and a polymerized unit based on a monomer containing a carboxy group, of all polymerized units.

The second metal-clad laminated sheet of the disclosure includes a metal foil and a resin layer. The resin layer has excellent insulation properties to serve as a substrate of the metal-clad laminated sheet.

The metal foil is the same as that of the first metal-clad laminated sheet of the disclosure.

The resin layer contains the epoxy resin in an amount of preferably 1 part by mass or more, more preferably 10 parts by mass or more, still more preferably 50 parts by mass or more, particularly preferably 80 parts by mass or more, relative to 100 parts by mass of the second fluorine-containing polymer of the disclosure. The amount of the epoxy resin is preferably 1000 parts by mass or less, more preferably 500 parts by mass or less, still more preferably 300 parts by mass or less, particularly preferably 200 parts by mass or less, relative to 100 parts by mass of the fluorine-containing polymer. Too much fluorine-containing polymer may lower the adhesiveness, while too much epoxy resin may lower the insulation properties, moisture resistance, heat resistance, or flame retardancy.

The resin layer is formed of the second curable composition of the disclosure, and the fluorine-containing polymer and the epoxy resin are crosslinked therein. Accordingly, the above ratio is a ratio of the amount of a resin portion derived from the epoxy resin relative to 100 parts by mass of a resin portion derived from the fluorine-containing polymer.

The second metal-clad laminated sheet of the disclosure may include different layer(s) in addition to the metal foil and the resin layer. One metal foil and one resin layer each may be used alone, or two or more different metal foils and two or more different resin layers each may be used in combination.

The second metal-clad laminated sheet of the disclosure may further include a second resin layer on the resin layer (hereafter, referred to as a "first resin layer"). Specifically, the second metal-clad laminated sheet of the disclosure may include a metal foil, a first resin layer, and a second resin layer in the stated order. The first resin layer may serve not only as a substrate but also as an adhesive layer bonding the metal foil and the second resin layer.

In the second metal-clad laminated sheet of the disclosure, the first resin layer may be also provided on a face (opposite face) of the metal foil different from the face where the first resin layer is already provided. Specifically, the second metal-clad laminated sheet of the disclosure may include a first resin layer, a metal foil, and a first resin layer in the stated order or include a first resin layer, a metal foil, a first resin layer, and a second resin layer in the stated order.

The second resin layer may be formed of a resin conventionally used in printed substrates. The second resin layer is preferably formed of at least one resin selected from the group consisting of polyethylene terephthalate and polyimide. In terms of heat resistance, preferred is polyimide.

The first resin layer used may be a film having a thickness of 1 to 150 $\mu$m. In the case where the metal foil and a second adhesive layer are bonded via the first resin layer, the first resin layer may have a dry thickness of 1 to 100 $\mu$m.

The second resin layer used may be a resin film having a thickness of 1 to 150 $\mu$m.

The second metal-clad laminated sheet of the disclosure can be produced by the same method as that for the first metal-clad laminated sheet of the disclosure, except that the fluorine-containing polymer used is the second fluorine-containing polymer of the disclosure.

The disclosure also provides a printed substrate including a patterned circuit formed by etching the metal foil of the second metal-clad laminated sheet of the disclosure (second printed substrate of the disclosure). The second printed substrate of the disclosure may be a flexible substrate or a rigid substrate. Preferred is a flexible substrate.

The second printed substrate of the disclosure may include a coverlay film on the metal-clad laminated sheet, and the coverlay film may be bonded to the metal-clad laminated sheet via the resin layer.

The etching may be performed by any conventionally known method. The patterned circuit is not limited. The printed substrate may have any patterned circuit.

The application of the second printed substrate of the disclosure is not limited. For example, since including a resin layer having a low dielectric constant and a low dielectric loss tangent, the second printed substrate of the disclosure can be used for applications using higher frequency bands such as 4G (37.5 Mbps) or 5G (several Gbps to 20 Gbps).

The third fluorine-containing polymer of the disclosure contains a polymerized unit based on a fluorine-containing vinyl monomer and a polymerized unit based on a vinyl ester monomer. The polymerized unit based on a fluorine-containing vinyl monomer and the polymerized unit based on a vinyl ester monomer are contained in a total amount of 70 to 100 mol% of all polymerized units. The fluorine-containing vinyl monomer includes at least one selected from the group consisting of tetrafluoroethylene, hexafluoropropylene, and chlorotrifluoroethylene. In the case of the fluorine-containing vinyl monomer including tetrafluoroethylene, the integral value of $CF_2H$ at a $-CF_2H$ end is not more than 2% of the integral value of entire $CF_2$ in 19F-NMR. In the case of the fluorine-containing vinyl monomer including hexafluoropropylene, the integral value of CFH at a $-CF_2CFHCF_3$ end is not more than 2% of the integral value of entire CF in 19F-NMR. In the case of the fluorine-containing vinyl monomer including chlorotrifluoroethylene, the total of the integral value of $CF_2H$ at a $-CF_2H$ end and the integral value of CFClH at a - CFClH end is not more than 2% of the total of the integral value of entire $CF_2$ and the integral value of entire CFCl in 19F-NMR. The third fluorine-containing polymer of the disclosure having the above structure can have a low dielectric loss tangent.

The third fluorine-containing polymer of the disclosure contains a polymerized unit based on a fluorine-containing vinyl monomer (hereafter, referred to as a "fluorine-containing vinyl monomer unit").

The fluorine-containing vinyl monomer includes at least one selected from the group consisting of tetrafluoroethylene (TFE), hexafluoropropylene (HFP), and chlorotrifluoroethylene (CTFE). Preferred is at least one selected from the group consisting of TFE and HFP as they are free from chlorine. Particularly preferred is TFE as it has excellent copolymerizability.

The fluorine-containing vinyl monomer unit excellently has a low dielectric constant and a low dielectric loss tangent and therefore is contained in an amount of preferably 10 mol% or more, more preferably 20 mol% or more, still more preferably 30 mol% or more, even more preferably 40 mol% or more, particularly preferably 50 mol% or more, while preferably 80 mol% or less, more preferably 70 mol% or less, still more preferably 60 mol% or less, of all polymerized units constituting the third fluorine-containing polymer of the disclosure.

In the case of the fluorine-containing vinyl monomer including TFE, the integral value of $CF_2H$ at the $-CF_2H$ end is not more than 2% of the integral value of entire $CF_2$ in 19F-NMR. As above, a smaller proportion of the $-CF_2H$ end can reduce the dielectric loss tangent. In order to achieve a lower dielectric loss tangent, the integral value of $CF_2H$ at the $-CF_2H$ end is preferably not more than 1%, more preferably not more than 0.5% relative to the integral value of entire $CF_2$ in 19F-NMR.

In the case of the fluorine-containing vinyl monomer including HFP, the integral value of CFH at the $-CF_2CFHCF_3$ end is not more than 2% of the integral value of entire CF in 19F-NMR. As above, a smaller proportion of the - $CF_2CFHCF_3$ end can reduce the dielectric loss tangent. In order to achieve a lower dielectric loss tangent, the integral value of CFH at the $-CF_2CFHCF_3$ end is preferably not more than 1%, more preferably not more than 0.5% relative to the integral value of entire CF in 19F-NMR.

In the case of the fluorine-containing vinyl monomer including CTFE, the total of the integral value of $CF_2H$ at the $-CF_2H$ end and the integral value of CFClH at the -CFClH end is not more than 2% of the total of the integral value of entire $CF_2$ and the integral value of entire CFCl in 19F-NMR. As above, a smaller proportion of the total of the - $CF_2H$ end and the -CFClH end can reduce the dielectric loss tangent. In order to achieve a lower dielectric loss tangent, the total of the integral value of $CF_2H$ at the - $CF_2H$ end and the integral value of CFClH at the -CFClH end is preferably not more than 1%, more preferably not more than 0.5% relative to the total of the integral value of entire $CF_2$ and the integral

value of entire CFCl in 19F-NMR.

Any conventional method is employable for 19F-NMR analysis or calculation of the integral values.

The proportions of the $-CF_2H$ end, the $-CF_2CFHCF_3$ end, and the -CFClH end can be reduced, for example, by the following methods.

(Method 1) A fluorine solvent is used for polymerization.
(Method 2) Use of a monomer highly susceptible to chain transfer is avoided.
(Method 3) The polymer composition is adjusted.
(Method 4) The molecular weight of the polymer is increased.

In the method 1, the fluorine solvent may be any solvent containing fluorine. Examples thereof include fluorinated alkanes, fluorinated aromatic compounds, hydrofluoroethers, fluorinated alkyl amines, and fluoroalcohols.

The fluorinated alkanes are preferably C4-C8 compounds. Examples of commercial products thereof include $C_6F_{13}H$ (ASAHIKLIN® AC-2000, available from Asahi Glass Co., LTD.), $C_6F_{13}C_2H_5$ (ASAHIKLIN® AC-6000, available from Asahi Glass Co., LTD.), and $C_2F_5CHFCHFCF_3$ (Vertrel® XF, available from The Chemours Company).

Examples of the fluorinated aromatic compounds include hexafluorobenzene, trifluoromethylbenzene, perfluorotoluene, and bis(trifluoromethyl)benzene.

The hydrofluoroethers are preferably C4-C12 compounds. Examples of commercial products thereof include $CF_3CH_2OCF_2CF_2H$ (ASAHIKLIN® AE-3000, available from Asahi Glass Co., LTD.), $C_4F_9OCH_3$ (Novec® 7100, available from 3M), $C_4F_9OC_2H_5$ (Novec® 7200, available from 3M), and $C_2F_5CF(OCH_3)C_3F7$ (Novec® 7300, available from 3M) .

Examples of the fluorinated alkyl amines include perfluorotripropylamine and perfluorotributylamine.

Examples of the fluoroalcohols include 2,2,3,3-tetrafluoropropanol, 2,2,2-trifluoroethanol, and hexafluoroisopropanol. In particular, preferred is at least one selected from the group consisting of fluorinated alkanes, hydrofluoroethers, and fluoroalcohols, and more preferred is a hydrofluoroether.

In the method 2, examples of the monomer highly susceptible to chain transfer include vinyl ethers and allyl ethers. More specifically, the examples include alkyl vinyl ethers, hydroxy alkyl vinyl ethers, alkyl allyl ethers, hydroxy alkyl allyl ethers, vinyl ethers containing other functional groups, and allyl ethers containing other functional groups.

Examples of the vinyl ethers include methyl vinyl ether, ethyl vinyl ether, n-butyl vinyl ether, iso-butyl vinyl ether, tert-butyl vinyl ether, 4-hydroxybutyl vinyl ether, stearyl vinyl ether, chloromethyl vinyl ether, 2-chloroethyl vinyl ether, chloropropyl vinyl ether, cyclohexyl vinyl ether, ethylene glycol monovinyl ether, and diethylene glycol monovinyl ether.

Examples of the allyl ethers include allyl ethyl ether, diallyl ether, and 1,3-diallyl oxy-2-propanol.

Examples of the hydroxyalkyl vinyl ethers include 2-hydroxyethyl vinyl ether, 3-hydroxypropyl vinyl ether, 2-hydroxypropyl vinyl ether, 2-hydroxy-2-methyl propyl vinyl ether, 4-hydroxybutyl vinyl ether, 4-hydroxy-2-methyl butyl vinyl ether, 5-hydroxypentyl vinyl ether, and 6-hydroxyhexyl vinyl ether.

Examples of the hydroxyalkyl allyl ethers include 2-hydroxyethyl allyl ether, 4-hydroxybutyl allyl ether, and glycerol monoallyl ether. Examples of the allyl ethers containing other functional groups include allyl glycidyl ether (AGE) containing an epoxy group.

A polymerized unit based on the monomer highly susceptible to chain transfer is contained in an amount of preferably not more than 10 mol%, more preferably not more than 5 mol%, still more preferably not more than 1 mol%, and may be 0 mol%, of all polymerized units constituting the third fluorine-containing polymer of the disclosure.

In the method 3, the polymer composition can be adjusted, for example, by reducing the fluorine-containing vinyl monomer unit. From this view point, the fluorine-containing vinyl monomer unit is contained in an amount of preferably not more than 60 mol%, more preferably not more than 50 mol%, still more preferably not more than 40 mol%, particularly preferably not more than 30 mol%, of all polymerized units constituting the third fluorine-containing polymer of the disclosure.

The polymer composition can be also adjusted by polymerization under the condition that allows presence of residual monomers as appropriate. The condition that allows presence of residual monomers as appropriate may be, for example, reduction of the time for an aging step in which a polymerization reaction is allowed to proceed at a predetermined temperature after addition of monomers (aging reaction). As the time for the aging step, preferred is 60 minutes or shorter, more preferred is 30 minutes or shorter, still more preferred is 15 minutes or shorter, and particularly preferred is 0 minutes, i.e., no aging reaction.

In the method 4, the number average molecular weight of the third fluorine-containing polymer of the disclosure is preferably 1000 or more, more preferably 5000 or more, still more preferably 7000 or more, even more preferably 9000 or more, particularly preferably 10000 or more in order to reduce the proportions of the $-CF_2H$ end, the - $CF_2CFHCF_3$ end, and the -CFClH end. The number average molecular weight is preferably 600000 or less, more preferably 100000 or less, still more preferably 40000 or less, particularly preferably 30000 or less, in terms of reactivity as an active ester or the like.

The number average molecular weight of the fluorine-containing polymer can be determined by gel permeation

chromatography (GPC).

The third fluorine-containing polymer of the disclosure contains a polymerized unit based on a vinyl ester monomer other than the fluorine-containing vinyl monomer (hereafter, referred to as a "vinyl ester monomer unit"). Containing the vinyl ester monomer unit, the third fluorine-containing polymer can generate an active ester to react with epoxy resins.

The vinyl ester monomer is the same as that of the first fluorine-containing polymer of the disclosure. In particular, preferred is a monomer represented by the formula (A). Particularly, preferred is at least one selected from the group consisting of vinyl benzoate, vinyl para-t-butylbenzoate, vinyl acetate, and vinyl pivalate, and more preferred is at least one selected from the group consisting of vinyl benzoate, vinyl para-t-butylbenzoate, and vinyl acetate.

In order to achieve excellent compatibility and reactivity with epoxy resins, the vinyl ester monomer unit is contained in an amount of preferably 10 mol% or more, more preferably 20 mol% or more, still more preferably 30 mol% or more, even more preferably 40 mol% or more, particularly preferably 50 mol% or more, of all polymerized units of the third fluorine-containing polymer of the disclosure. In order to achieve excellent heat resistance, the amount is preferably 80 mol% or less, more preferably 70 mol% or less, still more preferably 60 mol% or less.

According to a preferred embodiment, the third fluorine-containing polymer of the disclosure contains the polymerized unit based on a monomer represented by the formula (A) in an amount of 10 to 100 mol% and the polymerized unit based on a vinyl ester monomer different from the monomer represented by the formula (A) in an amount of 0 to 90 mol%, relative to 100 mol% in total of the vinyl ester monomer units. The polymerized unit based on a monomer represented by the formula (A) is contained in an amount of more preferably 20 to 90 mol%, still more preferably 30 to 80 mol%, even more preferably 35 to 75 mol%, particularly preferably 40 to 70 mol%, relative to 100 mol% in total of the vinyl ester monomer units. The polymerized unit based on a vinyl ester monomer different from the monomer represented by the formula (A) is contained in an amount of more preferably 10 to 80 mol%, still more preferably 20 to 70 mol%, even more preferably 25 to 65 mol%, particularly preferably 30 to 60 mol%, relative to 100 mol% in total of the vinyl ester monomer units.

In order to use the third fluorine-containing polymer of the disclosure in metal-clad laminated sheets, the third fluorine-containing polymer of the disclosure is desired to have excellent heat resistance. Accordingly, the vinyl ester monomer different from the monomer represented by the formula (A) is preferably a vinyl ester monomer that can increase the glass transition temperature by crosslinking. Examples thereof include vinyl cinnamate, vinyl β-styryl acrylate, vinyl β-furyl acrylate, and vinyl p-azidocinnamate.

The vinyl ester monomer may contain no hydroxy or carboxy group.

The third fluorine-containing polymer of the disclosure may further contain a polymerized unit based on a monomer different from the fluorine-containing vinyl monomer or the vinyl ester monomer (hereafter, referred to as a "different monomer") (hereafter, this polymerized unit is referred to as a "different monomer unit").

The different monomer is the same as that of the first fluorine-containing polymer of the disclosure, and examples thereof include alkyl vinyl ethers containing no hydroxy group, non-fluorinated olefins containing no halogen atom or no hydroxy group, amino group-containing monomers containing no NH group, hydrolyzable silyl group-containing monomers containing no OH group, epoxy group-containing monomers, oxetane group-containing monomers, heterocycle-containing monomers, and (meth)acrylic acid ester monomers. For these monomers, those exemplified for the first fluorine-containing polymer of the disclosure are all employable.

The (meth)acrylic acid ester is preferably an alicyclic ester because it can increase the polymer glass transition temperature. The (meth)acrylic acid ester is particularly preferably a monomer (2) represented by the following formula (2):

[Chem. 6]

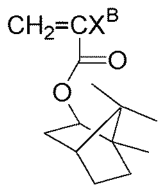

(2)

(wherein $X^B$ is H or $CH_3$), or phenyl (meth) acrylate. An aromatic ester of (meth)acrylic acid is preferred as it can serve as an active ester, and phenyl (meth)acrylate is preferred.

In the disclosure, the term "(meth)acrylic acid" means methacrylic acid or acrylic acid.

The different monomer preferably includes an epoxy group-containing monomer or an oxetane group-containing monomer in order to improve the curability. Examples of the epoxy group-containing monomer include allyl glycidyl

ether, 4-hydroxybutyl acrylate glycidyl ether, and 3,4-epoxycyclohexyl methyl methacrylate. Examples of the oxetane group-containing monomer include (3-ethyloxetan-3-yl)methyl acrylate. The amount of the epoxy group- or oxetane group-containing monomer is preferably 0.1 mol% or more, more preferably 0.5 mol% or more, still more preferably 1 mol% or more, of all polymerized units. The amount is preferably 15 mol% or less, more preferably 10 mol% or less, particularly preferably 5 mol% or less.

The different monomer that contains no hydroxy or carboxy group is preferably a heterocycle-containing monomer containing no hydroxy or carboxy group in order to improve the adherence. Examples of the heterocycle-containing monomer include: monomers containing a cyclic ether group such as furan, tetrahydrofurfuryl acrylate, and (2-methyl-2-ethyl-1,3-dioxolan-4-yl)methyl acrylate; monomers containing a lactone group such as 5-oxo-4-oxatricyclo[4.2.1.03.7]nonan-2-yl=acrylate; monomers containing an acid anhydride group such as itaconic anhydride, citraconic anhydride, and 5-norbornene-2,3-dicarboxylic acid anhydride; and monomers containing a pyrrolidone group such as N-vinyl-2-pyrrolidone. The amount of the heterocycle-containing monomer is preferably 0.1 mol% or more, more preferably 0.5 mol% or more, still more preferably 1 mol% or more, of all polymerized units. In terms of heat resistance, the amount is preferably 20 mol% or less, more preferably 10 mol% or less, particularly preferably 5 mol% or less.

The different monomer preferably includes the monomer (2) in terms of heat resistance. In the formula (2), $X^B$ is H or $CH_3$, preferably H. In order to further improve heat resistance, the polymerized unit based on the monomer (2) is contained in an amount of preferably 10 mol% or more of all polymerized units. The amount is more preferably 15 mol% or more, still more preferably 20 mol% or more. The monomer (2) unit is contained in an amount of preferably 90 mol% or less of all polymerized units. The amount is more preferably 80 mol% or less, still more preferably 70 mol% or less, even more preferably 60 mol% or less, particularly preferably 50 mol% or less.

The third fluorine-containing polymer of the disclosure contains not more than 1 mol% in total of a polymerized unit based on a monomer containing a hydroxy group (-OH group) and a polymerized unit based on a monomer containing a carboxy group (-COOH group), of all polymerized units. The total amount of the polymerized unit based on a monomer containing a hydroxy group (-OH group) and the polymerized unit based on a monomer containing a carboxy group (-COOH group) is preferably 0.5 mol% or less, more preferably 0.3 mol% or less, still more preferably 0.1 mol% or less, particularly preferably 0.0 mol%. When the total amount of the polymerized unit based on a monomer containing a hydroxy group (-OH group) and the polymerized unit based on a monomer containing a carboxy group (-COOH group) is within the above range, the dielectric constant and the dielectric loss tangent can be set lower.

The monomer containing a hydroxy group (-OH group) and the monomer containing a carboxy group are the same as those of the first fluorine-containing polymer of the disclosure.

The third fluorine-containing polymer of the disclosure has a molar ratio, fluorine-containing vinyl monomer unit/vinyl ester monomer unit, of preferably (10 to 90)/(10 to 90), more preferably (20 to 80)/(20 to 80), still more preferably (30 to 70)/(30 to 70).

In the third fluorine-containing polymer of the disclosure, the fluorine-containing vinyl monomer unit and the vinyl ester monomer unit are contained in a total amount of preferably 70 to 100 mol% of all polymerized units based on the fluorine-containing polymer. In order to achieve a low dielectric constant and a low dielectric loss tangent, the total amount is preferably 80 to 100 mol%, more preferably 90 to 100 mol%, still more preferably 95 to 100 mol%, particularly preferably 97 to 100 mol%.

In the case of the third fluorine-containing polymer of the disclosure, the dielectric loss tangent can be set lower by reducing the polymerized unit based on a monomer containing a hydroxy group (-OH group). From this view point, the third fluorine-containing polymer of the disclosure contains the polymerized unit based on a monomer containing a hydroxy group in an amount of preferably not more than 10 mol%, more preferably not more than 5 mol%, still more preferably not more than 1 mol%, of all polymerized units. The amount is particularly preferably 0 mol%, that is, no polymerized unit based on a monomer containing a hydroxy group is preferably contained.

Examples of the monomer containing a hydroxy group include those exemplified in the description of the first fluorine-containing polymer of the disclosure.

According to a preferred embodiment, the third fluorine-containing polymer of the disclosure contains 10 to 90 mol% of the TFE, HFP, or CTFE unit, 10 to 80 mol% of a unit of the monomer represented by the formula (A), 0 to 80 mol% of a unit of the vinyl ester monomer different from the monomer represented by the formula (A), and 0 to 10 mol% of the different monomer unit.

According to a more preferred embodiment, the third fluorine-containing polymer of the disclosure contains 20 to 80 mol% of the TFE, HFP, or CTFE unit, 10 to 70 mol% of the unit of the monomer represented by the formula (A), 0 to 60 mol% of the unit of the vinyl ester monomer different from the monomer represented by the formula (A), and 0 to 10 mol% of the different monomer unit. According to a still more preferred embodiment, the third fluorine-containing polymer of the disclosure contains 30 to 70 mol% of the TFE, HFP, or CTFE unit, 20 to 60 mol% of the unit of the monomer represented by the formula (A), 0 to 40 mol% of the unit of the vinyl ester monomer different from the monomer represented by the formula (A), and 0 to 10 mol% of the different monomer unit. According to a particularly preferred embodiment, the third fluorine-containing polymer of the disclosure contains 35 to 65 mol% of the TFE, HFP, or CTFE

unit, 25 to 55 mol% of the unit of the monomer represented by the formula (A), 0 to 35 mol% of the unit of the vinyl ester monomer different from the monomer represented by the formula (A), and 0 to 5 mol% of the different monomer unit.

According to a preferred embodiment, the third fluorine-containing polymer of the disclosure contains 10 to 90 mol% of the TFE, HFP, or CTFE unit, 10 to 80 mol% of the unit of the monomer represented by the formula (A), and 1 to 60 mol% of a unit of the monomer (2) represented by the formula (2).

According to a more preferred embodiment, the third fluorine-containing polymer of the disclosure contains 20 to 80 mol% of the TFE, HFP, or CTFE unit, 10 to 70 mol% of the unit of the monomer represented by the formula (A), and 5 to 50 mol% of the unit of the monomer (2) represented by the formula (2). According to a still more preferred embodiment, the third fluorine-containing polymer of the disclosure contains 30 to 70 mol% of the TFE, HFP, or CTFE unit, 20 to 60 mol% of the unit of the monomer represented by the formula (A), and 10 to 40 mol% of the unit of the monomer (2) represented by the formula (2). According to a particularly preferred embodiment, the third fluorine-containing polymer of the disclosure contains 35 to 65 mol% of the TFE, HFP, or CTFE unit, 25 to 55 mol% of the unit of the monomer represented by the formula (A), and 10 to 30 mol% of the unit of the monomer (2) represented by the formula (2).

The third fluorine-containing polymer of the disclosure is preferably a compound including a group obtained by esterifying a highly acidic OH group, specifically an OH group having a pKa of 25 or less (a value measured in a dimethyl sulfoxide solvent), with an aromatic or fatty acid (hereafter, this group is also referred to as an "active ester group (A)) (hereafter, this compound is also referred to as an "active ester compound (A)"). The second fluorine-containing polymer of the disclosure being the active ester compound (A) is more efficiently reactive with epoxy resins.

The second fluorine-containing polymer of the disclosure preferably contains a polymerized unit based on a monomer including the active ester group (A).

The second fluorine-containing polymer of the disclosure contains the polymerized unit based on a monomer including the active ester group (A) in an amount of preferably 10 to 70 mol%, more preferably 20 to 60 mol%, still more preferably 25 to 55 mol%, of all polymerized units.

In order to achieve a low dielectric constant and a low dielectric loss tangent, the third fluorine-containing polymer of the disclosure has a fluorine content of preferably 20% by mass or more. The fluorine content is more preferably 25% by mass or more, still more preferably 30% by mass or more, particularly preferably 35% by mass or more. The fluorine content of the fluorine-containing polymer can be determined by elemental analysis using an automatic sample combustion device.

The third fluorine-containing polymer of the disclosure has a vinyl ester monomer unit equivalent of preferably 90 to 5000 g/eg. The vinyl ester monomer unit equivalent is more preferably 90 to 1000 g/eg, still more preferably 90 to 700 g/eg. The vinyl ester monomer unit equivalent can be calculated from the composition of the polymer.

The third fluorine-containing polymer of the disclosure has a glass transition temperature of preferably 0°C or higher, more preferably 40°C or higher, still more preferably 50°C or higher, even more preferably 60°C or higher, furthermore preferably 65°C or higher, still furthermore preferably 70°C or higher, particularly preferably 100°C or higher. A higher glass transition temperature is preferred. Still, in terms of processability, the glass transition temperature is preferably 200°C or lower.

The third fluorine-containing polymer of the disclosure has a dielectric constant at 12 GHz of preferably 3.0 or lower, more preferably 2.8 or lower, still more preferably 2.6 or lower. A smaller dielectric constant is preferred. Still, in consideration of the balance with other properties, the dielectric constant may be 0.5 or higher, 1 or higher, or 2 or higher.

The third fluorine-containing polymer of the disclosure has a dielectric loss tangent at 12 GHz of preferably 0.013 or lower, more preferably 0.012 or lower, still more preferably 0.010 or lower, even more preferably 0.008 or lower, particularly preferably 0.005 or lower. A lower dielectric loss tangent is preferred. Still, in consideration of the balance with other properties, the dielectric loss tangent may be 0.0001 or higher, 0.001 or higher, 0.002 or higher, or 0.004 or higher.

The third fluorine-containing polymer of the disclosure can be produced by the same method as that for the first fluorine-containing polymer of the disclosure. In order to lower the dielectric loss tangent, the third fluorine-containing polymer of the disclosure is preferably produced under the conditions taking the above-described methods 1 to 4 into consideration.

The third composition for a metal-clad laminated sheet of the disclosure contains the third fluorine-containing polymer of the disclosure and a solvent.

Containing the fluorine-containing polymer having the above structure, the third composition for a metal-clad laminated sheet of the disclosure is excellent in compatibility with epoxy resins. The use of the third composition for a metal-clad laminated sheet of the disclosure in a resin layer of a metal-clad laminated sheet allows the resin layer to have a low dielectric constant and a low dielectric loss tangent. The disclosure provides the use of the composition for a metal-clad laminated sheet in metal-clad laminated sheets (resin layers of metal-clad laminated sheets).

The third composition for a metal-clad laminated sheet of the disclosure contains a solvent. The solvent is the same as that of the first composition for a metal-clad laminated sheet of the disclosure.

The third composition for a metal-clad laminated sheet of the disclosure may further contain a curing accelerator. The curing accelerator is the same as that of the first composition for a metal-clad laminated sheet of the disclosure. Each of these may be used alone or in combination of two or more.

The third composition for a metal-clad laminated sheet of the disclosure contains the fluorine-containing polymer in an amount of preferably 10% by mass or more, more preferably 25% by mass or more, still more preferably 40% by mass or more, relative to 100% by mass of the solid content. The amount may be 100% by mass or less, or 80% by mass or less.

The third composition for a metal-clad laminated sheet of the disclosure may be free from epoxy resins.

The third curable composition of the disclosure contains the third fluorine-containing polymer of the disclosure and an epoxy resin. Conventional fluorine-containing polymers having been proposed to be used in resin layers of metal-clad laminated sheets unfortunately do not have sufficient compatibility with epoxy resins.

The third curable composition of the disclosure containing the third fluorine-containing polymer of the disclosure is excellent in compatibility with epoxy resins, and therefore has a low dielectric constant and a low dielectric loss tangent. Moreover, the third curable composition of the disclosure has excellent properties including dispersibility, moisture resistance, heat resistance, flame retardancy, and adhesiveness.

The third curable composition of the disclosure containing the third fluorine-containing polymer of the disclosure can form resin layers having a low dielectric constant and a low dielectric loss tangent, and therefore is particularly suitable for forming resin layers of metal-clad laminated sheets.

The third curable composition of the disclosure is preferably a curable composition for a metal-clad laminated sheet. The disclosure provides the use of the curable composition in metal-clad laminated sheets (resin layers of metal-clad laminated sheets).

In the third curable composition of the disclosure, the epoxy resin is the same as that of the first curable composition of the disclosure, and all the embodiments having been described for the first curable composition are employable.

In the third curable composition of the disclosure, a ratio (value obtained by multiplying the mass and the vinyl ester monomer unit equivalent of the fluorine-containing polymer)/(value obtained by multiplying the mass and the epoxy equivalent of the epoxy resin ) is preferably 0.4 to 2.0. The ratio is more preferably 0.5 to 1.5, still more preferably 0.7 to 1.3, even more preferably 0.8 to 1.2, particularly preferably 0.9 to 1.1. When the ratio is within the above range, the fluorine-containing polymer and the epoxy resin can be efficiently cured.

The third curable composition of the disclosure contains the epoxy resin in an amount of preferably 1 part by mass or more, more preferably 50 parts by mass or more, still more preferably 80 parts by mass or more, relative to 100 parts by mass of the fluorine-containing polymer, in terms of the dielectric constant, dielectric loss tangent, dispersibility, moisture resistance, heat resistance, flame retardancy, and adhesiveness. The amount of the epoxy resin is preferably 1000 parts by mass or less, more preferably 500 parts by mass or less, still more preferably 300 parts by mass or less, particularly preferably 200 parts by mass or less, relative to 100 parts by mass of the fluorine-containing polymer.

The third curable composition of the disclosure may contain, in addition to the epoxy resin, additives such as a flame retardant, an inorganic filler, a silane coupling agent, a mold release agent, a pigment, and an emulsifier.

The third curable composition of the disclosure preferably further contains a curing accelerator. The curing accelerator is the same as that of the first curable composition of the disclosure. One curing accelerator may be used alone, or two or more curing accelerators may be used in combination.

The third curable composition of the disclosure may contain various additives in accordance with demanded properties. Examples of the additives include pigment dispersants, defoamers, leveling agents, UV absorbents, light stabilizers, thickeners, adhesion improvers, and matting agents.

In the case where the third curable composition of the disclosure contains the various additives mentioned above, the third curable composition of the disclosure contains the third fluorine-containing polymer of the disclosure and the epoxy resin in a total amount of preferably 5% by mass or more, more preferably 50% by mass or more, still more preferably 70% by mass or more, even more preferably 80% by mass or more, relative to 100% by mass of the solid content.

The third curable composition of the disclosure preferably contains an organic solvent. The organic solvent is the same as that of the first curable composition of the disclosure. The third curable composition of the disclosure has a solid content concentration of 10 to 80% by mass in total of the third fluorine-containing polymer of the disclosure and the epoxy resin. When the solid content concentration is within this range, the curable composition has an appropriate viscosity to be applied to form a uniform coating.

The third curable composition of the disclosure may be prepared by any method. An exemplary method includes mixing a solution or dispersion of a fluorine-containing polymer with a solution or dispersion of an epoxy resin.

The third curable composition of the disclosure can be used not only in a resin layer of a metal-clad laminated sheet but also as a resin for a powder coating composition or a resin for an optical application.

The third metal-clad laminated sheet of the disclosure is a metal-clad laminated sheet including: a metal foil; and a resin layer provided on the metal foil, the resin layer being formed of the third curable composition of the disclosure. The resin layer can be formed by curing the third curable composition of the disclosure.

The third metal-clad laminated sheet of the disclosure is a metal-clad laminated sheet including: a metal foil; and a resin layer provided on the metal foil. The resin layer contains a fluorine-containing polymer and an epoxy resin. The fluorine-containing polymer contains a polymerized unit based on a fluorine-containing vinyl monomer and a polymerized unit based on a vinyl ester monomer. The polymerized unit based on a fluorine-containing vinyl monomer and the polymerized unit based on a vinyl ester monomer are contained in a total amount of 70 to 100 mol% of all polymerized units. The fluorine-containing vinyl monomer includes at least one selected from the group consisting of tetrafluoroethylene, hexafluoropropylene, and chlorotrifluoroethylene. In the case of the fluorine-containing vinyl monomer including tetrafluoroethylene, the integral value of $CF_2H$ at a $-CF_2H$ end is not more than 2% of the integral value of entire $CF_2$ in 19F-NMR. In the case of the fluorine-containing vinyl monomer including hexafluoropropylene, the integral value of CFH at a $-CF_2CFHCF_3$ end is not more than 2% of the integral value of entire CF in 19F-NMR. In the case of the fluorine-containing vinyl monomer including chlorotrifluoroethylene, the total of the integral value of $CF_2H$ at a $-CF_2H$ end and the integral value of CFClH at a - CFClH end is not more than 2% of the total of the integral value of entire $CF_2$ and the integral value of entire CFCl in 19F-NMR.

The third metal-clad laminated sheet of the disclosure includes a metal foil and a resin layer. The resin layer has excellent insulation properties to serve as a substrate of the metal-clad laminated sheet.

The metal foil is the same as that of the first metal-clad laminated sheet of the disclosure.

The resin layer contains the epoxy resin in an amount of preferably 1 part by mass or more, more preferably 10 parts by mass or more, still more preferably 50 parts by mass or more, particularly preferably 80 parts by mass or more, relative to 100 parts by mass of the third fluorine-containing polymer of the disclosure. The amount of the epoxy resin is preferably 1000 parts by mass or less, more preferably 500 parts by mass or less, still more preferably 300 parts by mass or less, particularly preferably 200 parts by mass or less, relative to 100 parts by mass of the fluorine-containing polymer. Too much fluorine-containing polymer may lower the adhesiveness, while too much epoxy resin may lower the insulation properties, moisture resistance, heat resistance, or flame retardancy.

The resin layer is formed of the third curable composition of the disclosure, and the fluorine-containing polymer and the epoxy resin are crosslinked therein. Accordingly, the above ratio is a ratio of the amount of a resin portion derived from the epoxy resin relative to 100 parts by mass of a resin portion derived from the fluorine-containing polymer.

The third metal-clad laminated sheet of the disclosure may include different layer(s) in addition to the metal foil and the resin layer. One metal foil and one resin layer each may be used alone, or two or more different metal foils and two or more different resin layers each may be used in combination.

The third metal-clad laminated sheet of the disclosure may further include a second resin layer on the resin layer (hereafter, referred to as a "first resin layer"). Specifically, the third metal-clad laminated sheet of the disclosure may include a metal foil, a first resin layer, and a second resin layer in the stated order. The first resin layer may serve not only as a substrate but also as an adhesive layer bonding the metal foil and the second resin layer.

In the third metal-clad laminated sheet of the disclosure, the first resin layer may be also provided on a face (opposite face) of the metal foil different from the face where the first resin layer is already provided. Specifically, the third metal-clad laminated sheet of the disclosure may include a first resin layer, a metal foil, and a first resin layer in the stated order or include a first resin layer, a metal foil, a first resin layer, and a second resin layer in the stated order.

The second resin layer may be formed of a resin conventionally used in printed substrates. The second resin layer is preferably formed of at least one resin selected from the group consisting of polyethylene terephthalate and polyimide. In terms of heat resistance, preferred is polyimide.

The first resin layer used may be a film having a thickness of 1 to 150 $\mu$m. In the case where the metal foil and a second adhesive layer are bonded via the first resin layer, the first resin layer may have a dry thickness of 1 to 100 $\mu$m.

The second resin layer used may be a resin film having a thickness of 1 to 150 $\mu$m.

The third metal-clad laminated sheet of the disclosure can be produced by the same method as that for the first metal-clad laminated sheet of the disclosure, except that the fluorine-containing polymer used is the third fluorine-containing polymer of the disclosure.

The disclosure also provides a printed substrate including a patterned circuit formed by etching the metal foil of the third metal-clad laminated sheet of the disclosure (third printed substrate of the disclosure). The third printed substrate of the disclosure may be a flexible substrate or a rigid substrate. Preferred is a flexible substrate.

The third printed substrate of the disclosure may include a coverlay film on the metal-clad laminated sheet, and the coverlay film may be bonded to the metal-clad laminated sheet via the resin layer.

The etching may be performed by any conventionally known method. The patterned circuit is not limited. The printed substrate may have any patterned circuit.

The application of the third printed substrate of the disclosure is not limited. For example, since including a resin layer having a low dielectric constant and a low dielectric loss tangent, the third printed substrate of the disclosure

can be used for applications using higher frequency bands such as 4G (37.5 Mbps) or 5G (several Gbps to 20 Gbps).

The epoxy resin of the disclosure contains: at least one of a polymerized unit based on tetrafluoroethylene or a polymerized unit based on hexafluoropropylene; and a polymerized unit based on allyl glycidyl ether. The polymerized unit based on tetrafluoroethylene, the polymerized unit based on hexafluoropropylene, and the polymerized unit based on allyl glycidyl ether are contained in a total amount of 98 to 100 mol% of all polymerized units. In the case of the epoxy resin containing the polymerized unit based on tetrafluoroethylene, an integral value of $CF_2H$ at a $-CF_2H$ end is not more than 4% of an integral value of entire $CF_2$ in 19F-NMR. In the case of the epoxy resin containing the polymerized unit based on hexafluoropropylene, an integral value of CFH at a $-CF_2CFHCF_3$ end is not more than 4% of an integral value of entire CF in 19F-NMR. The epoxy resin of the disclosure having the above structure can increase the gel fraction after acetone immersion.

The epoxy resin of the disclosure contains at least one of a polymerized unit based on tetrafluoroethylene (TFE) (hereafter, referred to as a "TFE unit") or a polymerized unit based on hexafluoropropylene (HFP) (hereafter, referred to as a "HFP unit"). Preferred is a TFE unit as it has excellent copolymerizability.

The TFE unit and the HFP unit are contained in a total amount of preferably 10 mol% or more, more preferably 20 mol% or more, still more preferably 30 mol% or more, particularly preferably 40 mol% or more, of all polymerized units based on the epoxy resin of the disclosure. The total amount is preferably 80 mol% or less, more preferably 70 mol% or less, still more preferably 60 mol% or less, particularly preferably 50 mol% or less.

The epoxy resin of the disclosure contains a polymerized unit based on allyl glycidyl ether (AGE) (hereafter, referred to as an "AGE unit").

The AGE unit is contained in an amount of preferably 10 mol% or more, more preferably 20 mol% or more, still more preferably 30 mol% or more, even more preferably 40 mol% or more, particularly preferably 50 mol% or more, of all polymerized units based on the epoxy resin of the disclosure. The amount is preferably 80 mol% or less, more preferably 70 mol% or less, still more preferably 60 mol% or less.

In the epoxy resin of the disclosure, the total amount of the TFE unit, HFP unit, and AGE unit is 98 to 100 mol% of all polymerized units based on the epoxy resin. In terms of gel fraction after acetone immersion, the total amount is preferably 99 to 100 mol%, more preferably 100 mol%. Namely, the epoxy resin of the disclosure preferably substantially consists of the TFE unit, the HFP unit, and the AGE unit.

In the case where the epoxy resin of the disclosure contains the TFE unit, the integral value of $CF_2H$ at a $-CF_2H$ end is preferably not more than 4% of the integral value of entire $CF_2$ in 19F-NMR. The gel fraction after acetone immersion can be increased by reducing the proportion of the $-CF_2H$ end. Since the gel fraction after acetone immersion can be further increased, the integral value of $CF_2H$ at the $-CF_2H$ end is preferably not more than 3% of the integral value of entire $CF_2$ in 19F-NMR.

In the case where the epoxy resin of the disclosure contains the HFP unit, the integral value of CFH at a $-CF_2CFHCF_3$ end is preferably not more than 4% of the integral value of entire CF in 19F-NMR. The gel fraction after acetone immersion can be increased by reducing the proportion of the $-CF_2CFHCF_3$ end. Since the gel fraction after acetone immersion can be further increased, the integral value of CFH at the $-CF_2CFHCF_3$ end is preferably not more than 3% of the integral value of entire CF in 19F-NMR.

The proportions of the $-CF_2H$ end and the $-CF_2CFHCF_3$ end can be reduced, for example, by the methods 1 to 4 described for the third fluorine-containing polymer of the disclosure.

The epoxy resin of the disclosure has a number average molecular weight of preferably 500 to 10000. When the number average molecular weight is within this range, the epoxy resin can efficiently react with a fluorine-containing polymer containing an active ester, leading to firm bonding between a resin layer and a metal foil of a metal-clad laminated sheet. The number average molecular weight is more preferably 1000 or more. The number average molecular weight is more preferably 8000 or less, still more preferably 6000 or less, particularly preferably 4000 or less.

The number average molecular weight of the epoxy resin can be determined by gel permeation chromatography (GPC).

The epoxy resin of the disclosure is preferably liquid at 25°C. Such an epoxy resin has favorable compatibility with other polymers (resins).

Such a property can be achieved, for example, by reducing the molecular weight or lowering the Tg of the epoxy resin.

The epoxy resin of the disclosure preferably has a fluorine content of 20% by mass or more. The fluorine content is more preferably 25% by mass or more. The fluorine content of the epoxy resin can be determined by elemental analysis using an automatic sample combustion device.

The epoxy resin of the disclosure has an epoxy equivalent of preferably 50 to 5000 g/eg. The epoxy equivalent is more preferably 50 to 1000 g/eg, still more preferably 50 to 500 g/eg.

The epoxy equivalent can be determined in conformity with JIS 7236.

The epoxy resin of the disclosure has a glass transition temperature of preferably 20°C or lower, more preferably 10°C or lower, still more preferably 0°C or lower. The glass transition temperature is preferably - 100°C or higher, more

preferably -60°C or higher, still more preferably -40°C or higher.

The epoxy resin of the disclosure can be produced by the same method as that for the first fluorine-containing polymer of the disclosure.

The fourth curable composition of the disclosure contains the epoxy resin of the disclosure and the third fluorine-containing polymer of the disclosure.

Containing the third fluorine-containing polymer of the disclosure, the fourth curable composition of the disclosure has the same advantages as those of the third curable composition of the disclosure. Moreover, containing the epoxy resin of the disclosure, the fourth curable composition of the disclosure has better properties including adhesiveness.

The fourth curable composition of the disclosure is preferably a curable composition for a metal-clad laminated sheet. The disclosure provides the use of the curable composition in metal-clad laminated sheets (resin layers of metal-clad laminated sheets).

The epoxy resin of the disclosure may be combined with the first fluorine-containing polymer of the disclosure or the second fluorine-containing polymer of the disclosure to provide a curable composition.

In the fourth curable composition of the disclosure, a ratio (value obtained by multiplying the mass and the vinyl ester monomer unit equivalent of the fluorine-containing polymer)/(value obtained by multiplying the mass and the epoxy equivalent of the epoxy resin) is preferably 0.4 to 2.0. The ratio is more preferably 0.5 to 1.5, still more preferably 0.7 to 1.3, even more preferably 0.8 to 1.2, particularly preferably 0.9 to 1.1. When the ratio is within the above range, the fluorine-containing polymer and the epoxy resin can be efficiently cured.

The fourth curable composition of the disclosure contains the epoxy resin in an amount of preferably 1 part by mass or more, more preferably 50 parts by mass or more, still more preferably 80 parts by mass or more, relative to 100 parts by mass of the fluorine-containing polymer, in terms of the dielectric constant, dielectric loss tangent, dispersibility, moisture resistance, heat resistance, flame retardancy, and adhesiveness. The amount of the epoxy resin is preferably 1000 parts by mass or less, more preferably 500 parts by mass or less, still more preferably 300 parts by mass or less, particularly preferably 200 parts by mass or less, relative to 100 parts by mass of the fluorine-containing polymer.

The fourth curable composition of the disclosure may contain, in addition to the fluorine-containing polymer and the epoxy resin, additives such as a flame retardant, an inorganic filler, a silane coupling agent, a mold release agent, a pigment, and an emulsifier.

The fourth curable composition of the disclosure preferably further contains a curing accelerator. The curing accelerator is the same as that of the first curable composition of the disclosure. One curing accelerator may be used alone, or two or more curing accelerators may be used in combination.

The fourth curable composition of the disclosure may contain various additives in accordance with demanded properties. Examples of the additives include pigment dispersants, defoamers, leveling agents, UV absorbents, light stabilizers, thickeners, adhesion improvers, and matting agents.

In the case where the fourth curable composition of the disclosure contains the various additives mentioned above, the third curable composition of the disclosure contains the third fluorine-containing polymer of the disclosure and the epoxy resin of the disclosure in a total amount of preferably 5% by mass or more, more preferably 50% by mass or more, still more preferably 70% by mass or more, even more preferably 80% by mass or more, relative to 100% by mass of the solid content.

The fourth curable composition of the disclosure preferably contains an organic solvent. The organic solvent is the same as that of the first curable composition of the disclosure. The fourth curable composition of the disclosure has a solid content concentration of 10 to 80% by mass in total of the third fluorine-containing polymer of the disclosure and the epoxy resin of the disclosure. When the solid content concentration is within this range, the curable composition has an appropriate viscosity to be applied to form a uniform coating.

The fourth curable composition of the disclosure may be prepared by any method. An exemplary method includes mixing a solution or dispersion of a fluorine-containing polymer with a solution or dispersion of an epoxy resin.

The fourth curable composition of the disclosure can be used not only in a resin layer of a metal-clad laminated sheet but also as a resin for a powder coating composition or a resin for an optical application.

The fourth metal-clad laminated sheet of the disclosure is a metal-clad laminated sheet including: a metal foil; and a resin layer provided on the metal foil, the resin layer being formed of the fourth curable composition of the disclosure. The resin layer can be formed by curing the fourth curable composition of the disclosure.

The fourth metal-clad laminated sheet of the disclosure is a metal-clad laminated sheet including: a metal foil; and a resin layer provided on the metal foil. The resin layer contains a fluorine-containing polymer and an epoxy resin. The fluorine-containing polymer contains a polymerized unit based on a fluorine-containing vinyl monomer and a polymerized unit based on a vinyl ester monomer. The polymerized unit based on a fluorine-containing vinyl monomer and the polymerized unit based on a vinyl ester monomer are contained in a total amount of 70 to 100 mol% of all polymerized units. The fluorine-containing vinyl monomer includes at least one selected from the group consisting of tetrafluoroethylene, hexafluoropropylene, and chlorotrifluoroethylene. In the case of the fluorine-containing vinyl monomer including tetrafluoroethylene, the integral value of $CF_2H$ at a $-CF_2H$ end is not more than 2% of the integral value of entire $CF_2$ in 19F-NMR. In the case of the fluorine-containing vinyl monomer including hexafluoropropylene, the integral value of CFH at a $-CF_2CFHCF_3$ end is not more than 2% of the integral value of entire CF in 19F-NMR. In the case of the fluorine-containing vinyl monomer including chlorotrifluoroethylene, the total of the integral value of $CF_2H$ at a $-CF_2H$ end and the integral value of CFClH at a - CFClH end is not more than 2% of the total of the integral value of entire $CF_2$ and the integral value of entire CFCl in 19F-NMR. The epoxy resin consists of at least one of a polymerized unit based on tetrafluoroethylene or a polymerized unit based on hexafluoropropylene and a polymerized unit based on allyl glycidyl ether, and has a number average molecular weight of 500 to 10000. The epoxy resin is liquid at 25°C. In the case of the epoxy resin containing the polymerized unit based on tetrafluoroethylene, the integral value of $CF_2H$ at a $-CF_2H$ end is not more than 4% of the integral value of entire $CF_2$ in 19F-NMR. In the case of the epoxy resin containing the polymerized unit based on hexafluoropropylene, the integral value of CFH at a $-CF_2CFHCF_3$ end is not more than 4% of the integral value of entire CF in 19F-NMR.

The fourth metal-clad laminated sheet of the disclosure includes a metal foil and a resin layer. The resin layer has excellent insulation properties to serve as a substrate of the metal-clad laminated sheet.

The metal foil is the same as that of the first metal-clad laminated sheet of the disclosure.

The resin layer contains the epoxy resin in an amount of preferably 1 part by mass or more, more preferably 10 parts by mass or more, still more preferably 50 parts by mass or more, particularly preferably 80 parts by mass or more, relative to 100 parts by mass of the fluorine-containing polymer. The amount of the epoxy resin is preferably 1000 parts by mass or less, more preferably 500 parts by mass or less, still more preferably 300 parts by mass or less, particularly preferably 200 parts by mass or less, relative to 100 parts by mass of the fluorine-containing polymer. Too much fluorine-containing polymer may lower the adhesiveness, while too much epoxy resin may lower the insulation properties, moisture resistance, heat resistance, or flame retardancy.

The resin layer is formed of the fourth curable composition of the disclosure, and the fluorine-containing polymer and the epoxy resin are crosslinked therein. Accordingly, the above ratio is a ratio of the amount of a resin portion derived from the epoxy resin relative to 100 parts by mass of a resin portion derived from the fluorine-containing polymer.

The third metal-clad laminated sheet of the disclosure may include different layer(s) in addition to the metal foil and the resin layer. One metal foil and one resin layer each may be used alone, or two or more different metal foils and two or more different resin layers may be used in combination.

The fourth metal-clad laminated sheet of the disclosure may further include a second resin layer on the resin layer (hereafter, referred to as a "first resin layer"). Specifically, the fourth metal-clad laminated sheet of the disclosure may include a metal foil, a first resin layer, and a second resin layer in the stated order. The first resin layer may serve not only as a substrate but also as an adhesive layer bonding the metal foil and the second resin layer.

In the fourth metal-clad laminated sheet of the disclosure, the first resin layer may be also provided on a face (opposite face) of the metal foil different from the face where the first resin layer is already provided. Specifically, the fourth metal-clad laminated sheet of the disclosure may include a first resin layer, a metal foil, and a first resin layer in the stated order or include a first resin layer, a metal foil, a first resin layer, and a second resin layer in the stated order.

The second resin layer may be formed of a resin conventionally used in printed substrates. The second resin layer is preferably formed of at least one resin selected from the group consisting of polyethylene terephthalate and polyimide. In terms of heat resistance, preferred is polyimide.

The first resin layer used may be a film having a thickness of 1 to 150 μm. In the case where the metal foil and a second adhesive layer are bonded via the first resin layer, the first resin layer may have a dry thickness of 1 to 100 μm.

The second resin layer used may be a resin film having a thickness of 1 to 150 μm.

The fourth metal-clad laminated sheet of the disclosure can be produced by the same method as that for the first metal-clad laminated sheet of the disclosure, except that the fluorine-containing polymer used is the third fluorine-containing polymer of the disclosure and the epoxy resin used is the epoxy resin of the disclosure.

The disclosure also provides a printed substrate including a patterned circuit formed by etching the metal foil of the fourth metal-clad laminated sheet of the disclosure (fourth printed substrate of the disclosure). The fourth printed substrate of the disclosure may be a flexible substrate or a rigid substrate. Preferred is a flexible substrate.

The fourth printed substrate of the disclosure may include a coverlay film on the metal-clad laminated sheet, and the coverlay film may be bonded to the metal-clad laminated sheet via the resin layer.

The etching may be performed by any conventionally known method. The patterned circuit is not limited. The printed substrate may have any patterned circuit.

The application of the fourth printed substrate of the disclosure is not limited. For example, since including a resin layer having a low dielectric constant and a low dielectric loss tangent, the fourth printed substrate of the disclosure can be used for applications using higher frequency bands such as 4G (37.5 Mbps) or 5G (several Gbps to 20 Gbps).

EXAMPLES

The disclosure is specifically described in the following with reference to, but not limited to, examples.
Hereinbelow, the present invention is more specifically described with reference to examples.
Physical properties mentioned in the description are measured by the following methods.

(1) NMR analysis:

Measurement device: NMR measurement device, available from VARIAN
1H-NMR measurement condition: 400 MHz (tetramethylsilane = 0 ppm)

(2) Elemental analysis (measurement of fluorine content (% by mass))

Measurement device: automatic sample combustion device (AQF-100 available from Mitsubishi Chemical Corporation) including an ion chromatography system (ICS-1500 available from DIONEX)
Test sample: 3 mg

(3) Molecular weight

Measurement device: Shodex GPC-104 available from Showa Denko K.K.
Measurement condition: Tetrahydrofuran was used as an eluent, and polystyrene with a known molecular weight was used as a standard sample for molecular weight determination.

(4) Glass transition temperature
The glass transition temperature and the crystalline melting point were determined in accordance with ASTM E1356-98 from heat absorption in the second run by the midpoint method, using a differential scanning calorimeter available from METLER TOLEDO.

Measurement conditions
Rate of temperature rise: 20°C/min
Amount of sample: 10 mg
Heat cycle: -50°C to 150°C, heating-cooling-heating

(5) Infrared spectrum
Measurement device: Perkin-Elmer model 1760X FT-IR spectrometer (available from Perkin-Elmer)

A sample in a powdery or film form was scanned 40 times to obtain an infrared spectrum.

Example 1

A 3000-ml stainless-steel autoclave was charged with 1050 g of acetone and 130 g of vinyl benzoate (VBz), and purged with nitrogen under reduced pressure. To the autoclave was added 130 g of tetrafluoroethylene (TFE). The contents were heated under stirring to an appropriate temperature, and 8 g of a peroxide-type polymerization initiator was added thereto to initiate polymerization. The reaction was stopped when the pressure inside the reactor was reduced from 1.0 MPaG to 0.4 MPaG. Thus, a solution containing a polymer was obtained. The resulting solution was concentrated and dried to obtain a fluorine-containing polymer.
According to NMR analysis performed on the resulting fluorine-containing polymer, the polymer was composed of 50 mol% of tetrafluoroethylene and 50 mol% of vinyl benzoate. According to molecular weight analysis, the polymer had a number average molecular weight (Mn) of 11000. The polymer had a glass transition temperature (Tg) of 66°C. According to elemental analysis thereof, the polymer had a fluorine content of 30.3% by mass.
The vinyl ester unit equivalent calculated from the composition was 248 g/eq.

Comparative Example 1

A 6000-ml stainless-steel autoclave was charged with 2500 g of butyl acetate, 584 g of vinyl neononanoate (NNVE), 77 g of vinyl benzoate (VBz), 527 g of 4-hydroxybutyl vinyl ether (HBVE), and 7 g of crotonic acid (CA), and purged with nitrogen under reduced pressure. To the autoclave was added 658 g of tetrafluoroethylene (TFE). The contents were heated under stirring to an appropriate temperature, and 30 g of a peroxide-type polymerization initiator

was added thereto to initiate polymerization. The reaction was stopped when the pressure inside the reactor was reduced from 1.0 MPaG to 0.4 MPaG. Thus, a solution containing a polymer was obtained. The resulting solution was concentrated and dried to obtain a fluorine-containing polymer.

According to NMR analysis performed on the resulting fluorine-containing polymer, the polymer was composed of 45.0 mol% of tetrafluoroethylene, 33.3 mol% of vinyl neononanoate, 5.5 mol% of vinyl benzoate, 15.3 mol% of 4-hydroxybutyl vinyl ether, and 0.9 mol% of crotonic acid. According to molecular weight analysis, the polymer had a number average molecular weight (Mn) of 16000. The polymer had a glass transition temperature (Tg) of 30°C. According to elemental analysis thereof, the polymer had a fluorine content of 27.0% by mass.

The fluorine-containing polymer obtained in Example 1 was immersed in acetone and dried to obtain a cured product. In analysis of an infrared spectrum of the cured product, absorptions typical of a fluorine-containing polymer (1728 $cm^{-1}$, 1108 $cm^{-1}$, 710 $cm^{-1}$) and absorptions typical of the epoxy resin used (2947 $cm^{-1}$, 1602 $cm^{-1}$, 1491 $cm^{-1}$, 752 $cm^{-1}$) were both observed, which revealed that the fluorine-containing polymer served as an active ester to react with the epoxy resin.

Example 2

A 3000-ml stainless-steel autoclave was purged with nitrogen under reduced pressure, and then charged with 900 g of acetone and 130 g of tetrafluoroethylene (TFE). The contents were heated under stirring to 70.0°C, and 8 g of a peroxide-type polymerization initiator was added thereto. At the same time, a mixed solution containing 142 g of vinyl benzoate (VBz) and 71 g of acetone was fed thereinto at a rate of 3 ml/min. Thus, polymerization was initiated. The reaction was stopped when the pressure inside the reactor was reduced from 1.0 MPaG to 0.4 MPaG. Thus, a solution containing a polymer was obtained. The resulting solution was concentrated and dried to obtain a fluorine-containing polymer.

According to NMR analysis performed on the resulting fluorine-containing polymer, the polymer was composed of 54 mol% of TFE and 46 mol% of vinyl benzoate. According to molecular weight analysis, the polymer had a number average molecular weight (Mn) of 9000. The polymer had a glass transition temperature (Tg) of 54°C. According to elemental analysis thereof, the polymer had a fluorine content of 33.3% by mass. The vinyl ester unit equivalent calculated from the composition was 263 g/eq.

Example 3

The reaction was carried out as in Example 1, except that the amount of vinyl benzoate was changed to 87 g and 60 g of isobornyl acrylate was also added. Thus, a fluorine-containing polymer was obtained.

According to NMR analysis performed on the resulting fluorine-containing polymer, the polymer was composed of 47 mol% of tetrafluoroethylene, 34 mol% of vinyl benzoate (VBz), and 19 mol% of isobornyl acrylate (IBAC). According to molecular weight analysis thereof, the polymer had a number average molecular weight (Mn) of 8000. The polymer had a glass transition temperature (Tg) of 61°C. According to elemental analysis, the polymer had a fluorine content of 26.3% by mass. The vinyl ester unit equivalent calculated from the composition was 402 g/eq.

Compatibility was evaluated by the following method.

The fluorine-containing polymer obtained in each of the examples and comparative example was dissolved in methyl ethyl ketone to prepare a solution having a solid content of 50% by mass. An epoxy resin (epoxy equivalent: 259 g/eq) was similarly prepared in the form of a solution having a solid content of 80% by mass.

Next, these two solutions were mixed in a manner that the vinyl ester unit equivalent was set equal to the epoxy equivalent. The appearance of the solution mixture was visually observed to evaluate compatibility. The compatibility evaluation was performed based on the following criteria.

State of solution mixture
Clear: Good (good compatibility)
Not clear: Poor (poor compatibility)

Table 1 shows the results.

The reactivity with epoxy resins was evaluated by the following method.

To the above solution mixture was added 4-dimethylaminopyridine in an amount of 0.5% by mass relative to the solid content of the solution, followed by well mixing. Thus, a curable composition was produced.

A 10-g portion of the curable composition was dried in a fan dryer set to 50°C for three hours, and then reacted in a fan dryer set to 175°C for 12 hours. After the reaction, the cured product was cooled.

Next, the gel fraction was measured as an index of the reaction degree of the cured product.

A portion of the cured product was wrapped in a preliminarily weighed 400-mesh metallic wire cloth. A 50-ml

sample tube was charged with 25 ml of acetone and the cured product wrapped in the wire cloth. The cured product was immersed in acetone for 12 hours. Then, the wire cloth was taken out and weighed after drying. The weight of the dried cured product after acetone immersion was calculated.

The gel fraction was calculated using the expression: weight of dried cured product after acetone immersion/weight of cured product before acetone immersion × 100. Table 1 shows the results.

[Table 1]

| Evaluation item | | Example 1 | Example 2 | Example 3 | Comparative Example 1 |
|---|---|---|---|---|---|
| Evaluation on reactivity with epoxy resin | State of solution mixture | Clear | Clear | C lear | Not clear |
| | Compatbility | Good | Good | Good | Poor |
| | Gel fraction after acetone immersion | 50% | 54% | 70% | 54% |

Evaluation results on compatibility and reactivity with epoxy resins of the resins of Example 2 and Example 3 are mentioned above.

The arrangement (chain) of monomers in the polymer was determined by NMR analysis. In the case of vinyl benzoate, a chain of TVT in which T denotes tetrafluoroethylene and V denotes a vinyl ester gives a peak at around 6.1 ppm. Similarly, a TVVT chain gives a peak at around 5.9 ppm and a TVVVT chain gives a peak at around 5.6 ppm. Based on these results, the proportion of each chain can be calculated from its NMR peak area. Table 2 shows the calculation results.

[Table 2]

| Sequence | Example 1 | Example 2 | Example 3 |
|---|---|---|---|
| TVT | 56% | 66% | 50% |
| TVVT | 22% | 17% | 16% |
| TVVVT | 22% | 17% | 34% |

Example 1 and Example 2 show that, when more TVT chains in which V is vinyl benzoate are present in the polymer, the reactivity with epoxy resins is improved to increase the gel fraction.

Example 1 and Example 2 show that, when the molecular weight of the polymer is smaller, the reactivity with epoxy resins is improved to increase the gel fraction.

Example 1 and Example 3 show that the use of isobornyl acrylate as a third component improves the reactivity with epoxy resins to increase the gel fraction.

Synthesis Example 1

A 3-L stainless-steel autoclave was charged with 1000 g of acetone as a solvent. After the autoclave was purged with nitrogen, the autoclave was heated to 70°C. Into the tank was put tetrafluoroethylene under stirring until the pressure inside the tank reached 0.79 MPa.

Next, 4.2 g of PERBUTYL PV (product name, available from NOF Corporation) was put as a polymerization initiator thereinto. At the same time, supply of vinyl benzoate (VBz) was started. The vinyl benzoate was added in a total amount of 150 g at a rate of 1.5 ml/min. Tetrafluoroethylene was also supplied during the reaction continuously in a manner that the pressure inside the tank was set to 0.775 to 0.7795 MPa.

After one hour from the start of the reaction, 4.2 g of PERBUTYL PV was further added. After the supply of vinyl benzoate was stopped, the supply of tetrafluoroethylene was stopped. The temperature of the tank was set to 75°C, and an aging reaction was continued for one hour.

Then, the temperature and pressure inside the tank were brought back to normal temperature and normal pressure, and the polymerization was stopped. Thus, a solution (solid content concentration of 17% by mass) of a vinyl benzoate/tetrafluoroethylene copolymer in acetone was obtained.

After completion of the reaction, the obtained solution was concentrated and dried to obtain a fluorine-containing polymer.

According to NMR analysis, the resulting fluorine-containing polymer was composed of 50 mol% of tetrafluoroethylene and 50 mol% of vinyl benzoate. According to molecular weight analysis, the polymer had a number average molecular weight (Mn) of 12000. The polymer had a glass transition temperature (Tg) of 66°C. As a result of elemental analysis, the polymer had a fluorine content of 30.3% by mass.

The vinyl ester unit equivalent calculated from the composition was 248 g/eq.

Synthesis Example 2

A 3-L stainless-steel autoclave was charged with 900 g of acetone as a solvent. After the autoclave was purged with nitrogen, the tank was heated to 70°C. Into the tank was put tetrafluoroethylene under stirring until the pressure inside the tank reached 0.79 MPa.

Next, 4.2 g of PERBUTYL PV (product name, available from NOF Corporation) was put as a polymerization initiator thereinto. At the same time, supply of a mixed solution containing 140 g of vinyl benzoate and 70 g of acetone was started. The mixed solution of vinyl benzoate and acetone was added in a total amount of 200 g at a rate of 1.5 ml/min. Tetrafluoroethylene was also supplied during the reaction continuously in a manner that the pressure inside the tank was set to 0.775 to 0.7795 MPa.

After one hour from the start of the reaction, 4.2 g of PERBUTYL PV was further added. After the supply of the mixed solution of vinyl benzoate and acetone was stopped, the supply of tetrafluoroethylene was stopped. The temperature of the tank was set to 75°C, and an aging reaction was continued for two hours.

Then, the temperature and pressure inside the tank were brought back to normal temperature and normal pressure, and the polymerization was stopped. Thus, a solution (solid content concentration of 21% by mass) of a vinyl benzoate/tetrafluoroethylene copolymer in acetone was obtained.

After completion of the reaction, the obtained solution was concentrated and dried to obtain a fluorine-containing polymer.

According to NMR analysis, the resulting fluorine-containing polymer was composed of 60 mol% of tetrafluoroethylene and 40 mol% of vinyl benzoate. According to molecular weight analysis, the polymer had a number average molecular weight (Mn) of 9600. The polymer had a glass transition temperature (Tg) of 55°C. As a result of elemental analysis, the polymer had a fluorine content of 33.3% by mass.

The vinyl ester unit equivalent calculated from the composition was 263 g/eq.

Synthesis Example 3

A 3-L stainless-steel autoclave was charged with 800 g of acetone as a solvent and 20 g of vinyl benzoate. After the autoclave was purged with nitrogen, the tank was heated to 70°C. Into the tank was put tetrafluoroethylene under stirring until the pressure inside the tank reached 0.79 MPa.

Next, 4.2 g of PERBUTYL PV (product name, available from NOF Corporation) was put as a polymerization initiator thereinto. At the same time, supply of vinyl benzoate was started. Vinyl benzoate was added in a total amount of 100 g at a rate of 2.5 ml/min. Tetrafluoroethylene was also supplied during the reaction continuously in a manner that the pressure inside the tank was set to 0.775 to 0.7795 MPa.

After the supply of vinyl benzoate was stopped, the supply of tetrafluoroethylene was stopped. Then, the temperature and pressure inside the tank were brought back to normal temperature and normal pressure, and the polymerization was stopped. Thus, a solution (solid content concentration of 14% by mass) of a vinyl benzoate/tetrafluoroethylene copolymer in acetone was obtained.

After completion of the reaction, the polymer solution was reprecipitated in a large amount of methanol solution for purification of the polymer. After drying, a fluorine-containing polymer was obtained.

According to NMR analysis, the resulting fluorine-containing polymer was composed of 41 mol% of tetrafluoroethylene and 59 mol% of vinyl benzoate. According to molecular weight analysis, the polymer had a number average molecular weight (Mn) of 10000. The polymer had a glass transition temperature (Tg) of 62°C. As a result of elemental analysis, the polymer had a fluorine content of 23.5% by mass.

The vinyl ester unit equivalent calculated from the composition was 214 g/eq.

Synthesis Example 4

A 3-L stainless-steel autoclave was charged with 800 g of acetone as a solvent and 20 g of vinyl pivalate (PV). After the autoclave was purged with nitrogen, the tank was heated to 60°C. Into the tank was put tetrafluoroethylene under stirring until the pressure inside the tank reached 0.79 MPa.

Next, 2.1 g of PERBUTYL PV (product name, available from NOF Corporation) was put as a polymerization initiator thereinto. At the same time, supply of vinyl pivalate was started. Vinyl pivalate was added in a total amount of 160 g at a rate of 2.0 ml/min. Tetrafluoroethylene was also supplied during the reaction continuously in a manner that

the pressure inside the tank was set to 0.775 to 0.7795 MPa.

After the supply of vinyl pivalate was stopped, the supply of tetrafluoroethylene was stopped. After continuation of an aging reaction at 60°C for one hour, the temperature and pressure inside the tank were brought back to normal temperature and normal pressure, and the polymerization was stopped. Thus, a solution (solid content concentration of 14% by mass) of a vinyl pivalate/tetrafluoroethylene copolymer in acetone was obtained.

After completion of the reaction, the polymer solution was reprecipitated in a large amount of methanol solution for purification of the polymer. After drying, a fluorine-containing polymer was obtained.

According to NMR analysis, the resulting fluorine-containing polymer was composed of 55 mol% of tetrafluoroethylene and 45 mol% of vinyl pivalate. According to molecular weight analysis, the polymer had a number average molecular weight (Mn) of 14000. The polymer had a glass transition temperature (Tg) of 45°C. As a result of elemental analysis, the polymer had a fluorine content of 37.1% by mass.

The vinyl ester unit equivalent calculated from the composition was 250 g/eq.

Synthesis Example 5

A 3-L stainless-steel autoclave was charged with 800 g of acetone as a solvent. After the autoclave was purged with nitrogen, the tank was heated to 70°C. Into the tank was put tetrafluoroethylene under stirring until the pressure inside the tank reached 0.79 MPa.

Next, 4.2 g of PERBUTYL PV (product name, available from NOF Corporation) was put as a polymerization initiator thereinto. At the same time, supply of vinyl 4-t-butylbenzoate (t-BuVBz) was started. Vinyl 4-t-butylbenzoate was added in a total amount of 160 g at a rate of 2.0 ml/min. Tetrafluoroethylene was also supplied during the reaction continuously in a manner that the pressure inside the tank was set to 0.775 to 0.7795 MPa.

After the supply of vinyl 4-t-butylbenzoate was stopped, the supply of tetrafluoroethylene was stopped. The temperature of the tank was set to 75°C, and an aging reaction was continued for one hour.

Then, the temperature and pressure inside the tank were brought back to normal temperature and normal pressure, and the polymerization was stopped. Thus, a solution (solid content concentration of 27% by mass) of a vinyl 4-t-butylbenzoate/tetrafluoroethylene copolymer in acetone was obtained.

After completion of the reaction, the obtained solution was concentrated and dried to obtain a fluorine-containing polymer.

According to NMR analysis, the resulting fluorine-containing polymer was composed of 45 mol% of tetrafluoroethylene and 55 mol% of vinyl 4-t-butylbenzoate. According to molecular weight analysis, the polymer had a number average molecular weight (Mn) of 9000. The polymer had a glass transition temperature (Tg) of 85°C. As a result of elemental analysis, the polymer had a fluorine content of 34.5% by mass.

The vinyl ester unit equivalent calculated from the composition was 374 g/eq.

Synthesis Example 6

A 3-L stainless-steel autoclave was charged with 800 g of acetone as a solvent and 40 g of vinyl 4-t-butylbenzoate. After the autoclave was purged with nitrogen, the tank was heated to 65°C. Into the tank was put tetrafluoroethylene under stirring until the pressure inside the tank reached 0.79 MPa.

Next, 2.1 g of PERBUTYL PV (product name, available from NOF Corporation) was put as a polymerization initiator thereinto. At the same time, supply of vinyl 4-t-butylbenzoate was started. Vinyl 4-t-butylbenzoate was added in a total amount of 120 g at a rate of 2.0 ml/min. Tetrafluoroethylene was also supplied during the reaction continuously in a manner that the pressure inside the tank was set to 0.775 to 0.7795 MPa.

After the supply of vinyl 4-t-butylbenzoate was stopped, the supply of tetrafluoroethylene was stopped. The temperature of the tank was maintained at 65°C, and an aging reaction was continued for 0.5 hours.

Then, the temperature and pressure inside the tank were brought back to normal temperature and normal pressure, and the polymerization was stopped. Thus, a solution (solid content concentration of 22% by mass) of a vinyl 4-t-butylbenzoate/tetrafluoroethylene copolymer in acetone was obtained.

After completion of the reaction, the obtained solution was concentrated and dried to obtain a fluorine-containing polymer.

According to NMR analysis, the resulting fluorine-containing polymer was composed of 52 mol% of tetrafluoroethylene and 48 mol% of vinyl 4-t-butylbenzoate. According to molecular weight analysis, the polymer had a number average molecular weight (Mn) of 12000. The polymer had a glass transition temperature (Tg) of 107°C. As a result of elemental analysis, the polymer had a fluorine content of 26.1% by mass.

The vinyl ester unit equivalent calculated from the composition was 311 g/eq.

Synthesis Example 7

A 3-L stainless-steel autoclave was charged with 800 g of acetone as a solvent and 20 g of vinyl acetate. After the autoclave was purged with nitrogen, the tank was heated to 70°C. Into the tank was put tetrafluoroethylene under stirring until the pressure inside the tank reached 0.79 MPa.

Next, 2.1 g of PERBUTYL PV (product name, available from NOF Corporation) was put as a polymerization initiator thereinto. At the same time, supply of vinyl acetate was started. Vinyl acetate was added in a total amount of 110 g at a rate of 1.0 ml/min. Tetrafluoroethylene was also supplied during the reaction continuously in a manner that the pressure inside the tank was set to 0.775 to 0.7795 MPa.

After the supply of vinyl acetate was stopped, the supply of tetrafluoroethylene was stopped. Then, an aging reaction was further continued for 0.5 hours.

Then, the temperature and pressure inside the tank were brought back to normal temperature and normal pressure, and the polymerization was stopped. Thus, a solution (solid content concentration of 17% by mass) of a vinyl acetate/tetrafluoroethylene copolymer in acetone was obtained.

After completion of the reaction, the obtained solution was concentrated and dried to obtain a fluorine-containing polymer.

According to NMR analysis, the resulting fluorine-containing polymer was composed of 48 mol% of tetrafluoroethylene and 52 mol% of vinyl acetate. According to molecular weight analysis, the polymer had a number average molecular weight (Mn) of 10000. The polymer had a glass transition temperature (Tg) of 35°C. As a result of elemental analysis, the polymer had a fluorine content of 39.3% by mass.

The vinyl ester unit equivalent calculated from the composition was 178 g/eq.

Synthesis Example 8

A 3-L stainless-steel autoclave was charged with 800 g of acetone as a solvent and 20 g of vinyl benzoate. After the autoclave was purged with nitrogen, the tank was heated to 70°C. Into the tank was put 600 g of hexafluoropropylene under stirring.

Next, 2.1 g of PERBUTYL PV (product name, available from NOF Corporation) was put as a polymerization initiator thereinto. At the same time, supply of vinyl benzoate was started. Vinyl benzoate was added in a total amount of 60 g at a rate of 1.5 ml/min.

After the supply of vinyl benzoate was stopped, the reaction was allowed to continue for four hours while the temperature inside the tank was maintained at 70°C.

The temperature and pressure inside the tank were brought back to normal temperature and normal pressure, and the polymerization was stopped. Thus, a solution (solid content concentration of 14% by mass) of a vinyl benzoate/hexafluoropropylene copolymer in acetone was obtained.

After completion of the reaction, the obtained solution was concentrated and dried to obtain a fluorine-containing polymer.

According to NMR analysis, the resulting fluorine-containing polymer was composed of 37 mol% of hexafluoropropylene and 63 mol% of vinyl benzoate. According to molecular weight analysis, the polymer had a number average molecular weight (Mn) of 7500. The polymer had a glass transition temperature (Tg) of 45°C. As a result of elemental analysis, the polymer had a fluorine content of 28.1% by mass.

The vinyl ester unit equivalent calculated from the composition was 235 g/eq.

Synthesis Example 9

A 3-L stainless-steel autoclave was charged with 800 g of acetone as a solvent and 20 g of vinyl pivalate. After the autoclave was purged with nitrogen, the tank was heated to 70°C. Into the tank was put 600 g of hexafluoropropylene under stirring.

Next, 4.2 g of PERBUTYL PV (product name, available from NOF Corporation) was put as a polymerization initiator thereinto. At the same time, supply of vinyl pivalate was started. Vinyl pivalate was added in a total amount of 110 g at a rate of 1.5 ml/min.

After the supply of vinyl pivalate was stopped, the temperature and pressure inside the tank were brought back to normal temperature and normal pressure, and the polymerization was stopped. Thus, a solution (solid content concentration of 23% by mass) of a vinyl pivalate/hexafluoropropylene copolymer in acetone was obtained.

After completion of the reaction, the obtained solution was concentrated and dried to obtain a fluorine-containing polymer.

According to NMR analysis, the resulting fluorine-containing polymer was composed of 42 mol% of hexafluoropropylene and 58 mol% of vinyl pivalate. According to molecular weight analysis, the polymer had a number average

molecular weight (Mn) of 9000. The polymer had a glass transition temperature (Tg) of 50°C. As a result of elemental analysis, the polymer had a fluorine content of 34.5% by mass.

The vinyl ester unit equivalent calculated from the composition was 234 g/eq.

Synthesis Example 10

A 3-L stainless-steel autoclave was charged with 800 g of acetone as a solvent and 20 g of vinyl 4-t-butylbenzoate. After the autoclave was purged with nitrogen, the tank was heated to 70°C. Into the tank was put 600 g of hexafluoropropylene under stirring.

Next, 4.2 g of PERBUTYL PV (product name, available from NOF Corporation) was put as a polymerization initiator thereinto. At the same time, supply of vinyl 4-t-butylbenzoate was started. Vinyl 4-t-butylbenzoate was added in a total amount of 110 g at a rate of 2.0 ml/min.

After the supply of vinyl 4-t-butylbenzoate was stopped, the temperature and pressure inside the tank were brought back to normal temperature and normal pressure, and the polymerization was stopped. Thus, a solution (solid content concentration of 21% by mass) of a vinyl 4-t-butylbenzoate/hexafluoropropylene copolymer in acetone was obtained.

After completion of the reaction, the obtained solution was concentrated and dried to obtain a fluorine-containing polymer.

According to NMR analysis, the resulting fluorine-containing polymer was composed of 40 mol% of hexafluoropropylene and 60 mol% of vinyl 4-t-butylbenzoate. According to molecular weight analysis, the polymer had a number average molecular weight (Mn) of 9000. The polymer had a glass transition temperature (Tg) of 110°C. As a result of elemental analysis, the polymer had a fluorine content of 25.2% by mass.

The vinyl ester unit equivalent calculated from the composition was 305 g/eq.

Synthesis Example 11

A 3-L stainless-steel autoclave was charged with 800 g of acetone as a solvent, 16.5 g of vinyl 4-t-butylbenzoate, and 3.5 g of 4-hydroxybutyl vinyl ether. After the autoclave was purged with nitrogen, the tank was heated to 65°C. Into the tank was put tetrafluoroethylene under stirring until the pressure inside the tank reached 0.79 MPa.

Next, 2.1 g of PERBUTYL PV (product name, available from NOF Corporation) was put as a polymerization initiator thereinto. At the same time, supply of a mixed solution of 180 g of vinyl 4-t-butylbenzoate and 37 g of 4-hydroxybutyl vinyl ether was started. The mixed solution of vinyl 4-t-butylbenzoate and hydroxybutyl vinyl ether was added in a total amount of 160 g at a rate of 2.0 ml/min. Tetrafluoroethylene was also supplied during the reaction continuously in a manner that the pressure inside the tank was set to 0.775 to 0.7795 MPa.

After the supply of the mixed solution of vinyl 4-t-butylbenzoate and 4-hydroxybutyl vinyl ether was stopped, the supply of tetrafluoroethylene was stopped. Then, the temperature of the tank was set to 70°C, and an aging reaction was continued for 0.5 hours.

Then, the temperature and pressure inside the tank were brought back to normal temperature and normal pressure, and the polymerization was stopped. Thus, a solution (solid content concentration of 14% by mass) of a vinyl 4-t-butylbenzoate/4-hydroxybutyl vinyl ether/tetrafluoroethylene copolymer in acetone was obtained.

After completion of the reaction, the obtained solution was concentrated and dried to obtain a fluorine-containing polymer.

According to NMR analysis, the resulting fluorine-containing polymer was composed of 48 mol% of tetrafluoroethylene, 31 mol% of vinyl 4-t-butylbenzoate, and 21 mol% of 4-hydroxybutyl vinyl ether. According to molecular weight analysis, the polymer had a number average molecular weight (Mn) of 10000. The polymer had a glass transition temperature (Tg) of 40°C. As a result of elemental analysis, the polymer had a fluorine content of 26.5% by mass.

The vinyl ester unit equivalent calculated from the composition was 435 g/eq.

Synthesis Example 12

A 3-L stainless-steel autoclave was charged with 1000 g of acetone as a solvent and 10 g of vinyl benzoate. After the autoclave was purged with nitrogen, the tank was heated to 70°C. Into the tank was put tetrafluoroethylene under stirring until the pressure inside the tank reached 0.79 MPa.

Next, 4.2 g of PERBUTYL PV (product name, available from NOF Corporation) was put as a polymerization initiator thereinto. At the same time, supply of a mixed solution of 87 g of vinyl benzoate and 60 g of isobornyl acrylate (IBAC) was started. The mixed solution of vinyl benzoate and isobornyl acrylate was added in a total amount of 110 g at a rate of 1.5 ml/min. Tetrafluoroethylene was also supplied during the reaction continuously in a manner that the pressure inside the tank was set to 0.775 to 0.7795 MPa.

After the supply of the mixed solution of vinyl benzoate and isobornyl acrylate was stopped, the supply of tetrafluoroethylene was stopped. Then, the temperature and pressure inside the tank were brought back to normal temperature and normal pressure, and the polymerization was stopped. Thus, a solution (solid content concentration of 14% by mass) of a vinyl benzoate/isobornyl acrylate/tetrafluoroethylene copolymer in acetone was obtained.
After completion of the reaction, the polymer solution was reprecipitated in a large amount of methanol solution for purification of the polymer. After drying, a fluorine-containing polymer was obtained.
According to NMR analysis, the resulting fluorine-containing polymer was composed of 47 mol% of tetrafluoroethylene, 34 mol% of vinyl benzoate, and 19 mol% of isobornyl acrylate. According to molecular weight analysis, the polymer had a number average molecular weight (Mn) of 8000. The polymer had a glass transition temperature (Tg) of 60°C. As a result of elemental analysis, the polymer had a fluorine content of 26.3% by mass.
The vinyl ester unit equivalent calculated from the composition was 401 g/eq.

Synthesis Example 13

A 3-L stainless-steel autoclave was charged with 800 g of acetone as a solvent and 20 g of vinyl 4-t-butylbenzoate. After the autoclave was purged with nitrogen, the tank was heated to 70°C. Into the tank was put tetrafluoroethylene under stirring until the pressure inside the tank reached 0.79 MPa.
Next, 2.1 g of PERBUTYL PV (product name, available from NOF Corporation) was put as a polymerization initiator thereinto. At the same time, supply of a mixed solution of 100 g of vinyl 4-t-butylbenzoate and 54 g of isobornyl acrylate was started. The mixed solution of vinyl 4-t-butylbenzoate and isobornyl acrylate was added in a total amount of 132 g at a rate of 1.5 ml/min. Tetrafluoroethylene was also supplied during the reaction in a manner that the pressure inside the tank was set to 0.775 to 0.7795 MPa.
After the supply of the mixed solution of vinyl 4-t-butylbenzoate and isobornyl acrylate was stopped, the supply of tetrafluoroethylene was stopped. Then, an aging reaction was continued for 0.5 hours, while the temperature inside the tank was maintained at 70°C.
Then, the temperature and pressure inside the tank were brought back to normal temperature and normal pressure, and the polymerization was stopped. Thus, a solution (solid content concentration of 20% by mass) of a vinyl 4-t-butylbenzoate/isobornyl acrylate/tetrafluoroethylene copolymer in acetone was obtained.
After completion of the reaction, the obtained solution was concentrated and dried to obtain a fluorine-containing polymer.
According to NMR analysis, the resulting fluorine-containing polymer was composed of 42 mol% of tetrafluoroethylene, 36 mol% of vinyl 4-t-butylbenzoate, and 22 mol% of isobornyl acrylate. According to molecular weight analysis, the polymer had a number average molecular weight (Mn) of 8000. The polymer had a glass transition temperature (Tg) of 95°C. As a result of elemental analysis, the polymer had a fluorine content of 19.8% by mass.
The vinyl ester unit equivalent calculated from the composition was 450 g/eq.

Synthesis Example 14

A 3-L stainless-steel autoclave was charged with 1400 g of a fluorine-type solvent (Novec 7200 available from 3M) as a solvent and 20 g of vinyl 4-t-butylbenzoate. After the autoclave was purged with nitrogen, the tank was heated to 65°C. Into the tank was put tetrafluoroethylene under stirring until the pressure inside the tank reached 0.79 MPa.
Next, 2.1 g of PERBUTYL PV (product name, available from NOF Corporation) was put as a polymerization initiator thereinto. At the same time, supply of vinyl 4-t-butylbenzoate was started. 4-t-Butyl vinyl benzoate was added in a total amount of 80 g at a rate of 2.0 ml/min. Tetrafluoroethylene was also supplied during the reaction continuously in a manner that the pressure inside the tank was set to 0.775 to 0.7795 MPa.
After the supply of vinyl 4-t-butylbenzoate was stopped, the supply of tetrafluoroethylene was stopped.
Then, the temperature and pressure inside the tank were brought back to normal temperature and normal pressure, and the polymerization was stopped. Thus, a solution (solid content concentration of 0.4% by mass) of a vinyl 4-t-butylbenzoate/tetrafluoroethylene copolymer in the fluorine-type solvent was obtained. Since a solid fluorine-containing polymer was deposited from the vinyl 4-t-butylbenzoate/tetrafluoroethylene copolymer, 800 g of acetone was further added to the tank and the contents were stirred at 60°C for 0.5 hours. Thus, the fluorine-containing polymer was recovered. The solid content concentration was 8.3% by mass.
The obtained acetone solution was concentrated and then reprecipitated in a large amount of methanol solution for purification of the polymer. After drying, a fluorine-containing polymer was obtained.
According to NMR analysis, the resulting fluorine-containing polymer was composed of 19 mol% of tetrafluoroethylene and 81 mol% of vinyl 4-t-butylbenzoate. According to molecular weight analysis, the polymer had a number average molecular weight (Mn) of 19000. The polymer had a glass transition temperature (Tg) of 95°C. As a result of elemental analysis, the polymer had a fluorine content of 10.4% by mass.

The vinyl ester unit equivalent calculated from the composition was 236 g/eq.

Synthesis Example 15

A 3-L stainless-steel autoclave was charged with 1300 g of a fluorine-type solvent (Novec 7200 available from 3M) as a solvent and 40 g of allyl glycidyl ether. After the autoclave was purged with nitrogen, the tank was heated to 70°C. Into the tank was put tetrafluoroethylene under stirring until the pressure inside the tank reached 0.79 MPa.
Next, 4.2 g of PERBUTYL PV (product name, available from NOF Corporation) was put as a polymerization initiator thereinto. At the same time, supply of allyl glycidyl ether was started. Allyl glycidyl ether was added in a total amount of 180 g at a rate of 1.5 ml/min. Tetrafluoroethylene was also supplied during the reaction continuously in a manner that the pressure inside the tank was set to 0.775 to 0.7795 MPa. After a lapse of 5 hours, 1 hour, and 1.5 hours from the start of the reaction, a 4.2-g portion of PERBUTYL PV was further added.
After the supply of allyl glycidyl ether was stopped, the supply of tetrafluoroethylene was stopped.
The temperature inside the tank was set to 75°C, and an aging reaction was continued for three hours.
Then, the temperature and pressure inside the tank were brought back to normal temperature and normal pressure, and the polymerization was stopped. The content taken out therefrom consisted of two layers including a solution (solid content concentration of 0.7% by mass) of an allyl glycidyl ether/tetrafluoroethylene copolymer in the fluorine-type solvent and a component mainly containing the allyl glycidyl ether/tetrafluoroethylene copolymer. Since the allyl glycidyl ether/tetrafluoroethylene copolymer was found to be dissolved in acetone, 800 g of acetone was further fed into the tank and the contents were stirred at 60°C for 0.5 hours. Thus, a fluorine-containing polymer was recovered and put together with the above-mentioned component mainly containing the allyl glycidyl ether/tetrafluoroethylene copolymer. The solid content concentration was 15.2% by mass.
The resulting acetone solution was concentrated and dried to obtain a fluorine-containing polymer.
According to NMR analysis, the resulting fluorine-containing polymer (epoxy resin) was composed of 41 mol% of tetrafluoroethylene and 59 mol% of allyl glycidyl ether. According to molecular weight analysis, the polymer had a number average molecular weight (Mn) of 1500. The polymer had a glass transition temperature (Tg) of -35°C. As a result of elemental analysis, the polymer had a fluorine content of 28.8% by mass. The polymer was liquid at 25°C.
The epoxy unit equivalent calculated from the composition was 184 g/eq.

Synthesis Example 16

A 3-L stainless-steel autoclave was charged with 800 g of acetone as a solvent and 20 g of vinyl benzoate. After the autoclave was purged with nitrogen, the tank was heated to 70°C. Into the tank was put 600 g of hexafluoropropylene under stirring.
Next, 4.2 g of PERBUTYL PV (product name, available from NOF Corporation) was put as a polymerization initiator thereinto. At the same time, supply of vinyl benzoate was started. The vinyl benzoate was added in a total amount of 100 g at a rate of 1.5 ml/min.
After the supply of vinyl benzoate was stopped, the temperature and pressure inside the tank were brought back to normal temperature and normal pressure, and the polymerization was stopped. Thus, a solution (solid content concentration of 16% by mass) of a vinyl benzoate/hexafluoropropylene copolymer in acetone was obtained.
After completion of the reaction, the polymer solution was reprecipitated in a large amount of methanol solution for purification of the polymer. After drying, a fluorine-containing polymer was obtained.
According to NMR analysis, the resulting fluorine-containing polymer was composed of 37 mol% of hexafluoropropylene and 63 mol% of vinyl benzoate. According to molecular weight analysis, the polymer had a number average molecular weight (Mn) of 9000. The polymer had a glass transition temperature (Tg) of 65°C. As a result of elemental analysis, the polymer had a fluorine content of 28.1% by mass.
The vinyl ester unit equivalent calculated from the composition was 235 g/eq.

[Relative dielectric constant and dielectric loss tangent]

A film of each of the fluorine-containing polymers obtained in Synthesis Examples 1 to 14 and 16 was produced by vacuum heat press. The relative dielectric constant and dielectric loss tangent of the produced film (sample F) were measured as follows. Table 3 shows the results.
Using a network analyzer, changes in the resonant frequency and Q value of the sample F produced above were measured with a cavity resonator. Using the following equations, the dielectric loss tangent (tan $\delta$) at 12 GHz was calculated. The cavity resonator method employed herein is in conformity with [Nondestructive measurement of complex permittivity of dielectric plate materials by a cavity resonance method. MW87-53] by Prof. Kobayashi of Saitama University.

tan δ = (1/Qu) × {1 + (W2/W1)} - (Pc/ωW1)

[Math. 1]

$$\varepsilon_r = \left(\frac{c}{\pi \times L - F_0}\right)^2 \times \left\{X^2 - Y^2\left(\frac{L}{2M}\right)^2\right\} + 1$$

XtanX= (L／2M) YcosY

$$X = \frac{L}{2}\sqrt{\varepsilon_r \times k_0^{\ 2} - k_r^{\ 2}}$$

$$Y = M\sqrt{k_0^{\ 2} - k_r^{\ 2}}$$

$$k_0 = \frac{\varpi}{c}$$

$$\varpi = 2\pi F_0$$

$$k_r = \frac{3.8317}{D/2}$$

$$Q_u = \frac{Q_L}{1 - 10^{(-Id/20)}}$$

$$Q_L = \frac{F_0}{F_1 - F_2}$$

$$W_1 = \frac{1}{8} \times \varepsilon_r \times \varepsilon_0 \times L \times \pi \times \varpi^2 \times \mu_0^{\ 2} \times J_1^{\ 2} \times J_0^{\ 2} \times \left(1 + \frac{\sin X}{2X}\right)$$

$$W_2 = \frac{1}{4} \times \varepsilon_0 \times M \times \pi \times \left(1 - \frac{\sin 2Y}{2Y}\right) \times \varpi^2 \times \mu_0^{\ 2} \times J_1^{\ 2} \times J_0^{\ 2}$$

$$P_c = P_1 + P_2 + P_3$$

$$P_1 = \frac{1}{2} \times Rs \times \frac{D}{2} \times L \times \pi \times \left(1 - \frac{\sin X}{2X}\right) \times \left(\frac{J_1 \times 2}{D}\right)^4 \times J_0^{\ 2}$$

$$P_2 = \frac{1}{2} \times \left(\frac{-\cos X}{\sin Y}\right)^2 \times Rs \times \frac{D}{2} \times M \times \pi \times \left(1 - \frac{\sin 2Y}{2Y}\right) \times \left(\frac{J_1 \times 2}{D}\right)^4 \times J_0^{\ 2}$$

$$P_3 = \frac{1}{2} \times \left(\frac{-\cos X}{\sin Y}\right)^2 \times Rs \times \pi \times \left(J_1 \times J_0 \times \frac{Y}{M}\right)^2$$

Symbols in the equations are defined as below.

D: Diameter of cavity resonator (mm)
M: Length on one side of cavity resonator (mm)
L: Sample length (mm)
c: Light speed (m/s)
Id: Attenuation (dB)
F0: Resonant frequency (Hz)
F1: Upper frequency at which attenuation from resonance point is 3 dB (Hz)
F2: Lower frequency at which attenuation from resonance point is 3 dB (Hz)
ε0: Dielectric constant in vacuum (H/m)
εr: Relative dielectric constant of sample
μ0: Magnetic permeability in vacuum (H/m)
Rs: Effective surface resistance in consideration of surface roughness of conductor cavity (Ω)
J0: -0.402759
J1: 3.83171

Proportion of $-CF_2H$ end

Based on 19F-NMR measurement, the integral value of entire $CF_2$ from -104 ppm to -142 ppm and the integral value of $CF_2H$ from -136 ppm to -142 ppm were obtained, and the obtained values were assigned in the following equation for calculation of the proportion of the $-CF_2H$ end. Table 3 shows the results.

Proportion of $-CF_2H$ end = (integral value of $CF_2H$ from -136 ppm to -142 ppm)/(integral value of entire $CF_2$ from -104 ppm to -142 ppm) × 100

Proportion of $-CF_2CFHCF_3$ end

Base on 19F-NMR measurement, the integral value of entire CF from -172 ppm to -216 ppm and the integral value of CFH from -210 ppm to -216 ppm were obtained, and the obtained values were assigned in the following equation for calculation of the proportion of the $-CF_2CFHCF_3$ end. Table 3 shows the results.

Proportion of $-CF_2CFHCF_3$ end = (integral value of CFH from -210 ppm to -216 ppm)/(integral value of entire CF from -172 ppm to -216 ppm) × 100

[Table 3]

| Synthes is Example | Polymercom position | | Fluorine content (mass%) | Proportion of-CF2H end (%) | Proportion of-CF2CFHCF3 end (%) | M n | Film appearance | Film tickness (mm) | Dielectric constant | Dieelctric bss tangent | Glass transition point(°C) |
|---|---|---|---|---|---|---|---|---|---|---|---|
| 1 | TFE/VBz | 50/50 | 30.3 | 0.57 | | 12000 | Clear | 0.791 | 2.69 | 0.0073 | 66 |
| 2 | TFE/VBz | 60/40 | 33.3 | 0.82 | | 9600 | Clear | 0.832 | 2.61 | 0.0100 | 55 |
| 3 | TFE/VBz | 41/59 | 23.5 | 0.15 | | 10000 | Clear | 0.804 | 2.71 | 0.0051 | 62 |
| 4 | TFE/PV | 55/45 | 37.1 | 0.42 | | 14000 | Clear | 0.794 | 2.38 | 0.0098 | 45 |
| 5 | TFE/t-BuVBz | 45/55 | 34.5 | 2.00 | | 9000 | White | 0.744 | 2.52 | 0.0118 | 85 |
| 6 | TFE/t-BuVBz | 52/48 | 26.1 | 0.58 | | 12000 | White | 0.92 | 2.43 | 0.0077 | 107 |
| 7 | TFE/ Vinylacetate | 48/52 | 39.3 | 0.02 | | 10000 | Clear | 0.596 | 2.37 | 0.0090 | 35 |
| 8 | HFP/VBz | 37/63 | 28.1 | | 7.66 | 7500 | Clear | 0.797 | 2.74 | 0.0121 | 45 |
| 9 | HFP/PV | 42/58 | 34.5 | | 0.00 | 9000 | Clear | 0.833 | 2.12 | 0.0064 | 50 |
| 10 | HFP/t-BuVBz | 40/60 | 25.2 | | 1.50 | 9000 | Clear | 1.052 | 2.57 | 0.0054 | 110 |
| 11 | TFE/t-BuVBz/ HBVE | 48/31/21 | 26.5 | 3.57 | | 10000 | Clear | 0.767 | 2.67 | 0.0187 | 40 |
| 12 | TFE/VBz/BAC | 47/34/19 | 26.3 | 1.43 | | 8000 | Clear | 0.731 | 2.61 | 0.0086 | 60 |
| 13 | TFE/t- BuVBz/BAC | 42/36/22 | 19.8 | 1.41 | | 8000 | Clear | 0.991 | 2.48 | 0.0071 | 95 |
| 14 | TFE/t-BuVBz | 19/81 | 10.4 | 0.00 | | 19000 | Clear | 0,76 | 2.57 | 0.0045 | 95 |
| 15 | TFE/AGE | 41/59 | 28.8 | 2.76 | | 1500 | - | | - | - | -35 |
| 16 | HFP/VBz | 37/63 | 28.1 | | 0.90 | 9000 | Clear | 0.776 | 2.70 | 0.0049 | 65 |

Table 3 shows that synthesis Examples 1 to 7, 9, 10, 12 to 14, and 15 corresponding to the third fluorine-containing polymer of the disclosure each have a low dielectric loss tangent.

Comparison of Synthesis Examples 1 to 3 or comparison of Synthesis Examples 5 and 14 shows that the dielectric loss tangent is lower when the proportion of the $-CF_2H$ end is smaller.

Comparison of Synthesis Examples 8 and 16 shows that the dielectric loss tangent is lower when the proportion of the $-CF_2CFHCF_3$ end is smaller.

Compatibility was evaluated as described below.

The fluorine-containing polymers (ester resins) obtained in Synthesis Examples 1 to 14 and 16 were each dissolved in acetone to obtain a solution having a solid content of 50% by mass. Using epoxy resins including epoxy A: Synthesis Example 15, epoxy B: 2,2-bis(4-glycidyloxyphenyl)propane (available from Tokyo Chemical Industry Co., Ltd., purity of 92.6%, epoxy equivalent of 184), and epoxy C: ethylene glycol diglycidyl ether (available from Kyoeisha Chemical Co., Ltd., epoxy equivalent of 130), solutions having a solid content of 50% by mass were similarly prepared.

Next, two types of solutions (ester resin solution, epoxy resin solution) obtained above were mixed in a manner that the vinyl ester unit equivalent was set equal to the epoxy equivalent. The appearance of the solution mixture was visually observed to evaluate the compatibility. The compatibility was judged based on the following criteria.

State of solution mixture

Clear: Good (good compatibility)
Not clear: Poor (poor compatibility)

In the case where the solution mixture was not clear when the solid content concentration was 50% by mass, acetone was added until the solution mixture became clear. The solid content concentration at which the solution mixture became clear was used for evaluation of the compatibility. Tables 4 to 6 show the results. The columns for compatibility evaluation in the tables show the solid content concentration (% by mass) at which the solution mixture became clear.

The reactivity with epoxy resins was evaluated by the following method.

To the above solution mixture was added 4-dimethylaminopyridine (DMAP) in an amount of 0.5% by mass relative to the solid content of the solution, followed by well mixing. Thus, a curable composition was produced.

A 10-g portion of the curable composition was dried in a fan dryer set to 50°C for three hours, and then reacted in a fan dryer set to 175°C for 12 hours. After the reaction, the cured product was cooled.

Next, the gel fraction was measured as an index of the reaction degree of the cured product.

A portion of the cured product was wrapped in a preliminarily weighed 400-mesh metallic wire cloth. To a 50-ml sample tube was charged 25 ml of acetone and the cured product wrapped in the wire cloth. The cured product was immersed in acetone for 12 hours. Then, the wire cloth was taken out and the mass thereof was measured after drying. The dried cured product after acetone immersion was calculated.

The gel fraction was calculated using the expression: mass of dried cured product after acetone immersion/mass of cured product before acetone immersion × 100. Tables 4 to 6 show the results.

[Table 4]

| No. | Epoxy | | Ester | | | Catalyst | | Evaluation compatbility | Gelfraction alterimmersion |
|---|---|---|---|---|---|---|---|---|---|
| | Type of epoxy | Charged am ountof solids (g) | Type of ester | | Charged am ountof solids (g) | Type of catalyst | 5% solution (g) | | |
| 1 | Epoxy A | 2.5 | TFE/VBz | Synthesis Example 1 | 3.36 | DM AP | 1.17 | 50% | 91 |
| 2 | Epoxy A | 2.5 | TFE/PV | Synlthes is Example 4 | 3.40 | DM AP | 1.18 | 30% | 70 |
| 3 | Epoxy A | 2.5 | TFE/ vinylacetate | Synthesis Example 7 | 1.92 | DM AP | 0.88 | 50% | 96 |
| 4 | Epoxy A | 2.5 | TFE/t-BuVBz | Synthes is Example 14 | 3.22 | DM AP | 1.14 | 40% | 93 |
| 5 | Epoxy A | 2.5 | TFE/VBz/BAC | Synthes is Example 12 | 5.49 | DM AP | 1.60 | 50% | 97 |
| 6 | Epoxy A | 2.5 | TFE/VBz | Synthesis Example 3 | 2.92 | DM AP | 1.08 | 50% | 94 |
| 7 | Epoxy A | 2.5 | HFP/VBz | Synthes is Example 16 | 3.20 | DM AP | 1.14 | 50% | 83 |
| 8 | Epoxy A | 2.5 | TFE/t- BuVBz/BAC | Synthes is Example 13 | 6.15 | DM AP | 1.60 | 40% | 90 |

[Table 5]

| No. | Epoxy | | Ester | | | Catalyst | | Evaluation on com patibility | Gelfraction after imm ersion |
|---|---|---|---|---|---|---|---|---|---|
| | Type of epoxy | Charged am ountof solids (g) | Type of ester | | Charged am ountof solids (g) | Type of catalyst | 5% solution (g) | | |
| 1 | Epoxy B | 1.36 | TFE/VBz | Synthesis Example 1 | 1.68 | DM AP | 0.59 | 50% | 60 |
| 2 | Epoxy B | 1.36 | TFE/PV | Synthesis Example 4 | 1.70 | DM AP | 0.59 | 40% | 65 |
| 3 | Epoxy B | 1.36 | TFE/vinylacetate | Synthesis Example 7 | 0.96 | DM AP | 0.44 | 50% | 81 |
| 4 | Epoxy B | 1.36 | TFE/t-BuVBz | Synthes is Example 14 | 1.61 | DM AP | 0.57 | 50% | 73 |
| 5 | Epoxy B | 1.36 | TFE/VBz/BAC | Synthes is Example 12 | 2.75 | DM AP | 0.80 | 50% | 73 |
| 6 | Epoxy B | 1.36 | TFE/VBz | Synthesis Example 3 | 1.46 | DM AP | 0.54 | 50% | 64 |
| 7 | Epoxy B | 1.36 | HFP/VBz | Synthes is Example 16 | 1.60 | DM AP | 0.57 | 50% | 68 |
| 8 | Epoxy B | 1.36 | TFE/t-BuVBz/BAC | Synthes is Example 13 | 3.08 | DM AP | 0.80 | 50% | 81 |

[Table 6]

| No. | Epoxy | | Ester | | | Catalyst | | Evaluation compatibility | Gelfraction alter immersion |
|---|---|---|---|---|---|---|---|---|---|
| | Type of epoxy | Charged am ountof solids (g) | Type of ester | | Charged am ountof solids (g) | Type of catalyst | 5% solution (g) | | |
| 1 | Epoxy C | 0.92 | TFE/VBz | Synthesis Example 1 | 1.68 | DM AP | 0.26 | 50% | 72 |
| 2 | Epoxy C | 0.92 | TFE/PV | Synthes is Example 4 | 1.70 | DM AP | 0.26 | 50% | 37 |
| 3 | Epoxy C | 0.92 | TFE/vinlacetate | Synthesis Example 7 | 0.96 | DM AP | 0.19 | 50% | 80 |
| 4 | Epoxy C | 0.92 | TFE/t-BuVBz | Synthes is Example 14 | 1.61 | DM AP | 0.26 | 50% | 63 |
| 5 | Epoxy C | 0.92 | TFE/VBz/BAC | Synthes is Example 12 | 2.75 | DM AP | 0.37 | 50% | 78 |
| 6 | Epoxy C | 0.92 | TFE/VBz | Synthesis Example 3 | 1.46 | DM AP | 0.24 | 50% | 70 |
| 7 | Epoxy C | 0.92 | HFP/VBz | Synthes is Example 16 | 1.60 | DM AP | 0.25 | 50% | 66 |
| 8 | Epoxy C | 0.92 | TFE/t-BuVBz/BAC | Synthes is Example 13 | 3.08 | DM AP | 0.40 | 50% | 84 |

Tables 4 to 6 show that those having a higher compatibility (solid content concentration at which the solution mixture became clear was higher) have a higher gel fraction, and that the sample containing the epoxy resin (epoxy A) of Synthesis Example 15 has a high gel fraction.

The results of No.1 to 3 show that, in the case where the vinyl ester monomer used is vinyl benzoate (VBz) or vinyl acetate, generally, the reactivity with epoxy resins is better to increase the gel fraction.

The results of No. 5 and 6 show that the use of isobornyl acrylate (IABC) as a third component different from the fluorine-containing vinyl monomer or the vinyl ester monomer improves the reactivity with epoxy resins to increase the gel fraction.

## Claims

1. A fluorine-containing polymer for a metal-clad laminated sheet, comprising:

   a polymerized unit based on a fluorine-containing vinyl monomer; and
   a polymerized unit based on a vinyl ester monomer other than the fluorine-containing vinyl monomer,
   the fluorine-containing polymer comprising not more than 1 mol% in total of a polymerized unit based on a monomer containing a hydroxy group and a polymerized unit based on a monomer containing a carboxy group, of all polymerized units.

2. A composition for a metal-clad laminated sheet, comprising:

   the fluorine-containing polymer according to claim 1; and
   a solvent.

3. The composition for a metal-clad laminated sheet according to claim 2, wherein the polymerized unit based on a vinyl ester monomer is contained in an amount of 10 mol% or more of all polymerized units of the fluorine-containing polymer.

4. The composition for a metal-clad laminated sheet according to claim 2 or 3, wherein the vinyl ester monomer is a monomer represented by the following formula:

   $$CH_2=CH\text{-}O\text{-}C(=O)\text{-}R^A$$

   wherein $R^A$ is a C1-C4 alkyl group or a phenyl group optionally containing a substituent.

5. The composition for a metal-clad laminated sheet according to any one of claims 2 to 4, wherein the vinyl ester monomer includes at least one selected from the group consisting of vinyl benzoate, vinyl para-t-butylbenzoate, vinyl acetate, and vinyl pivalate.

6. The composition for a metal-clad laminated sheet according to any one of claims 2 to 5, wherein the polymerized unit based on a fluorine-containing vinyl monomer is contained in an amount of 10 mol% or more of all polymerized units of the fluorine-containing polymer.

7. The composition for a metal-clad laminated sheet according to any one of claims 2 to 6, wherein the fluorine-containing vinyl monomer includes at least one selected from the group consisting of tetrafluoroethylene, chlorotrifluoroethylene, vinyl fluoride, hexafluoropropylene, and perfluoro(alkyl vinyl ethers).

8. The composition for a metal-clad laminated sheet according to any one of claims 2 to 7, wherein the fluorine-containing polymer further contains a polymerized unit based on a monomer different from the fluorine-containing vinyl monomer or the vinyl ester monomer.

9. The composition for a metal-clad laminated sheet according to claim 8, wherein the monomer different from the fluorine-containing vinyl monomer or the vinyl ester monomer includes a monomer represented by the following formula (2) :

[Chem. 1]

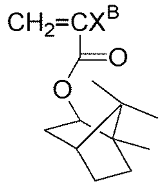

(2)

wherein $X^B$ is H or $CH_3$.

**10.** The composition for a metal-clad laminated sheet according to any one of claims 2 to 9, wherein the fluorine-containing polymer has a number average molecular weight of 1000 to 30000.

**11.** A curable composition comprising:

a fluorine-containing polymer; and
an epoxy resin,
the fluorine-containing polymer comprising a polymerized unit based on a fluorine-containing vinyl monomer and a polymerized unit based on a vinyl ester other than the polymerized unit based on a fluorine-containing vinyl monomer, and comprising not more than 1 mol% in total of a polymerized unit based on a monomer containing a hydroxy group and a polymerized unit based on a monomer containing a carboxy group, of all polymerized units.

**12.** The curable composition according to claim 11, further comprising a solvent.

**13.** The curable composition according to claim 11 or 12, wherein the epoxy resin is contained in an amount of 1 to 1000 parts by mass relative to 100 parts by mass of the fluorine-containing polymer.

**14.** The curable composition according to any one of claims 11 to 13, further comprising a curing accelerator.

**15.** A metal-clad laminated sheet comprising:

a metal foil; and
a resin layer provided on the metal foil,
the resin layer being formed of the curable composition according to any one of claims 11 to 14.

**16.** A printed substrate comprising a patterned circuit formed by etching the metal foil of the metal-clad laminated sheet according to claim 15.

**17.** A fluorine-containing polymer comprising:

a polymerized unit based on tetrafluoroethylene; and
a polymerized unit based on a vinyl ester monomer,
the fluorine-containing polymer comprising a chain of a tetrafluoroethylene unit-a vinyl ester unit-a tetrafluoroethylene unit in an amount of 45 mol% or more and comprising not more than 1 mol% in total of a polymerized unit based on a monomer containing a hydroxy group and a polymerized unit based on a monomer containing a carboxy group, of all polymerized units.

**18.** The fluorine-containing polymer according to claim 17, having a number average molecular weight of 15000 or less.

**19.** The fluorine-containing polymer according to claim 17 or 18, wherein the polymerized unit based on a vinyl ester monomer is contained in an amount of 10 mol% or more of all polymerized units of the fluorine-containing polymer.

**20.** The fluorine-containing polymer according to any one of claims 17 to 19, wherein the vinyl ester monomer is a monomer represented by the following formula:

$CH_2=CH-O-C(=O)-R^A$

wherein $R^A$ is a C1-C4 alkyl group or a phenyl group optionally containing a substituent.

**21.** The fluorine-containing polymer according to any one of claims 17 to 20, wherein the vinyl ester monomer includes at least one selected from the group consisting of vinyl benzoate, vinyl para-t-butylbenzoate, vinyl acetate, and vinyl pivalate.

**22.** The fluorine-containing polymer according to any one of claims 17 to 21, wherein the polymerized unit based on tetrafluoroethylene is contained in an amount of 10 mol% or more of all polymerized units of the fluorine-containing polymer.

**23.** The fluorine-containing polymer according to any one of claims 17 to 22, further comprising a polymerized unit based on a monomer different from the tetrafluoroethylene or the vinyl ester monomer.

**24.** The fluorine-containing polymer according to claim 23, wherein the monomer different from the tetrafluoroethylene or the vinyl ester monomer includes a monomer represented by the following formula (2):

[Chem. 2]

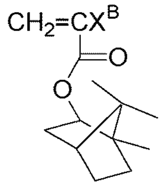

(2)

wherein $X^B$ is H or $CH_3$.

**25.** A composition for a metal-clad laminated sheet, comprising:

the fluorine-containing polymer according to any one of claims 17 to 24; and
a solvent.

**26.** A curable composition comprising:

the fluorine-containing polymer according to any one of claims 17 to 24; and
an epoxy resin.

**27.** The curable composition according to claim 26, further comprising a solvent.

**28.** The curable composition according to claim 26 or 27, wherein the epoxy resin is contained in an amount of 1 to 1000 parts by mass relative to 100 parts by mass of the fluorine-containing polymer.

**29.** The curable composition according to any one of claims 26 to 28, further comprising a curing accelerator.

**30.** A metal-clad laminated sheet comprising:

a metal foil; and
a resin layer provided on the metal foil,
the resin layer being formed of the curable composition according to any one of claims 26 to 29.

**31.** A printed substrate comprising a patterned circuit formed by etching the metal foil of the metal-clad laminated sheet according to claim 30.

**32.** A fluorine-containing polymer comprising:

a polymerized unit based on a fluorine-containing vinyl monomer; and
a polymerized unit based on a vinyl ester monomer,
the polymerized unit based on a fluorine-containing vinyl monomer and the polymerized unit based on a vinyl ester monomer being contained in a total amount of 70 to 100 mol% of all polymerized units,
the fluorine-containing vinyl monomer including at least one selected from the group consisting of tetrafluoroethylene, hexafluoropropylene, and chlorotrifluoroethylene,
wherein, in the case of the fluorine-containing vinyl monomer including tetrafluoroethylene, an integral value of $CF_2H$ at a $-CF_2H$ end is not more than 2% of an integral value of entire $CF_2$ in 19F-NMR,
in the case of the fluorine-containing vinyl monomer including hexafluoropropylene, an integral value of CFH at a $-CF_2CFHCF_3$ end is not more than 2% of an integral value of entire CF in 19F-NMR, and
in the case of the fluorine-containing vinyl monomer including chlorotrifluoroethylene, a total of an integral value of $CF_2H$ at a $-CF_2H$ end and an integral value of CFClH at a -CFClH end is not more than 2% of a total of an integral value of entire $CF_2$ and an integral value of entire CFCl in 19F-NMR.

**33.** The fluorine-containing polymer according to claim 32, having a number average molecular weight of 1000 to 600000.

**34.** The fluorine-containing polymer according to claim 32 or 33,
wherein the polymerized unit based on a vinyl ester monomer is contained in an amount of 10 mol% or more of all polymerized units of the fluorine-containing polymer.

**35.** The fluorine-containing polymer according to any one of claims 32 to 34,
wherein the vinyl ester monomer is a monomer represented by the following formula:

$$CH_2=CH-O-C(=O)-R^A$$

wherein $R^A$ is a C1-C4 alkyl group or a phenyl group optionally containing a substituent.

**36.** The fluorine-containing polymer according to any one of claims 32 to 35,
wherein the vinyl ester monomer includes at least one selected from the group consisting of vinyl benzoate, vinyl para-t-butylbenzoate, vinyl acetate, and vinyl pivalate.

**37.** The fluorine-containing polymer according to any one of claims 32 to 36,
wherein the polymerized unit based on a fluorine-containing vinyl monomer is contained in an amount of 10 mol% or more of all polymerized units of the fluorine-containing polymer.

**38.** The fluorine-containing polymer according to any one of claims 32 to 37, further comprising a polymerized unit based on a monomer different from the fluorine-containing vinyl monomer or the vinyl ester monomer.

**39.** The fluorine-containing polymer according to claim 38,
wherein the monomer different from the fluorine-containing vinyl monomer or the vinyl ester monomer includes a monomer represented by the following formula (2) :

[Chem. 3]

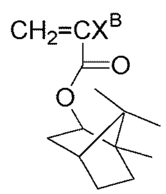

(2)

wherein $X^B$ is H or $CH_3$.

**40.** A composition for a metal-clad laminated sheet, comprising:

the fluorine-containing polymer according to any one of claims 32 to 39; and

a solvent.

**41.** A curable composition comprising:

the fluorine-containing polymer according to any one of claims 32 to 39; and
an epoxy resin.

**42.** The curable composition according to claim 41, further comprising a solvent.

**43.** The curable composition according to claim 41 or 42,
wherein the epoxy resin is contained in an amount of 1 to 1000 parts by mass relative to 100 parts by mass of the fluorine-containing polymer.

**44.** The curable composition according to any one of claims 41 to 43, further comprising a curing accelerator.

**45.** A metal-clad laminated sheet comprising:

a metal foil; and
a resin layer provided on the metal foil,
the resin layer being formed of the curable composition according to any one of claims 41 to 44.

**46.** A printed substrate comprising a patterned circuit formed by etching the metal foil of the metal-clad laminated sheet according to claim 45.

**47.** An epoxy resin comprising:

at least one of a polymerized unit based on tetrafluoroethylene or a polymerized unit based on hexafluoropropylene; and
a polymerized unit based on allyl glycidyl ether,
the polymerized unit based on tetrafluoroethylene, the polymerized unit based on hexafluoropropylene, and the polymerized unit based on allyl glycidyl ether being contained in a total amount of 98 to 100 mol% of all polymerized units.

**48.** The epoxy resin according to claim 47, which is liquid at 25°C.

**49.** The epoxy resin according to claim 47 or 48, having a number average molecular weight of 500 to 10000.

**50.** The epoxy resin according to any one of claim 47 to 49,

wherein, in the case where the polymerized unit based on tetrafluoroethylene is contained, an integral value of $CF_2H$ at a $-CF_2H$ end is not more than 4% of an integral value of entire $CF_2$ in 19F-NMR, and
in the case where the polymerized unit based on hexafluoropropylene is contained, an integral value of CFH at a $-CF_2CFHCF_3$ end is not more than 4% of an integral value of entire CF in 19F-NMR.

**51.** The epoxy resin according to any one of claims 47 to 50,
wherein the polymerized unit based on allyl glycidyl ether is contained in an amount of 10 mol% or more of all polymerized units of the epoxy resin.

**52.** The epoxy resin according to any one of claims 47 to 51,
wherein the polymerized unit based on tetrafluoroethylene and the polymerized unit based on hexafluoropropylene are contained in a total amount of 10 mol% or more of all polymerized units of the epoxy resin.

**53.** A curable composition comprising:

the epoxy resin according to any one of claims 47 to 52; and
the fluorine-containing polymer according to any one of claims 32 to 39.

**54.** The curable composition according to claim 53, further comprising a solvent.

**55.** The curable composition according to claim 53 or 54,
wherein the epoxy resin is contained in an amount of 1 to 1000 parts by mass relative to 100 parts by mass of the fluorine-containing polymer.

**56.** The curable composition according to any one of claims 53 to 55, further comprising a curing accelerator.

**57.** A metal-clad laminated sheet comprising:

a metal foil; and
a resin layer provided on the metal foil,
the resin layer being formed of the curable composition according to any one of claims 53 to 56.

**58.** A printed substrate comprising a patterned circuit formed by etching the metal foil of the metal-clad laminated sheet according to claim 57.

**INTERNATIONAL SEARCH REPORT**

International application No. PCT/JP2020/030199

A. CLASSIFICATION OF SUBJECT MATTER

C08G 59/20(2006.01)i; C08G 59/40(2006.01)i; C08F 214/18(2006.01)i; C08F 218/04(2006.01)i; C08L 27/12(2006.01)i; C08L 31/02(2006.01)i; C08L 63/00(2006.01)i; B32B 15/08(2006.01)i; B32B 15/082(2006.01)i; H05K 1/03(2006.01)i

FI: C08F214/18; C08L27/12; C08L63/00 A; B32B15/082 B; H05K1/03 610H; C08L31/02; B32B15/08 J; C08G59/20; C08G59/40; C08F218/04

According to International Patent Classification (IPC) or to both national classification and IPC

B. FIELDS SEARCHED

Minimum documentation searched (classification system followed by classification symbols)

C08G59/00-59/72; C08F214/18-214/28; C08F218/04-218/10; C08L27/12-27/20; C08L31/02-31/04; C08L63/00-63/10; B32B15/08; B32B15/082; H05K1/03

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>A | JP 2016-510838 A (ARKEMA INC.) 11.04.2016 (2016-04-11) claims, paragraphs [0012], [0018], examples | 1, 17-22, 32-37<br>23-24, 38-39 |
| X<br>A | JP 2015-167537 A (DAIKIN INDUSTRIES, LTD.) 28.09.2015 (2015-09-28) claims, paragraph [0060], synthesis examples 1-5 | 1, 17-22, 32-37<br>23-24, 38-39 |
| X | JP 10-97858 A (ASAHI GLASS CO., LTD.) 14.04.1998 (1998-04-14) claims, example 2 | 1 |
| X<br>A | JP 7-268034 A (ASAHI GLASS CO., LTD.) 17.10.1995 (1995-10-17) claims, paragraphs [0014]-[0015] | 47-49, 52<br>50-51, 53-58 |

☒ Further documents are listed in the continuation of Box C. ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| | |
|---|---|
| Date of the actual completion of the international search<br>13 October 2020 (13.10.2020) | Date of mailing of the international search report<br>20 October 2020 (20.10.2020) |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

International application No. PCT/JP2020/030199

C (Continuation). DOCUMENTS CONSIDERED TO BE RELEVANT

| Category* | Citation of document, with indication, where appropriate, of the relevant passages | Relevant to claim No. |
|---|---|---|
| X<br>A | WO 2015/111724 A1 (ASAHI GLASS CO., LTD.) 30.07.2015 (2015-07-30) claims 1, 3-4, paragraphs [0011], [0028] | 47, 52<br>48-51, 53-58 |
| A | JP 1-123848 A (ASAHI GLASS CO., LTD.) 16.05.1989 (1989-05-16) claims, examples | 1-58 |

Form PCT/ISA/210 (continuation of second sheet) (January 2015)

**INTERNATIONAL SEARCH REPORT**
Information on patent family members

International application no.
PCT/JP2020/030199

| Patent Documents referred in the Report | Publication Date | Patent Family | Publication Date |
|---|---|---|---|
| JP 2016-510838 A | 11 Apr. 2016 | US 2016/0009840 A1 claims, paragraphs [0012], [0016], examples<br>WO 2014/149911 A1<br>EP 2970536 A1<br>CN 105026443 A | |
| JP 2015-167537 A | 28 Sep. 2015 | (Family: none) | |
| JP 10-97858 A | 14 Apr. 1998 | (Family: none) | |
| JP 7-268034 A | 17 Oct. 1995 | (Family: none) | |
| WO 2015/111724 A1 | 30 Jul. 2015 | (Family: none) | |
| JP 1-123848 A | 16 May 1989 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012106491 A
- JP 2006307091 A